# EUROPEAN PATENT APPLICATION

(11) **EP 4 715 465 A1**
(43) Date of publication of application: **25.03.2026**
(21) Application number: 24807140.9
(22) Date of filing: 10.05.2024
(51) Int. Cl.: G03F 7/075, C08G 77/38

(54) **MULTILAYER BODY, METHOD FOR PRODUCING MULTILAYER BODY, AND PHOTOSENSITIVE SURFACE MODIFIER**

(30) Priority: 18.05.2023 JP 2023082081
(71) Applicant: Nissan Chemical Corporation, Tokyo 103-6119 (JP)
(72) Inventor: SHIBAYAMA, Wataru, Toyama-shi, Toyama 939-2792 (JP); TAKEDA, Satoshi, Toyama-shi, Toyama 939-2792 (JP); SHIGAKI, Shuhei, Toyama-shi, Toyama 939-2792 (JP); FURUKAWA, Yuki, Toyama-shi, Toyama 939-2792 (JP); SAIJO, Taiki, Toyama-shi, Toyama 939-2792 (JP)
(74) Representative: Hoffmann Eitle
(86) International application number: PCT/JP2024/017374
(87) International publication number: WO 2024/237188

(57) **Abstract**

The present invention provides a laminate including: a substrate; and a surface-modified film, the surface-modified film formed of a photosensitive surface modifier containing a photosensitive polymer and irradiated with light or an electron beam, in which the surface-modified film has an exposed region irradiated with the light or the electron beam and an unexposed region, and one of the exposed region and the unexposed region is a selective upper layer formation region in which an upper layer is selectively formed.

## Description

### Technical Field

The present invention relates to a laminate, a method for producing a laminate, and a photosensitive surface modifier.

### Background Art

In the related art, a lithography process using a resist composition has been performed in the production of semiconductor devices. The degree of integration of semiconductor devices is recently increased, and thus there is a need to miniaturize patterns of wiring or the like. As a thin film formation technique for forming a fine pattern, a technique for forming a dense thin film with a uniform film thickness by a CVD method, an ALD method, or the like has been provided.

As the above-described thin film formation method, Patent Literature 1 and Non Patent Literature 1 disclose a method of selectively forming a thin film in a specific region on the surface of a substrate by an ALD method.

### Citation List

### Patent Literature

Patent Literature 1: JP 2021-14631 A

### Non Patent Literature

Non Patent Literature 1: Journal of Photopolymer Science and Technology (2018),31(3),431-436

### Summary of Invention

### Technical Problem

The region-selective thin film formation method by the ALD method or the like described above is currently developed, and technical improvement as needed is expected. For example, as an underlying layer for forming a region-selective thin film, there is a need for development of an underlying layer that can be formed by a simple method without undergoing special raw materials or production steps.

### Solution to Problem

As a result of intensive studies to solve the above problem, the present inventors have found that the above problem can be solved, and completed the present invention having the following gist.

That is, the present invention includes the following items.
[1] A laminate including:
   a substrate; and
   a surface-modified film, the surface-modified film formed of a photosensitive surface modifier containing a photosensitive polymer and irradiated with light or an electron beam,
   wherein the surface-modified film has an exposed region irradiated with the light or the electron beam and an unexposed region, and
   one of the exposed region and the unexposed region is a selective upper layer formation region in which an upper layer is selectively formed.
[2] The laminate according to [1], wherein the photosensitive polymer is a polysiloxane.
[3] The laminate according to [2], wherein the polysiloxane contains a polysiloxane modified product in which at least some of silanol groups are alcohol-modified or acetal-protected.
[4] The laminate according to [2] or [3], wherein the polysiloxane contains at least one structure selected from a hydrocarbon group having 1 to 8 carbon atoms optionally substituted with a halogen atom, an aromatic ring having 6 to 30 carbon atoms optionally substituted with a halogen atom, an alkenyl group, an alkynyl group, a norbornene ring, a phenol group, a protected phenol group, an amino group, an amide group, a cyclic amide group, an imide group, a cyclic imide group, a sulfonyl group, a sulfonamide group, a nitro group, a cyano group, a thiocyanate group, an isocyanate group, a halogen group, a carboxylic acid group, a carboxylic acid ester group, a sulfonic acid group, a sulfonic acid ester group, a phosphoric acid group, a phosphoric acid ester group, an ammonium group, a phosphonium group, a sulfonium group, an epoxy group, a glycidoxy group, a cyclohexylepoxy group, a ring-opened epoxy group, a ring-opened glycidoxy group, a ring-opened cyclohexylepoxy group, a hydroxy group, a mercapto group, an acryloyloxy group, or a methacryloyloxy group.
[5] The laminate according to any one of [2] to [4], wherein the polysiloxane contains a group bonded to a silicon atom and having an ionic bond.
[6] The laminate according to [5], wherein
   the group having an ionic bond has an anionic group which is a group bonded to a silicon atom and a cation,
   an anion in the anionic group is a sulfonate anion, a carboxylate anion, or a phosphate anion, and
   the cation is a sulfonium cation, an iodonium cation, a phosphonium cation, a dihydroimidazole cation, or an ammonium cation.
[7] The laminate according to [5] or [6], wherein
   the group having an ionic bond has a cationic group which is a group bonded to a silicon atom and an anion,
   a cation in the cationic group is a sulfonium cation, an iodonium cation, a phosphonium cation, a dihydroimidazole cation, or an ammonium cation, and
   the anion is a sulfonate anion, a carboxylate anion, or a phosphate anion.
[8] The laminate according to any one of [2] to [7], wherein the polysiloxane contains a Q unit.
[9] The laminate according to any one of [1] to [8], wherein the substrate is made of a material containing an inorganic material or an organic material.
[10] The laminate according to any one of [1] to [9], wherein the substrate has a film made of a material containing an inorganic material or an organic material.
[11] The laminate according to [9] or [10], wherein the inorganic material is at least one selected from the group consisting of a metal, a metal oxide, a metal nitride, a metal carbide, a metal oxynitride, a metal oxycarbide, and a metal carbonitride.
[12] The laminate according to any one of [9] to [11], wherein the organic material is at least one selected from the group consisting of amorphous carbon, graphite, fullerene, carbon nanotube, diamond, diamond-like carbon, polyimide, and an organic film doped or partially substituted with boron, oxygen, nitrogen, phosphorus, silicon, sulfur, or halogen.
[13] A method for producing the laminate described in any one of [1] to [12], including:
   a film formation step of forming a surface modification precursor film on the substrate with the photosensitive surface modifier containing the photosensitive polymer and a solvent; and
   an exposure step of irradiating the surface modification precursor film with the light or the electron beam to form the surface-modified film having the exposed region and the unexposed region.
[14] The method for producing the laminate according to [13], wherein the laminate further includes a silicon-containing resist underlayer film or a carbon-containing resist underlayer film.
[15] The method for producing the laminate according to [13] or [14], wherein the surface-modified film has a film thickness of 5 nm or less.
[16] The method for producing the laminate according to any one of [13] to [15], further including
   a thinning step of bringing the surface-modified film into contact with a thinning liquid to cause the surface-modified film to have a film thickness of 5 nm or less.
[17] The method for producing the laminate according to [16], wherein the thinning liquid is at least one selected from the group consisting of an organic solvent, water, and an alkaline aqueous solution.
[18] The method for producing the laminate according to [16] or [17], wherein the thinning step is a step of spin-coating the surface-modified film with a thinning liquid to thin the surface-modified film and to form a surface-modified film having a film thickness of 5 nm or less.
[19] The method for producing the laminate according to any one of [13] to [18], further including a selective film formation step of preferentially forming an upper layer in one of the exposed region and the unexposed region.
[20] The method for producing the laminate according to [19], wherein the selective film formation step is a step of forming an upper layer by any of vacuum deposition, chemical vapor deposition (CVD), atomic layer deposition (ALD), and molecular layer deposition (MLD).
[21] A photosensitive surface modifier including: the photosensitive polymer; and a solvent, wherein
   the photosensitive surface modifier is a formation material for the surface-modified film of the laminate described in any one of [1] to [12].
[22] The photosensitive surface modifier according to [21], wherein the solvent contains at least one selected from the group consisting of alcohols, alkylene glycol alkyl ethers, alkylene glycol monoalkyl ether carboxylic acid esters, and water.
[23] The photosensitive surface modifier according to [21] or [22], further including an acid.
[24] The photosensitive surface modifier according to any one of [21] to [23], further including an acid generator.

### Advantageous Effects of Invention

According to the present invention, it is possible to provide a laminate in which a plurality of regions having different surface characteristics is formed through simple step as an underlying layer for selectively forming a thin film.

### Description of Embodiments

### (Laminate)

The laminate of the present invention includes a substrate and a surface-modified film formed of a photosensitive surface modifier containing a photosensitive polymer and irradiated with light or an electron beam. The laminate of the present invention may further include other films and layers.

### <<Surface-Modified Film>>

The surface-modified film is formed of a photosensitive surface modifier and has an exposed region irradiated with light or an electron beam and an unexposed region. The laminate of the present invention may further include other regions.

One of the exposed region and the unexposed region is a selective upper layer formation region where an upper layer is selectively formed. That is, in the laminate of the present invention, the exposed region is surface-modified by irradiation with light or the like. The surface-modified exposed region and the unexposed region are regions having different tendencies in the upper layer formation (different surface characteristics). One of the exposed region and the unexposed region is a region where an upper layer is likely to be selectively formed.

The exposed region is a region irradiated with light or an electron beam in the surface-modified film. The unexposed region is a region in the surface-modified film that is not irradiated with light or an electron beam, and is, for example, a region that is under a predetermined mask when irradiated with light or an electron beam.

The upper layer is not particularly limited, and is, for example, a layer of a photoresist material.

The exposed region and the unexposed region formed as described above are regions having different surface characteristics. Specifically, the exposed region and the unexposed region preferably have different hydrophilicity. Examples of the hydrophilicity include a contact angle of water. The difference in the water contact angle between the exposed region and the unexposed region is preferably 10 degrees or more, particularly preferably 15 degrees or more, and more preferably 20 degrees or more.

After liquid dropping in a volume of 3 µl, the dropping is stopped for 5 seconds, the contact angle of water is measured using a fully automatic contact angle meter (DM-701, manufactured by Kyowa Interface Science Co., Ltd.), the measurement is performed five times, thereby calculating an average value.

As described above, the surface characteristics are different between the exposed region and the unexposed region. Thus, when an upper layer is formed on the surface-modified film of the laminate, the amount of the upper layer deposited is likely to increase with respect to one of the exposed region and the unexposed region, and the upper layer is likely to be formed selectively in the region. For example, when a layer of a metal material is formed as an upper layer, the upper layer can be selectively formed in a region having high hydrophilicity.

The film thickness of the surface-modified film is 5 nm or less, preferably 3 nm or less. The lower limit of the film thickness of the surface-modified film is not particularly limited, and the film thickness of the surface-modified film may be 0.1 nm or more or 0.2 nm or more.

In the present invention, there is no clear distinction between the film and the layer.

In the present invention, the film thickness is measured as described below.

The film thickness is measured using an Ellipsometric Film Thickness Measurement System RE-3100 (SCREEN Semiconductor Solutions Co., Ltd.).

### <<<Photosensitive Polymer>>

The photosensitive polymer is not particularly limited as long as it is photosensitive to irradiation with light or an electron beam, and can be appropriately selected depending on the purpose.

The photosensitive polymer is, for example, a polymer (photoreactive polymer) that causes a photochemical reaction and causes a change in structure, such as cross-linking or decomposition, when irradiated with light or an electron beam. The photosensitive polymer may include a photoinitiator that reacts with the photoreactive polymer to change the structure of the polymer. For example, the photoinitiator may be a photoacid generator (PAG).

Hereinafter, the photosensitive polymer may be simply referred to as a polymer.

The weight-average molecular weight of the photosensitive polymer is not particularly limited, and may be, for example, 500 to 1,000,000. From the viewpoint of preventing the precipitation in the photosensitive surface modifier, the weight-average molecular weight is preferably 500,000 or less, more preferably 250,000 or less, and still more preferably 100,000 or less. From the viewpoint of the compatibility between storage stability and application property, the weight-average molecular weight may be preferably 500 or more, more preferably 600 or more.

### -Polysiloxane-

As the photosensitive polymer, a polysiloxane having part of an organic moiety is preferred from the viewpoint of easily causing photolysis or photocrosslinking in EUV, ArF exposure or electron beam lithography while firmly adhering to a substrate by chemical cross-linking.

The polysiloxane is not particularly limited as long as it is a polymer having a siloxane bond.

The photosensitive reaction of the polysiloxane is not particularly limited. For example, it is considered that the photoacid generator (PAG) and halogen in the side chain of the polysiloxane are decomposed by irradiation with light or an electron beam, the structure of the polymer is changed, and sulfonic acid and carboxylic acid are generated to cause a reaction in which hydrophilicity is likely to be exhibited. In addition, as the photosensitive reaction of the polysiloxane, for example, a reaction in which an aromatic ring of a polymer is eliminated, and a hydrophilic part (OH group) is exposed due to a change in structure accompanying the elimination is also considered.

The polysiloxane may include a modified polysiloxane in which some of silanol groups are modified, for example, a polysiloxane modified product in which some of silanol groups are alcohol-modified or acetal-protected.

Further, the polysiloxane may contain, as an example, a hydrolysis condensate of a hydrolyzable silane, and may contain a modified polysiloxane in which at least some of silanol groups of the hydrolysis condensate are alcohol-modified or acetal-protected. The hydrolyzable silane related to the hydrolysis condensate may include one type or two or more types of hydrolyzable silanes.

Further, the polysiloxane may have a structure whose main chain is any of a cage type, a ladder type, a linear type, and a branched type. Furthermore, the polysiloxane to be used may be a commercially available polysiloxane.

In the present invention, the "hydrolysis condensate", i.e. product of hydrolysis condensation, of the hydrolyzable silane includes not only a polyorganosiloxane polymer which is a condensate prepared through complete condensation, but also a polyorganosiloxane polymer which is a partial hydrolysis condensate prepared through incomplete condensation. Such a partial hydrolysis condensate is a polymer prepared through hydrolysis and condensation of a hydrolyzable silane compound, as in the case of a condensate prepared through complete condensation. However, the partial hydrolysis condensate contains remaining Si-OH groups, due to partial or incomplete hydrolysis and condensation of the silane compound. Further, the surface modifier may contain an uncondensed hydrolysate (complete hydrolysate or partial hydrolysate) or a remaining monomer (hydrolyzable silane), in addition to the hydrolysis condensate.

In the present specification, the "hydrolyzable silane" may be simply referred to as "silane compound".

In addition, in the present specification, the "polysiloxane" may be referred to as "hydrolysis condensate".

Preferably, the polysiloxane contains at least one structure selected from a hydrocarbon group having 1 to 8 carbon atoms optionally substituted with a halogen atom, an aromatic ring having 6 to 30 carbon atoms optionally substituted with a halogen atom, an alkenyl group, an alkynyl group, a norbornene ring, a phenol group, a protected phenol group, an amino group, an amide group, a cyclic amide group, an imide group, a cyclic imide group, a sulfonyl group, a sulfonamide group, a nitro group, a cyano group, a thiocyanate group, an isocyanate group, a halogen group, a carboxylic acid group, a carboxylic acid ester group, a sulfonic acid group, a sulfonic acid ester group, a phosphoric acid group, a phosphoric acid ester group, an ammonium group, a phosphonium group, a sulfonium group, an epoxy group, a glycidoxy group, a cyclohexylepoxy group, a ring-opened epoxy group, a ring-opened glycidoxy group, a ring-opened cyclohexylepoxy group, a hydroxy group, a mercapto group, an acryloyloxy group, or a methacryloyloxy group.

When the polysiloxane contains these structures, a decomposition reaction proceeds after EUV or electron beam exposure, and hydrophilization is likely to occur.

The ring-opened epoxy group represents a -CH(OH)-CH₂(OH) group.

In the present invention, examples of the halogen atom include a fluorine atom, a chlorine atom, a bromine atom, and an iodine atom.

It is particularly preferable that the polysiloxane contains a hydrocarbon group having 1 to 8 carbon atoms optionally substituted with a halogen atom or an aromatic ring having 6 to 30 carbon atoms optionally substituted with a halogen atom. The larger the number of substitutions of halogen atoms is, the more likely it is that the photosensitive polymer is decomposed by irradiation with light or an electron beam in the exposure step. In the case of having an aromatic ring, in the film formation step, a surface modification precursor film having a high contact angle of water before the exposure step with respect to the substrate is likely to be formed. Further, in the exposure step, a sensitive polymer which is likely to be decomposed by irradiation with light or an electron beam is likely to be formed.

Examples of the hydrocarbon group having 1 to 8 carbon atoms optionally substituted with a halogen atom or the aromatic ring having 6 to 30 carbon atoms optionally substituted with a halogen atom include the following groups: 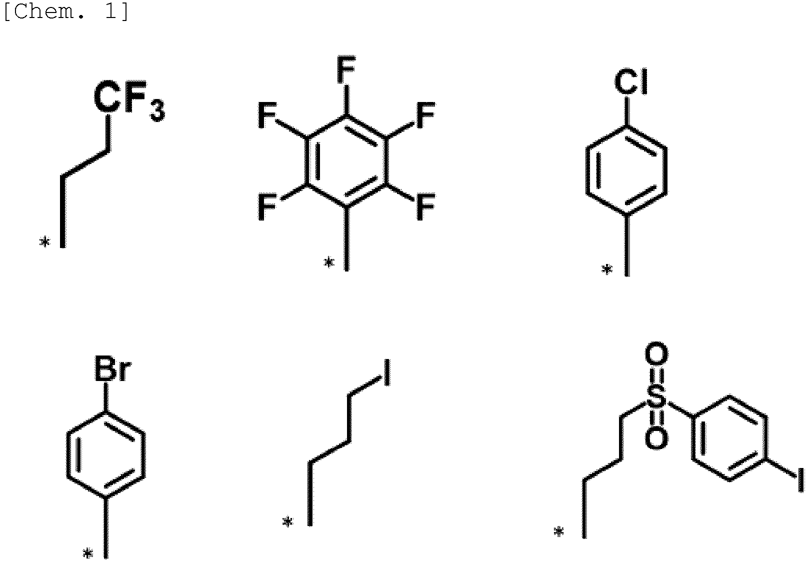 where each asterisk * represents a bonding site bonded to a silicon atom.

The polysiloxane preferably contains a group bonded to a silicon atom and having an ionic bond.

The group having an ionic bond has, for example, an anionic group which is a group bonded to a silicon atom, and a cation. The group having such an ionic bond is represented by, for example, Formula (I-1) below.

The group having an ionic bond has, for example, a cationic group which is a group bonded to a silicon atom, and an anion. The group having an ionic bond is represented by, for example, the following Formula (I-2): 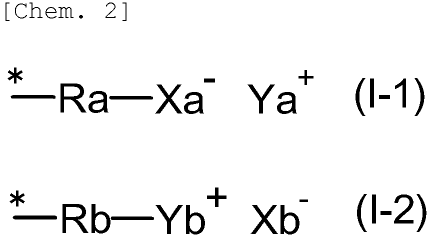
where in Formula (I-1), an asterisk * represents a bonding site bonded to a silicon atom, Ra represents a single bond or a divalent organic group, Xa⁻ represents a monovalent group having an anion, Ya⁺ represents a cation,
in Formula (I-2), an asterisk * represents a bonding site bonded to a silicon atom, Rb represents a single bond or a divalent organic group, Yb⁺ represents a monovalent group having a cation, and Xb⁻ represents an anion.

Ra and Rb each are, for example, a divalent organic group having 1 to 10 carbon atoms.

Ra and Rb each may have a heteroatom. Examples of the heteroatom include an oxygen atom and a nitrogen atom.

Examples of the anion in the anionic group or an anion include a sulfonate anion, a carboxylate anion, and a phosphate anion.

Examples of the cation in the cationic group or a cation include a sulfonium cation, an iodonium cation, a phosphonium cation, a dihydroimidazole cation, and an ammonium cation. The cation in the cationic group or a cation is preferably a sulfonium cation or an iodonium cation. This is because a photosensitive polymer, which is likely to be decomposed by irradiation with light or electron beam, is likely to be formed in the exposure step.

The sulfonium cation is preferably a triarylsulfonium cation, a diarylmonoalkylsulfonium cation, a monoaryldialkylsulfonium cation, a trialkylsulfonium cation, or the like.

The iodonium cation is preferably a diaryliodonium cation.

The phosphonium cation is preferably a tetraarylphosphonium cation, a triarylmonoalkylphosphonium cation, a diaryldialkylphosphonium cation, a monoaryltrialkylsulfonium cation, or the like.

The ammonium cation is preferably a quaternary ammonium cation, a tertiary ammonium, a secondary ammonium, a primary ammonium, or the like.

Examples of the anionic group which is a group bonded to a silicon atom include the following groups: 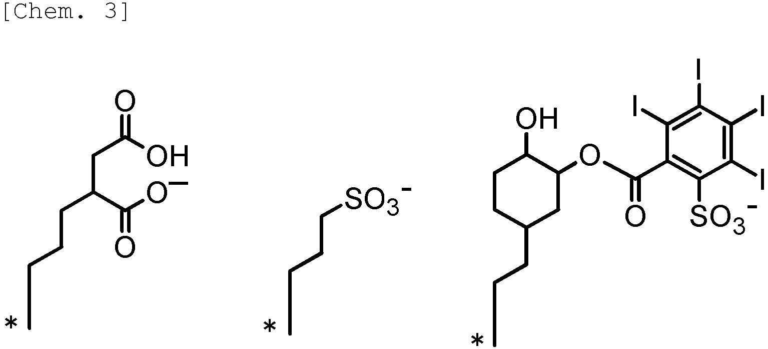 where each asterisk * represents a bonding site bonded to a silicon atom.

Examples of the cationic group which is a group bonded to a silicon atom include the following groups: 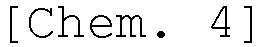 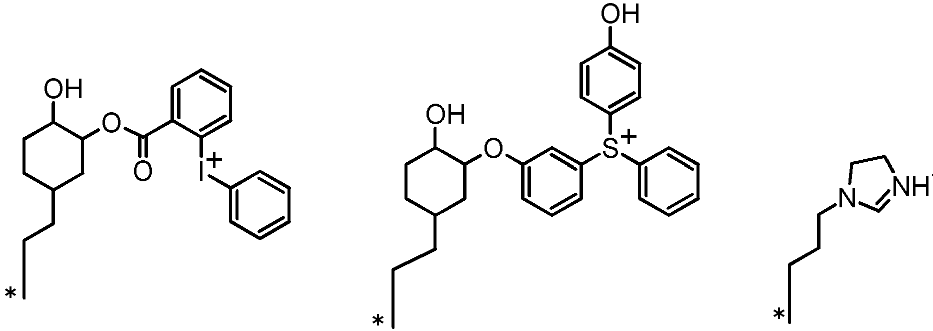 where each asterisk * represents a bonding site bonded to a silicon atom.

Examples of the anion include the following anions:

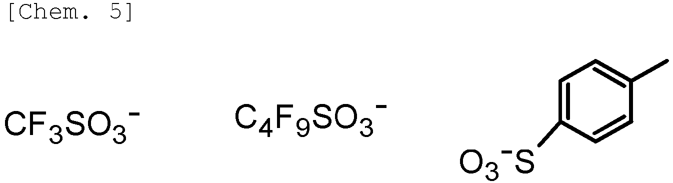

Examples of the cation include the following cations:

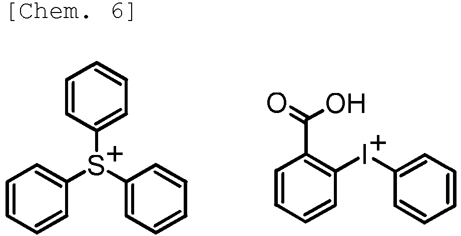

Examples of the group having an ionic bond include the following groups: 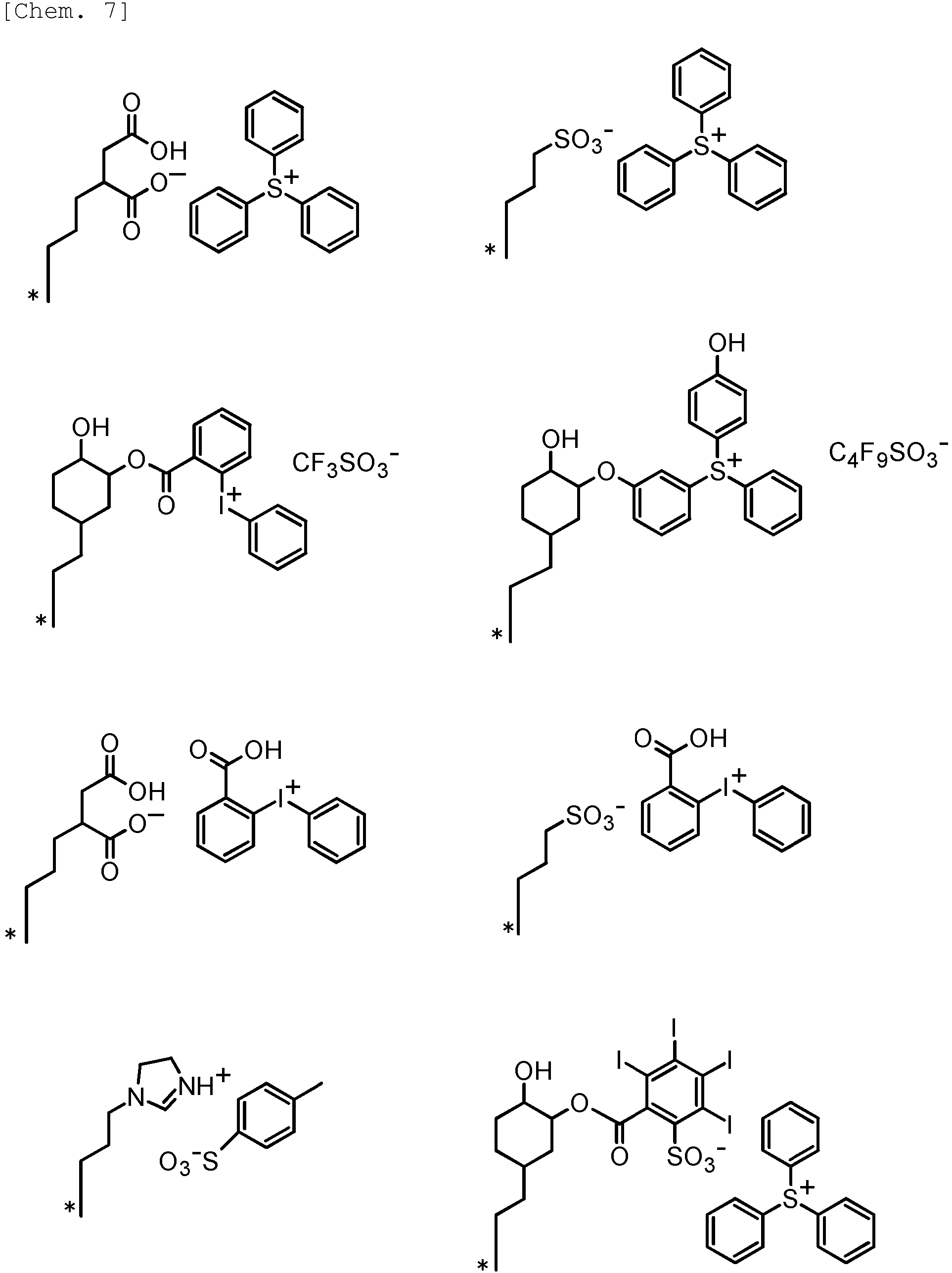 where each asterisk * represents a bonding site bonded to a silicon atom.

The polysiloxane contains, for example, at least one of an M unit, a D unit, a T unit, or a Q unit.

The M unit is a structural unit represented by R^{a}R^{b}R^{c}SiO_{1/2}, the D unit is a structural unit represented by R^{a}R^{b}SiO_{2/2}, the T unit is a structural unit represented by R^{a}SiO_{3/2}, and the Q unit is a structural unit represented by SiO_{4/2}. R^{a}, R^{b}, and R^{c} in these structural units represent a monovalent organic group having no hydrolyzability.

The polysiloxane contains, for example, a Q unit.

The polysiloxane preferably contains a T unit. The proportion of the T unit in the polysiloxane is preferably 30 mass% or more, more preferably 50 mass or more, and particularly preferably 60 mass% or more, relative to the total of the M unit, the D unit, the T unit, and the Q unit of the polysiloxane. In this case, the polysiloxane may contain or need not contain the M unit, the D unit, and the Q unit. When the polysiloxane contains the T unit, the surface-modified layer formed by the action of the monovalent organic group tends to interact with an adjacent layer or film. As a result, for example, characteristics of the organic group, such as photoreaction, are likely to occur efficiently while the surface-modified layer is in close contact with the underlayer substrate through the SiO bond. In a case where the polysiloxane may contain the M unit and the D unit, when the mass ratio of the T unit is larger than the total of the M unit and the D unit in the polysiloxane, the film strength, film formability, and the like of the surface-modified layer can be enhanced.

The polysiloxane may be, for example, a hydrolysis condensate of a hydrolyzable silane containing at least one hydrolyzable silane represented by the following Formula (1):
--Formula (1)--
[Chem. 8]

**R¹ₐSi(R²)₄₋ₐ** (1)

In Formula (1), R¹ is a group bonded to a silicon atom, and represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more of these groups. R¹ is preferably an optionally substituted aryl group, an optionally substituted alkyl group, or an optionally substituted aryl group.

R² is a group or atom bonded to a silicon atom, and each independently represents an alkoxy group, an aralkyloxy group, an acyloxy group, or a halogen atom.

a represents an integer of 0 to 3.

### ---R¹---

The alkyl group may be linear, branched, or cyclic, and the number of carbon atoms thereof is not particularly limited, but is preferably 40 or less, more preferably 30 or less, still more preferably 20 or less, and yet still more preferably 10 or less.

Specific examples of the linear or branched alkyl group as the alkyl group include a methyl group, ethyl group, n-propyl group, i-propyl group, n-butyl group, i-butyl group, s-butyl group, t-butyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, n-hexyl group, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group, and 1-ethyl-2-methyl-n-propyl group.

In the present specification, "i" means "iso", "s" means "sec", and "t" means "tert".

Specific examples of the cyclic alkyl group include: cyclic alkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and crosslinked cyclic cycloalkyl groups, such as a bicyclobutyl group, a bicyclopentyl group, a bicyclohexyl group, a bicycloheptyl group, a bicyclooctyl group, a bicyclononyl group, and a bicyclodecyl group.

The aryl group may be any of a phenyl group, a monovalent group derived by removing one hydrogen atom from a condensed-ring aromatic hydrocarbon compound, and a monovalent group derived by removing one hydrogen atom from a linked-ring aromatic hydrocarbon compound. The number of carbon atoms of the aryl group is not particularly limited, but is preferably 40 or less, more preferably 30 or less, and still more preferably 20 or less.

Examples of the aryl group include an aryl group having 6 to 20 carbon atoms, and examples thereof include, but are not limited thereto, a phenyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthryl group, a 1-naphthacenyl group, a 2-naphthacenyl group, a 5-naphthacenyl group, a 2-chrysenyl group, a 1-pyrenyl group, a 2-pyrenyl group, a pentacenyl group, a benzopyrenyl group, and a triphenylenyl group; a biphenyl-2-yl group (o-biphenylyl group), a biphenyl-3-yl group (m-biphenylyl group), a biphenyl-4-yl group (p-biphenylyl group), a paraterphenyl-4-yl group, a metaterphenyl-4-yl group, an orthoterphenyl-4-yl group, a 1,1'-binaphthyl-2-yl group, and a 2,2'-binaphthyl-1-yl group.

The aralkyl group is an alkyl group substituted with an aryl group, and specific examples of the aryl group and the alkyl group are the same as those described above. The number of carbon atoms of the aralkyl group is not particularly limited, but is preferably 40 or less, more preferably 30 or less, and still more preferably 20 or less.

Specific examples of the aralkyl group include, but are not limited thereto, a phenylmethyl group (benzyl group), a 2-phenylethylene group, a 3-phenyl-n-propyl group, a 4-phenyl-n-butyl group, a 5-phenyl-n-pentyl group, a 6-phenyl-n-hexyl group, a 7-phenyl-n-heptyl group, a 8-phenyl-n-octyl group, a 9-phenyl-n-nonyl group, and a 10 phenyl-n-decyl group.

The alkyl halide group, the aryl halide group, and the aralkyl halide group are an alkyl group substituted with one or more halogen atoms, an aryl group substituted with one or more halogen atoms, and an aralkyl group substituted with one or more halogen atoms, respectively. Specific examples of the alkyl halide group, the aryl halide group, and the aralkyl halide group are the same as those described above.

The number of carbon atoms of the alkyl halide group is not particularly limited, but is preferably 40 or less, more preferably 30 or less, still more preferably 20 or less, and yet still more preferably 10 or less.

Specific examples of the alkyl halide group include, but are not limited to, a monofluoromethyl group, a difluoromethyl group, a trifluoromethyl group, a bromodifluoromethyl group, a 2-chloroethyl group, a 2-bromoethyl group, a 1,1-difluoroethyl group, a 2,2,2-trifluoroethyl group, a 1,1,2,2-tetrafluoroethyl group, a 2-chloro-1,1,2-trifluoroethyl group, a pentafluoroethyl group, a 3-bromopropyl group, a 2,2,3,3-tetrafluoropropyl group, a 1,1,2,3,3,3-hexafluoropropyl group, a 1,1,1,3,3,3-hexafluoropropane-2-yl group, a 3-bromo-2-methylpropyl group, a 4-bromobutyl group, and a perfluoropentyl group.

The number of carbon atoms of the aryl halide group is not particularly limited, but is preferably 40 or less, more preferably 30 or less, and still more preferably 20 or less.

Specific examples of the aryl halide group include, but are not limited to, a 2-fluorophenyl group, a 3-fluorophenyl group, a 4-fluorophenyl group, a 2,3-difluorophenyl group, a 2,4-difluorophenyl group, a 2,5-difluorophenyl group, a 2,6-difluorophenyl group, a 3,4-difluorophenyl group, a 3,5-difluorophenyl group, a 2,3,4-trifluorophenyl group, a 2,3,5-trifluorophenyl group, a 2,3,6-trifluorophenyl group, a 2,4,5-trifluorophenyl group, a 2,4,6-trifluorophenyl group, a 3,4,5-trifluorophenyl group, a 2,3,4,5-tetrafluorophenyl group, a 2,3,4,6-tetrafluorophenyl group, a 2,3,5,6-tetrafluorophenyl group, a pentafluorophenyl group, a 2-fluoro-1-naphthyl group, a 3-fluoro-1-naphthyl group, a 4-fluoro-1-naphthyl group, a 6-fluoro-1-naphthyl group, a 7-fluoro-1-naphthyl group, an 8-fluoro-1-naphthyl group, a 4,5-difluoro-1-naphthyl group, a 5,7-difluoro-1-naphthyl group, a 5,8-difluoro-1-naphthyl group, a 5,6,7,8-tetrafluoro-1-naphthyl group, a heptafluoro-1-naphthyl group, a 1-fluoro-2-naphthyl group, a 5-fluoro-2-naphthyl group, a 6-fluoro-2-naphthyl group, a 7-fluoro-2-naphthyl group, a 5,7-difluoro-2-naphthyl group, and a heptafluoro-2-naphthyl group, and groups obtained as fluorine atoms (fluoro groups) of the groups are optionally substituted with chlorine atoms (chloro groups), bromine atoms (bromo groups), and iodine atoms (iodine groups).

The number of carbon atoms of the aralkyl halide group is not particularly limited, but is preferably 40 or less, more preferably 30 or less, and still more preferably 20 or less.

Specific examples of the aralkyl halide group include a 2-fluorobenzyl group, 3-fluorobenzyl group, 4-fluorobenzyl group, 2,3-difluorobenzyl group, 2,4-difluorobenzyl group, 2,5-difluorobenzyl group, 2,6-difluorobenzyl group, 3,4-difluorobenzyl group, 3,5-difluorobenzyl group, 2,3,4-trifluorobenzyl group, 2,3,5-trifluorobenzyl group, 2,3,6-trifluorobenzyl group, 2,4,5-trifluorobenzyl group, 2,4,6-trifluorobenzyl group, 2,3,4,5-tetrafluorobenzyl group, 2,3,4,6-tetrafluorobenzyl group, 2,3,5,6-tetrafluorobenzyl group, and 2,3,4,5,6-pentafluorobenzyl group. Examples thereof also include groups in which fluorine atoms (fluoro groups) in the above groups are optionally substituted with chlorine atoms (chloro groups), bromine atoms (bromo groups), or iodine atoms (iodine groups), but not limited thereto.

The alkoxyalkyl group, the alkoxyaryl group, and the alkoxyaralkyl group are an alkyl group substituted with one or more alkoxy groups, an aryl group substituted with one or more alkoxy groups, and an aralkyl group substituted with one or more alkoxy groups, respectively. Specific examples of the alkoxyalkyl group, the alkoxyaryl group, and the alkoxyaralkyl group are the same as those described above.

The alkoxy group as the substituent is, for example, an alkoxy group having at least any one of linear, branched, and cyclic alkyl moieties having 1 to 20 carbon atoms.

Examples of the linear or branched alkoxy group include a methoxy group, ethoxy group, n-propoxy group, i-propoxy group, n-butoxy group, i-butoxy group, s-butoxy group, t-butoxy group, n-pentyloxy group, 1-methyl-n-butoxy group, 2-methyl-n-butoxy group, 3-methyl-n-butoxy group, 1,1-dimethyl-n-propoxy group, 1,2-dimethyl-n-propoxy group, 2,2-dimethyl-n-propoxy group, 1-ethyl-n-propoxy group, n-hexyloxy group, 1-methyl-n-pentyloxy group, 2-methyl-n-pentyloxy group, 3-methyl-n-pentyloxy group, 4-methyl-n-pentyloxy group, 1,1-dimethyl-n-butoxy group, 1,2-dimethyl-n-butoxy group, 1,3-dimethyl-n-butoxy group, 2,2-dimethyl-n-butoxy group, 2,3-dimethyl-n-butoxy group, 3,3-dimethyl-n-butoxy group, 1-ethyl-n-butoxy group, 2-ethyl-n-butoxy group, 1,1,2-trimethyl-n-propoxy group, 1,2,2-trimethyl-n-propoxy group, 1-ethyl-1-methyl-n-propoxy group, and 1-ethyl-2-methyl-n-propoxy group.

Examples of the cyclic alkoxy group include a cyclopropoxy group, cyclobutoxy group, 1-methyl-cyclopropoxy group, 2-methyl-cyclopropoxy group, cyclopentyloxy group, 1-methyl-cyclobutoxy group, 2-methyl-cyclobutoxy group, 3-methyl-cyclobutoxy group, 1,2-dimethyl-cyclopropoxy group, 2,3-dimethyl-cyclopropoxy group, 1-ethyl-cyclopropoxy group, 2-ethyl-cyclopropoxy group, cyclohexyloxy group, 1-methyl-cyclopentyloxy group, 2-methyl-cyclopentyloxy group, 3-methyl-cyclopentyloxy group, 1-ethyl-cyclobutoxy group, 2-ethyl-cyclobutoxy group, 3-ethyl-cyclobutoxy group, 1,2-dimethyl-cyclobutoxy group, 1,3-dimethyl-cyclobutoxy group, 2,2-dimethyl-cyclobutoxy group, 2,3-dimethyl-cyclobutoxy group, 2,4-dimethyl-cyclobutoxy group, 3,3-dimethyl-cyclobutoxy group, 1-n-propyl-cyclopropoxy group, 2-n-propyl-cyclopropoxy group, 1-i-propyl-cyclopropoxy group, 2-i-propyl-cyclopropoxy group, 1,2,2-trimethyl-cyclopropoxy group, 1,2,3-trimethyl-cyclopropoxy group, 2,2,3-trimethyl-cyclopropoxy group, 1-ethyl-2-methyl-cyclopropoxy group, 2-ethyl-1-methyl-cyclopropoxy group, 2-ethyl-2-methyl-cyclopropoxy group, and 2-ethyl-3-methyl-cyclopropoxy group.

Specific examples of the alkoxyalkyl group include, but are not limited to, lower (about 5 or less carbon atoms) alkyloxy lower (about 5 or less carbon atoms) alkyl groups, such as methoxymethyl group, ethoxymethyl group, 1-ethoxyethyl group, 2-ethoxyethyl group, and ethoxymethyl group.

Specific examples of the alkoxyaryl group include, but are not limited to, a 2-methoxyphenyl group, 3-methoxyphenyl group, 4-methoxyphenyl group, 2-(1-ethoxy)phenyl group, 3-(1-ethoxy)phenyl group, 4-(1-ethoxy)phenyl group, 2-(2-ethoxy)phenyl group, 3-(2-ethoxy)phenyl group, 4-(2-ethoxy)phenyl group, 2-methoxynaphthalene-1-yl group, 3-methoxynaphthalene-1-yl group, 4-methoxynaphthalene-1-yl group, 5-methoxynaphthalene-1-yl group, 6-methoxynaphthalene-1-yl group, and 7-methoxynaphthalene-1-yl group.

Specific examples of the alkoxyaralkyl group include, but are not limited to, a 3-(methoxyphenyl)benzyl group and a 4-(methoxyphenyl)benzyl group.

The alkenyl group may be linear or branched, and the number of carbon atoms of the linear or branched alkenyl group is not particularly limited, but is preferably 40 or less, more preferably 30 or less, still more preferably 20 or less, and yet still more preferably 10 or less.

Specific examples of the alkenyl group include an ethenyl group (vinyl group), 1-propenyl group, 2-propenyl group, 1-methyl-1-ethenyl group, 1-butenyl group, 2-butenyl group, 3-butenyl group, 2-methyl-1-propenyl group, 2-methyl-2-propenyl group, 1-ethylethenyl group, 1-methyl-1-propenyl group, 1-methyl-2-propenyl group, 1-pentenyl group, 2-pentenyl group, 3-pentenyl group, 4-pentenyl group, 1-n-propylethenyl group, 1-methyl-1-butenyl group, 1-methyl-2-butenyl group, 1-methyl-3-butenyl group, 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4-pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-t-butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, 2-methyl-3-cyclopentenyl group, 2-methyl-4-cyclopentenyl group, 2-methyl-5-cyclopentenyl group, 2-methylene-cyclopentyl group, 3-methyl-1-cyclopentenyl group, 3-methyl-2-cyclopentenyl group, 3-methyl-3-cyclopentenyl group, 3-methyl-4-cyclopentenyl group, 3-methyl-5-cyclopentenyl group, 3-methylene-cyclopentyl group, 1-cyclohexenyl group, 2-cyclohexenyl group, and 3-cyclohexenyl group. Examples thereof also include crosslinked cyclic alkenyl groups such as a bicycloheptenyl group (norbornyl group).

Examples of the substituent in the aforementioned alkyl group, aryl group, aralkyl group, alkyl halide group, aryl halide group, aralkyl halide group, alkoxyalkyl group, alkoxyaryl group, alkoxyaralkyl group, and alkenyl group described above include an alkyl group, an aryl group, an aralkyl group, an alkyl halide group, an aryl halide group, an aralkyl halide group, an alkoxyalkyl group, an aryloxy group, an alkoxyaryl group, an alkoxyaralkyl group, an alkenyl group, an alkoxy group, and an aralkyloxy group. Specific examples thereof and the preferred number of carbon atoms thereof are the same as those described above or below.

The aryloxy group as described in the substituent is a group in which an aryl group is bonded via an oxygen atom (-O-), and specific examples of the aryl group are the same as those described above. The number of carbon atoms in the aryloxy group is not particularly limited, but is preferably 40 or less, more preferably 30 or less, and still more preferably 20 or less. Specific examples thereof include, but are not limited to, a phenoxy group and a naphthalene-2-yloxy group.

When two or more substituents are present, the substituents may be bonded together to form a ring.

Examples of the organic group having an optionally ring-opened epoxy group include a glycidoxymethyl group, a glycidoxyethyl group, a glycidoxypropyl group, a glycidoxybutyl group, an epoxy cyclohexyl group, and groups in which epoxy groups of the above groups are ring-opened.

Examples of the organic group having an acryloyl group include an acryloyloxymethyl group, an acryloyloxyethyl group, and an acryloyloxypropyl group.

Examples of the organic group having a methacryloyl group include a methacryloyloxymethyl group, a methacryloyloxyethyl group, and a methacryloyloxypropyl group.

Examples of the organic group having a mercapto group include a mercaptoethyl group, a mercaptobutyl group, a mercaptohexyl group, a mercaptooctyl group, and a mercaptophenyl group.

Examples of the organic group having an amino group include, but are not limited to, an amino group, an aminomethyl group, an aminoethyl group, an aminophenyl group, a dimethylaminoethyl group, and a dimethylaminopropyl group. The organic group having an amino group will be described later in more detail.

Examples of the organic group having an alkoxy group include, but are not limited to, a methoxymethyl group and a methoxyethyl group. However, the organic group excludes a group in which an alkoxy group is directly bonded to a silicon atom.

Examples of the organic group having a sulfonyl group include, but are not limited to, a sulfonylalkyl group and a sulfonylaryl group.

Examples of the organic group having a cyano group include a cyanoethyl group, a cyanopropyl group, a cyanophenyl group, and a thiocyanate group.

The organic group having an amino group is, for example, an organic group having at least one of a primary amino group, a secondary amino group, or a tertiary amino group. A hydrolysis condensate in which a hydrolyzable silane having a tertiary amino group is hydrolyzed with a strong acid to form a counter cation having a tertiary ammonium group can be preferably used. The organic group may contain a heteroatom such as an oxygen atom or a sulfur atom, in addition to the nitrogen atom forming the amino group.

A preferable example of the organic group having an amino group is a group represented by the following Formula (A1).

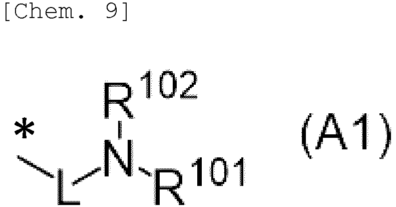

In Formula (A1), R¹⁰¹ and R¹⁰² each independently represent a hydrogen atom or a hydrocarbon group, and L represents an independently and optionally substituted alkylene group. An asterisk * represents a bonding site.

Examples of the hydrocarbon group include, but are not limited to, an alkyl group, an alkenyl group, and an aryl group. Specific examples of the alkyl group, the alkenyl group, and the aryl group are the same as those described above regarding R¹.

The alkylene group may be linear or branched, and the number of carbon atoms of the linear or branched alkylene group is ordinarily 1 to 10, preferably 1 to 5. Examples of the linear or branched alkylene group include linear alkylene groups such as a methylene group, an ethylene group, a trimethylene group, a tetramethylene group, a pentamethylene group, a hexamethylene group, a heptamethylene group, an octamethylene group, a nonamethylene group, and a decamethylene group.

Examples of the organic group having an amino group include, but are not limited to, an amino group, an aminomethyl group, an aminoethyl group, an aminophenyl group, a dimethylaminoethyl group, and a dimethylaminopropyl group.

### ---R²---

Examples of the alkoxy group in R² include the alkoxy groups exemplified in the description of R¹.

Examples of the halogen atom in R² include the halogen atoms exemplified in the description of R¹.

The aralkyloxy group is a monovalent group derived by removing a hydrogen atom from a hydroxy group of aralkyl alcohol, and specific examples of the aralkyl group in the aralkyloxy group are the same as those described above.

The number of carbon atoms of the aralkyloxy group is not particularly limited, but may be, for example, 40 or less, preferably 30 or less, and more preferably 20 or less.

Specific examples of the aralkyloxy group include, but are not limited to, a phenylmethyloxy group (benzyloxy group), 2-phenylethyleneoxy group, 3-phenyl-n-propyloxy group, 4-phenyl-n-butyloxy group, 5-phenyl-n-pentyloxy group, 6-phenyl-n-hexyloxy group, 7-phenyl-n-heptyloxy group, 8-phenyl-n-octyloxy group, 9-phenyl-n-nonyloxy group, and 10-phenyl-n-decyloxy group.

The acyloxy group is a monovalent group derived by removing a hydrogen atom from a carboxyl group (-COOH) of a carboxylic acid compound, and examples of the acyloxy group typically include, but are not limited to, an alkylcarbonyloxy group, an arylcarbonyloxy group, or an aralkylcarbonyloxy group, derived by removing a hydrogen atom from a carboxyl group of an alkyl carboxylic acid, an aryl carboxylic acid, or an aralkyl carboxylic acid. Specific examples of the alkyl group, aryl group, and aralkyl group in the alkyl carboxylic acid, aryl carboxylic acid, and aralkyl carboxylic acid are the same as those described above.

Specific examples of the acyloxy group include an acyloxy group having 2 to 20 carbon atoms, and examples thereof include a methylcarbonyloxy group, ethylcarbonyloxy group, n-propylcarbonyloxy group, i-propylcarbonyloxy group, n-butylcarbonyloxy group, i-butylcarbonyloxy group, s-butylcarbonyloxy group, t-butylcarbonyloxy group, n-pentylcarbonyloxy group, 1-methyl-n-butylcarbonyloxy group, 2-methyl-n-butylcarbonyloxy group, 3-methyl-n-butylcarbonyloxy group, 1,1-dimethyl-n-propylcarbonyloxy group, 1,2-dimethyl-n-propylcarbonyloxy group, 2,2-dimethyl-n-propylcarbonyloxy group, 1-ethyl-n-propylcarbonyloxy group, n-hexylcarbonyloxy group, 1-methyl-n-pentylcarbonyloxy group, 2-methyl-n-pentylcarbonyloxy group, 3-methyl-n-pentylcarbonyloxy group, 4-methyl-n-pentylcarbonyloxy group, 1,1-dimethyl-n-butylcarbonyloxy group, 1,2-dimethyl-n-butylcarbonyloxy group, 1,3-dimethyl-n-butylcarbonyloxy group, 2,2-dimethyl-n-butylcarbonyloxy group, 2,3-dimethyl-n-butylcarbonyloxy group, 3,3-dimethyl-n-butylcarbonyloxy group, 1-ethyl-n-butylcarbonyloxy group, 2-ethyl-n-butylcarbonyloxy group, 1,1,2-trimethyl-n-propylcarbonyloxy group, 1,2,2-trimethyl-n-propylcarbonyloxy group, 1-ethyl-1-methyl-n-propylcarbonyloxy group, 1-ethyl-2-methyl-n-propylcarbonyloxy group, phenylcarbonyloxy group, and tosylcarbonyloxy group.

### ---Specific Example of Hydrolyzable Silane Represented by Formula (1)---

Specific examples of the hydrolyzable silane represented by Formula (1) include, but are not limited to, tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, and α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylethyldimethoxysilane, α-glycidoxypropylmethyldimethoxysilane, α-glycidoxypropylmethyldiethoxysilane, β-glycidoxypropylmethyldimethoxysilane, β-glycidoxypropylethyldimethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxypropylvinyldimethoxysilane, γ-glycidoxypropylvinyldiethoxysilane, allyltrimethoxysilane, allyltriethoxysilane, allyltrichlorosilane, allyltriacetoxysilane, allylmethyldimethoxysilane, allylmethyldiethoxysilane, allylmethyldichlorosilane, allylmethyldiacetoxysilane, allyldimethylmethoxysilane, allyldimethylethoxysilane, allyldimethylchlorosilane, allyldimethylacetoxysilane, diallyldimethoxysilane, diallyldiethoxysilane, diallyldichlorosilane, diallyldiacetoxysilane, 3-allylaminopropyltrimethoxysilane, 3-allylaminopropyltriethoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, 3-phenylaminopropyltrimethoxysilane, 3-phenylaminopropyltriethoxysilane, dimethoxymethyl-3-(3-phenoxypropylthiopropyl)silane, triethoxy((2-methoxy-4-(methoxymethyl) phenoxy) methyl) silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenethylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzyltriacetoxysilane, methoxybenzyltrichlorosilane, methoxyphenethyltrimethoxysilane, methoxyphenethyltriethoxysilane, methoxyphenethyltriacetoxysilane, methoxyphenethyltrichlorosilane, ethoxyphenyltrimethoxysilane, ethoxyphenyltriethoxysilane, ethoxyphenyltriacetoxysilane, ethoxyphenyltrichlorosilane, ethoxybenzyltrimethoxysilane, ethoxybenzyltriethoxysilane, ethoxybenzyltriacetoxysilane, ethoxybenzyltrichlorosilane, i-propoxyphenyltrimethoxysilane, i-propoxyphenyltriethoxysilane, i-propoxyphenyltriacetoxysilane, i-propoxyphenyltrichlorosilane, i-propoxybenzyltrimethoxysilane, i-propoxybenzyltriethoxysilane, i-propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyltrimethoxysilane, t-butoxybenzyltriethoxysilane, t-butoxybenzyltriacetoxysilane, t-butoxybenzyltrichlorosilane, methoxynaphthyltrimethoxysilane, methoxynaphthyltriethoxysilane, methoxynaphthyltriacetoxysilane, methoxynaphthyltrichlorosilane, ethoxynaphthyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, thiocyanatepropyltriethoxysilane, chloromethyltrimethoxysilane, chloromethyltriethoxysilane, triethoxysilylpropyldiallylisocyanurate, bicyclo[2,2,1]heptenyltriethoxysilane, benzenesulfonylpropyltriethoxysilane, benzenesulfonamidepropyltriethoxysilane, dimethylaminopropyltrimethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, methylvinyldiethoxysilane, silanes represented by Formulae (A-1) to (A-41) below, and silanes represented by Formulae (1-1) to (1-294) below.

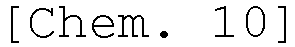

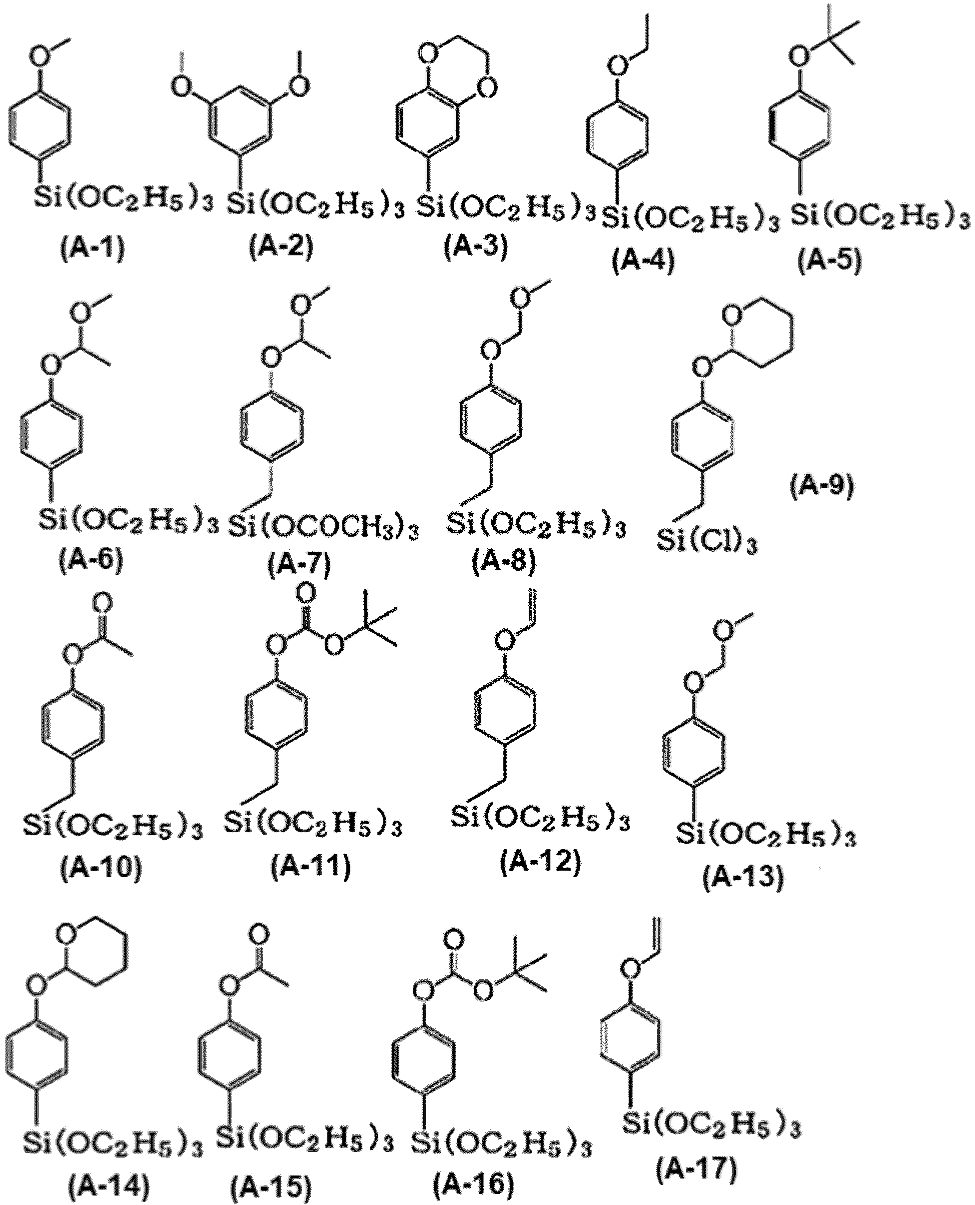

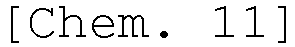

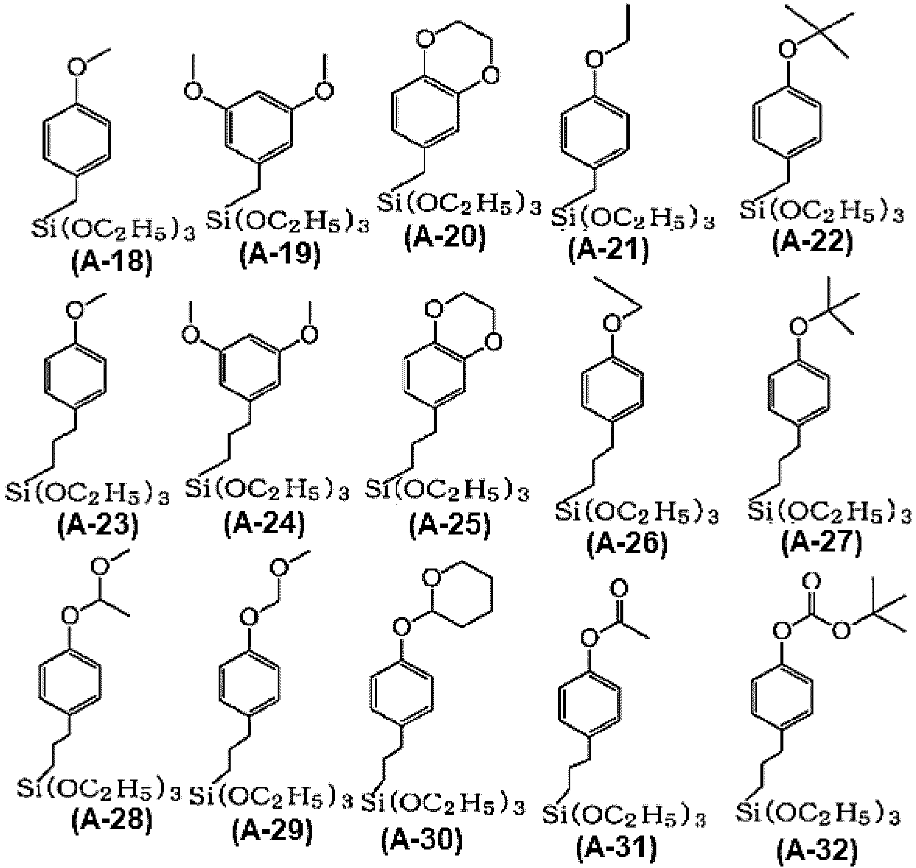

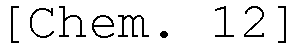

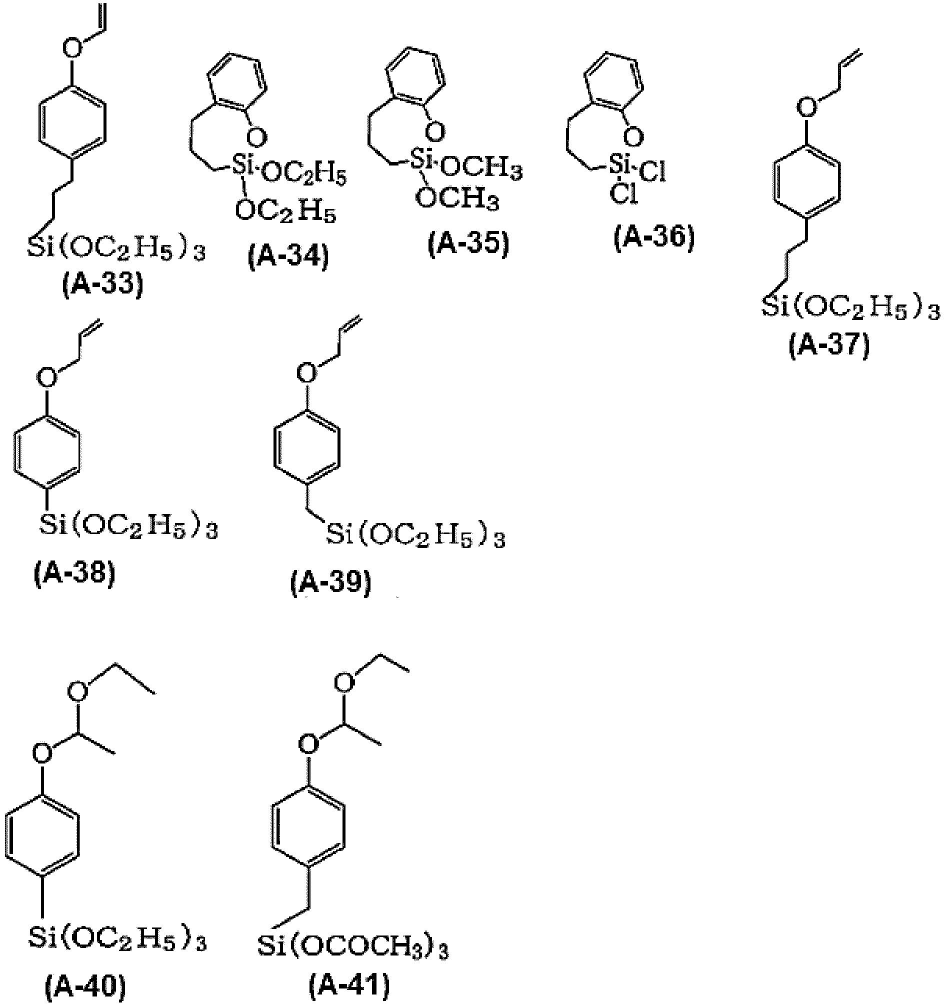

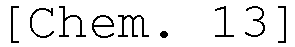

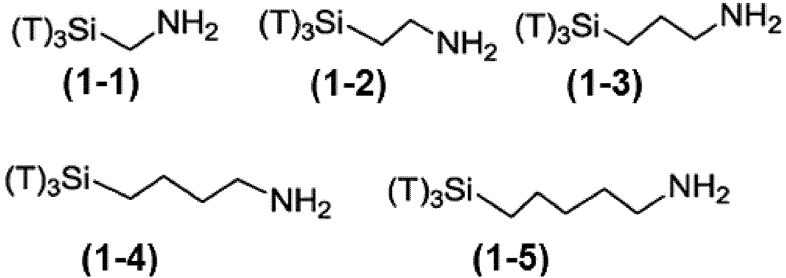

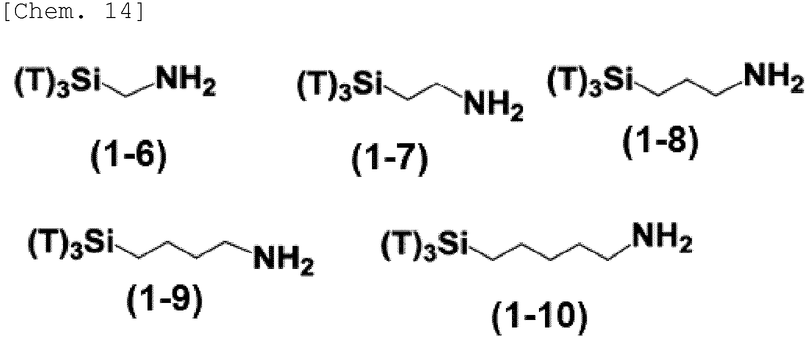

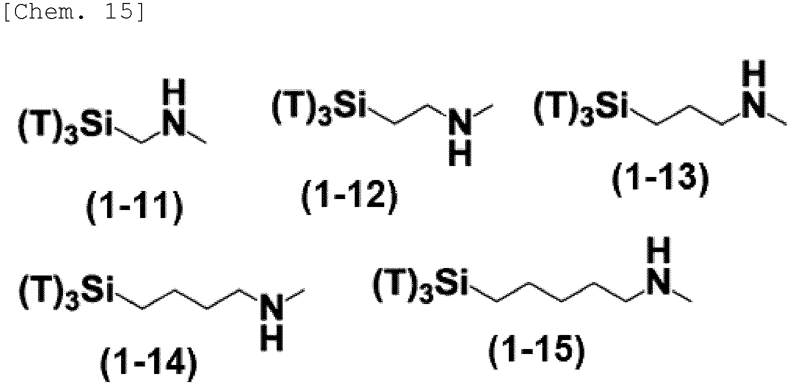

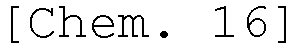

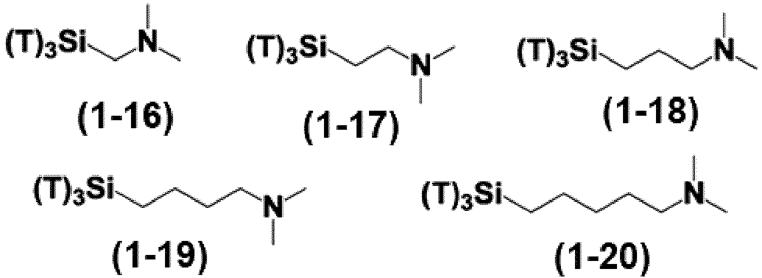

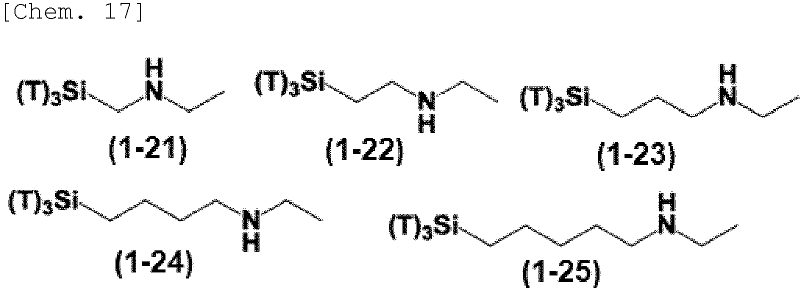

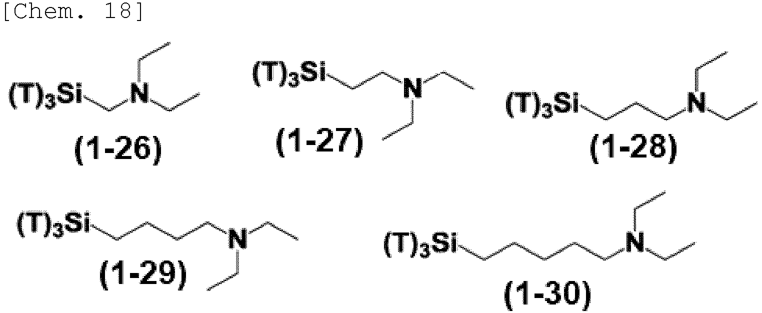

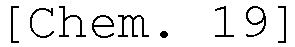

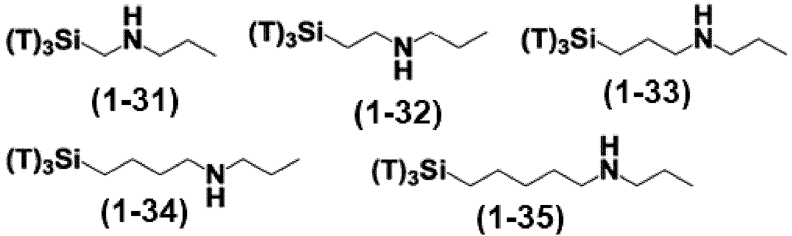

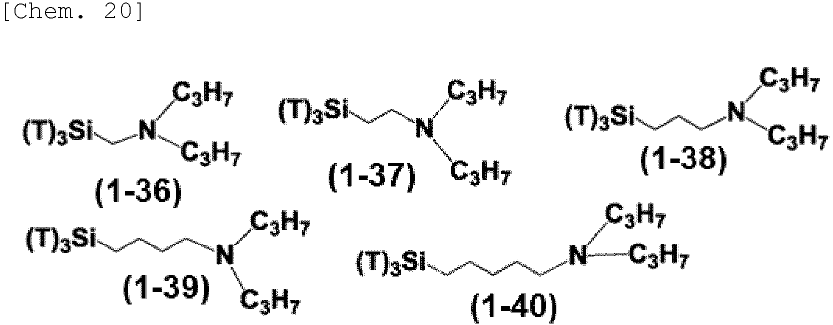

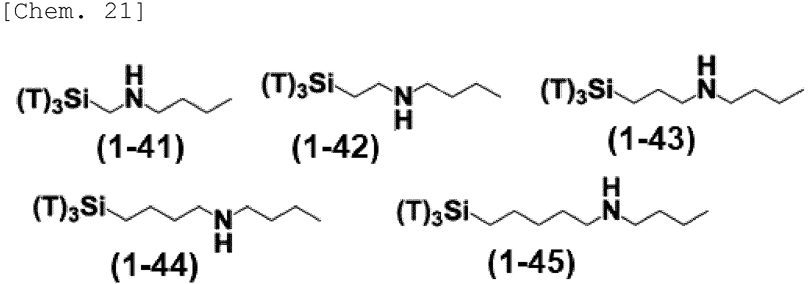

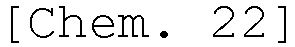

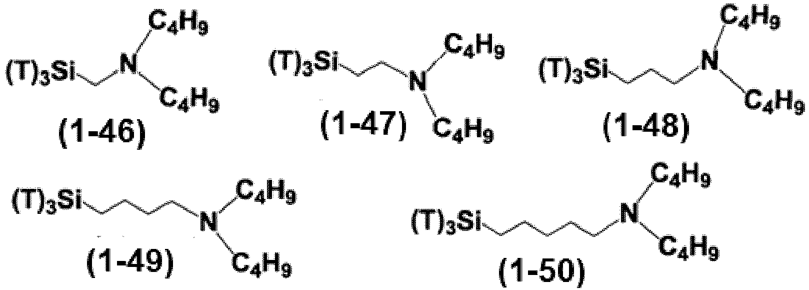

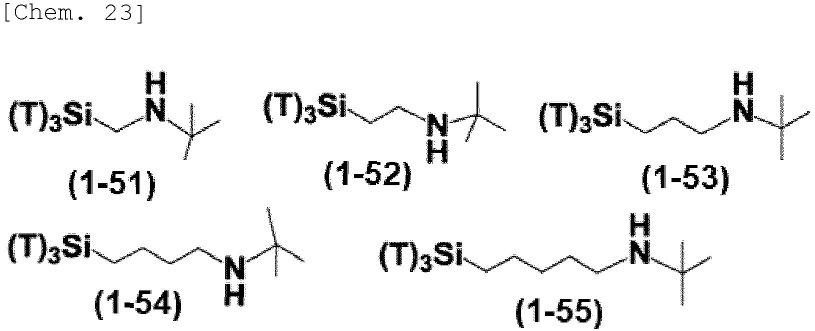

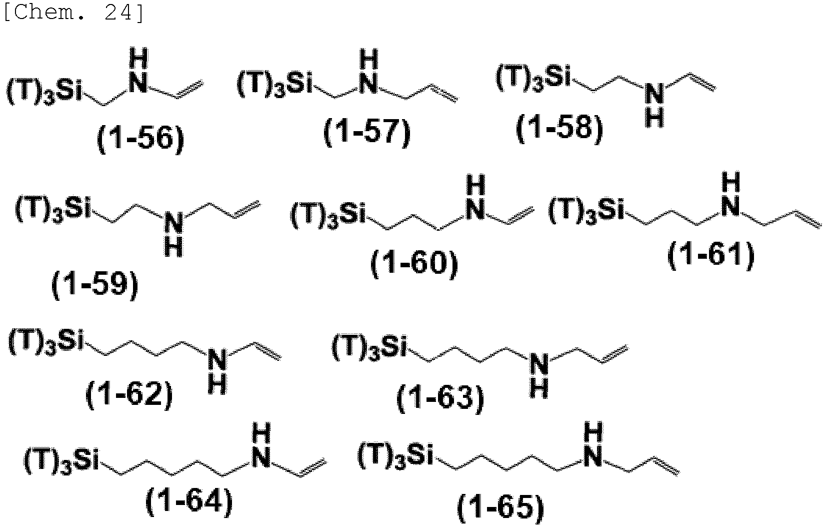

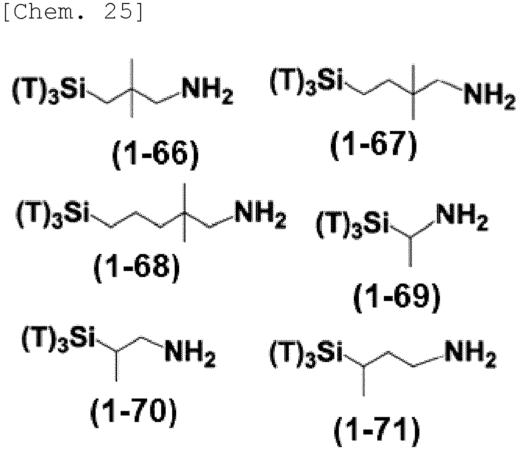

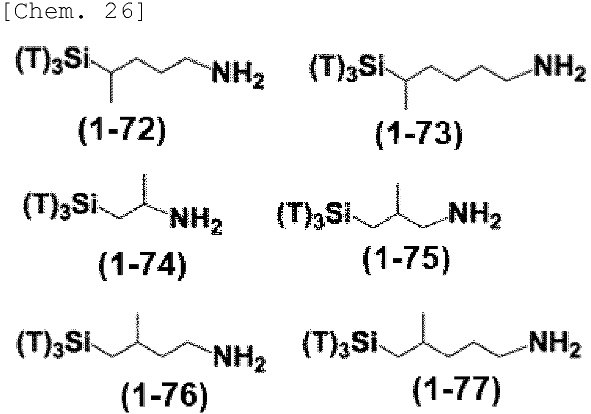

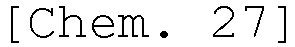

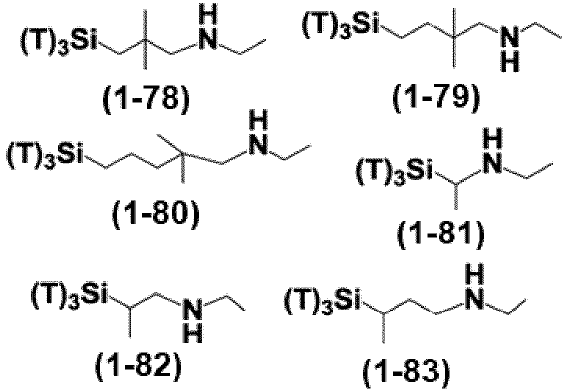

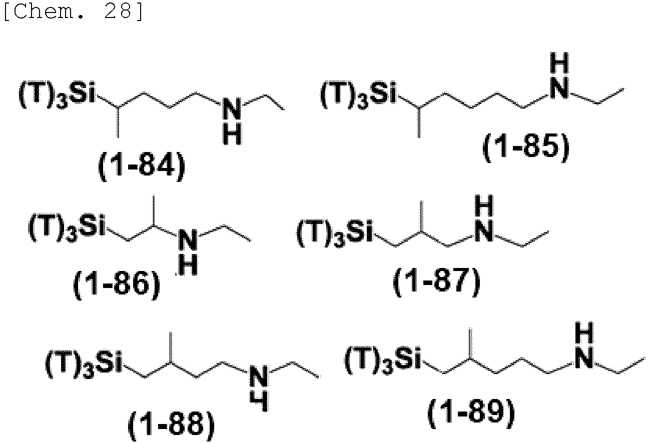

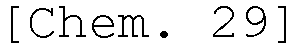

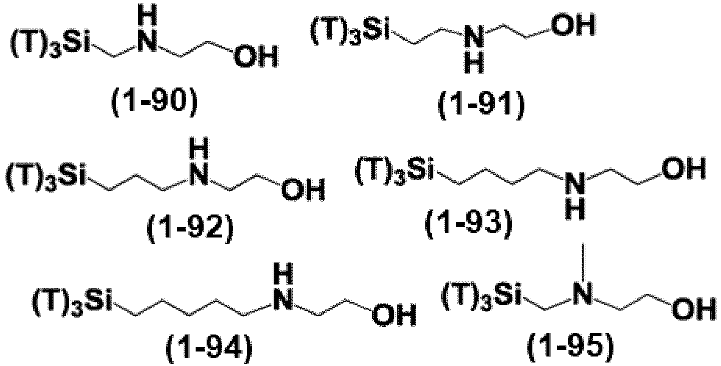

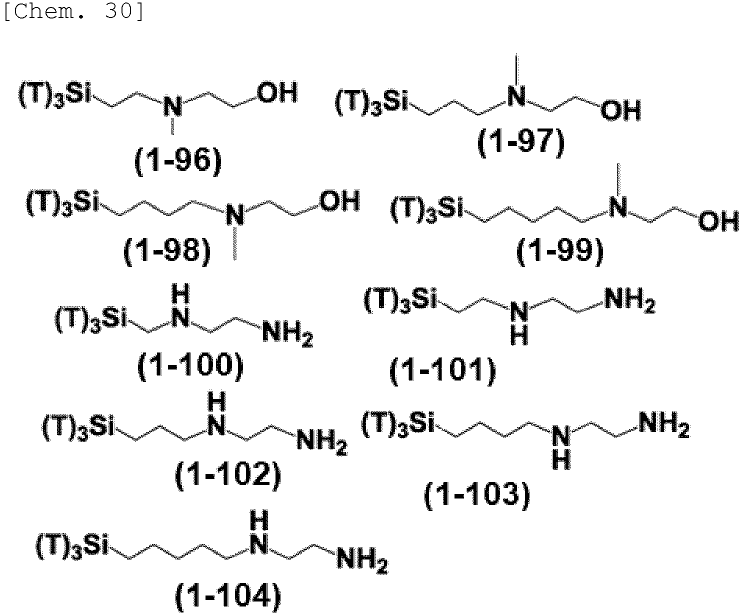

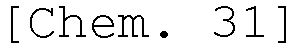

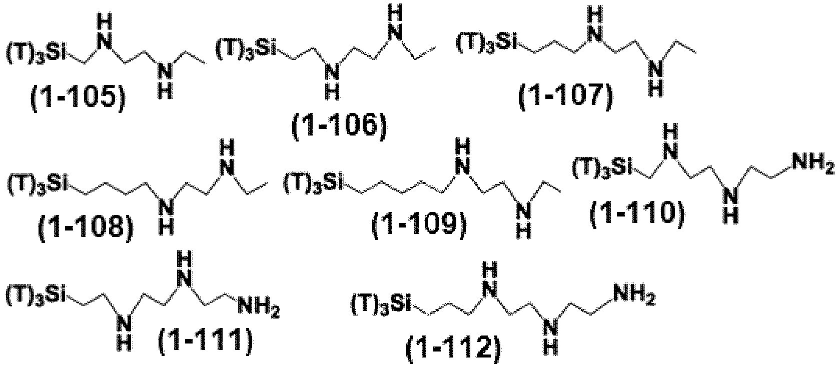

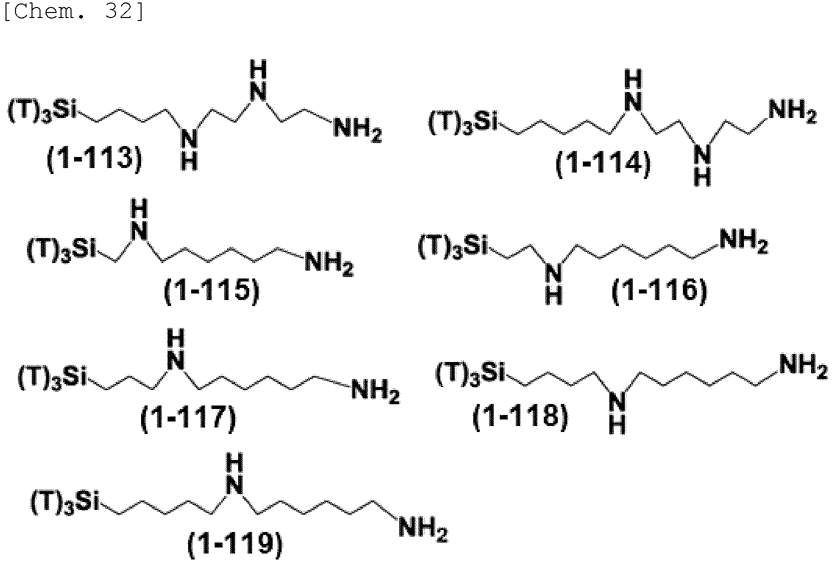

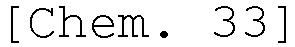

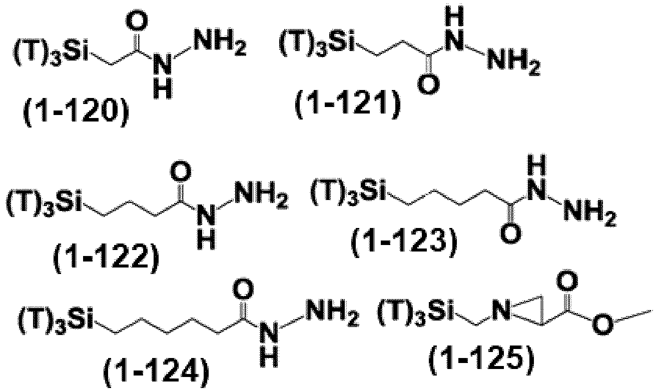

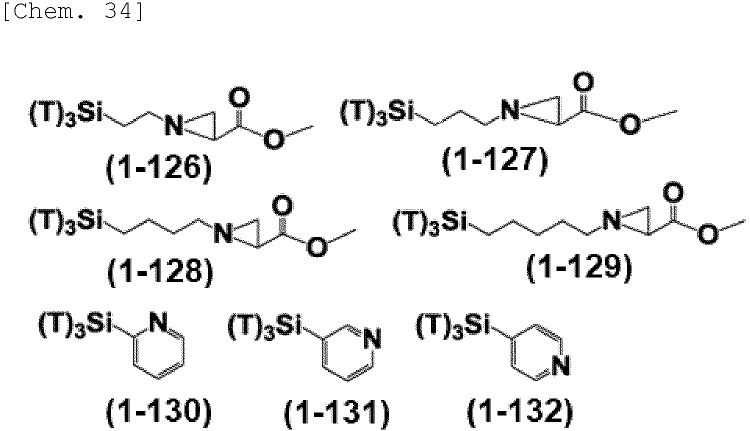

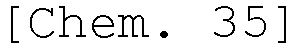

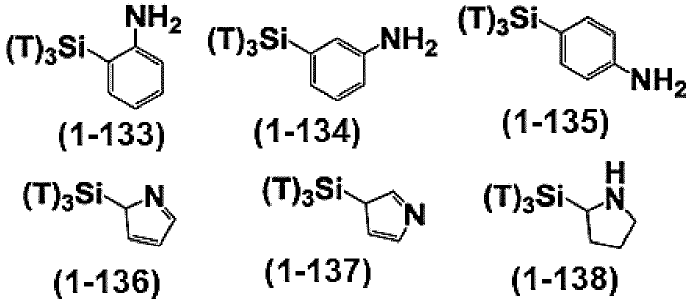

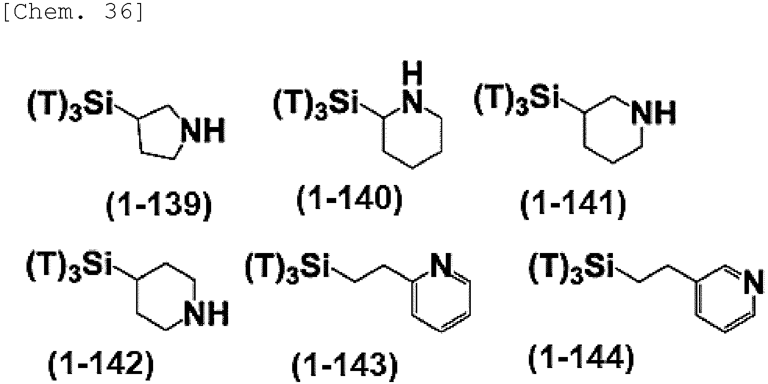

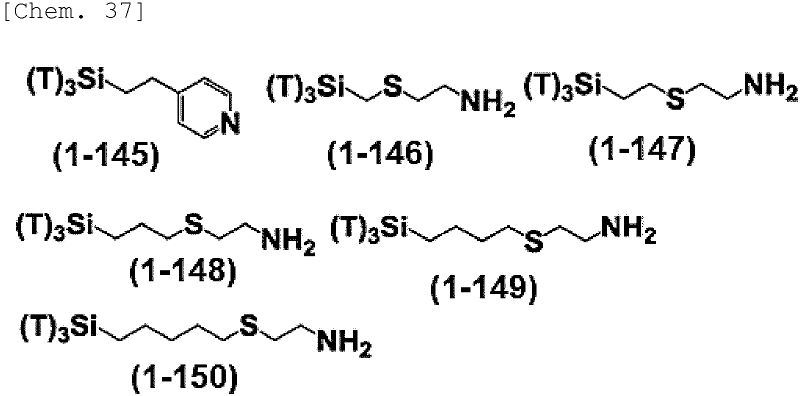

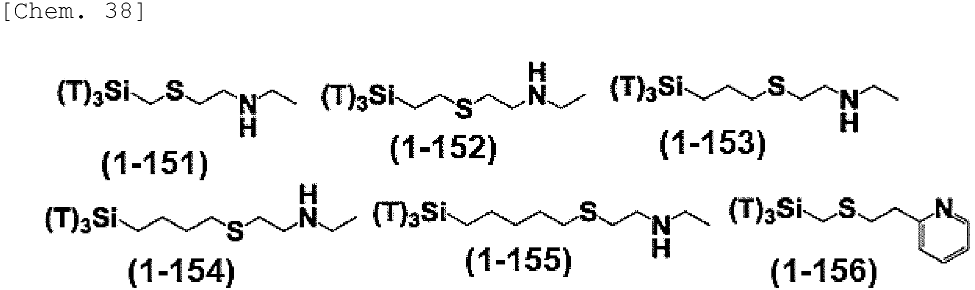

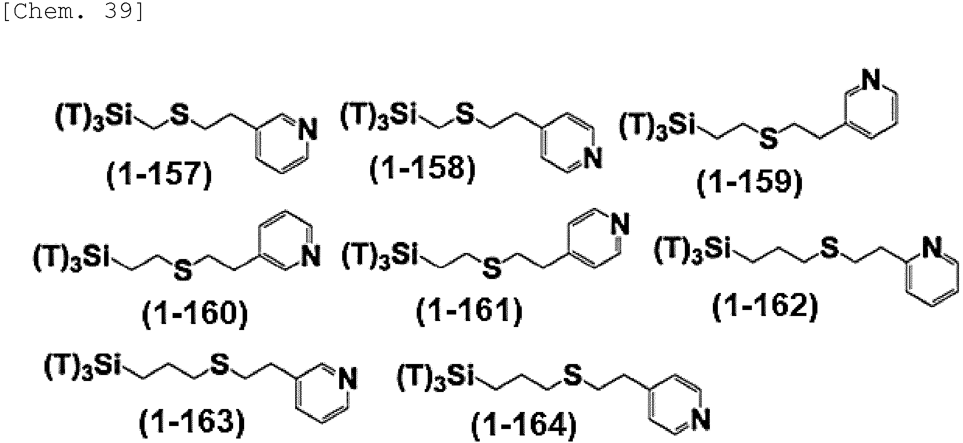

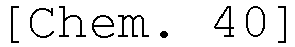

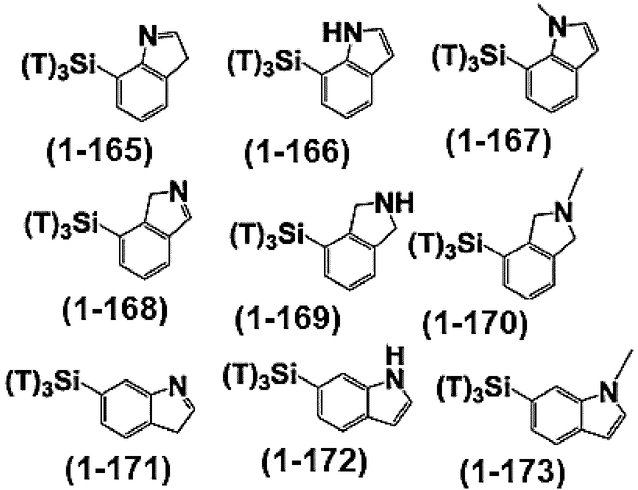

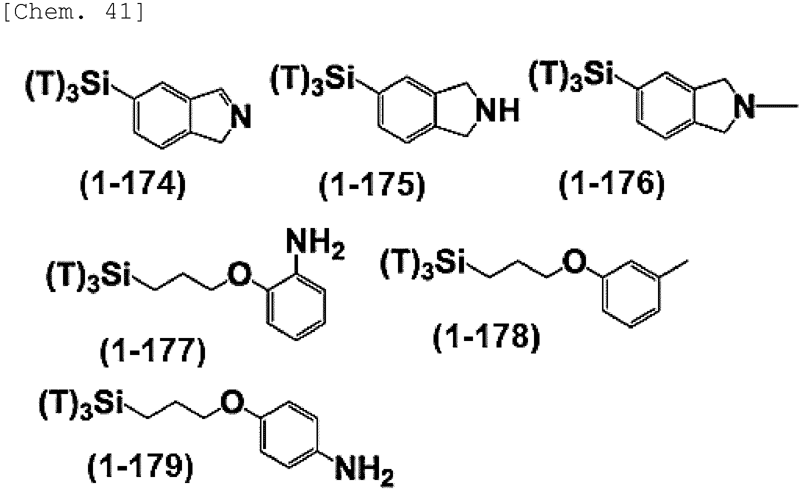

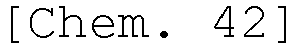

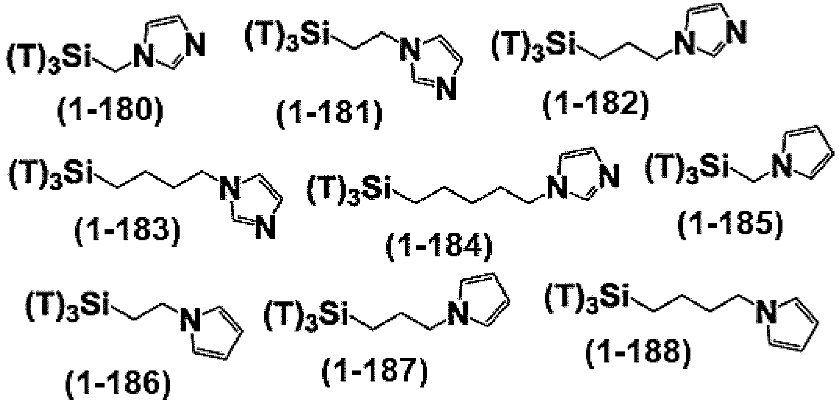

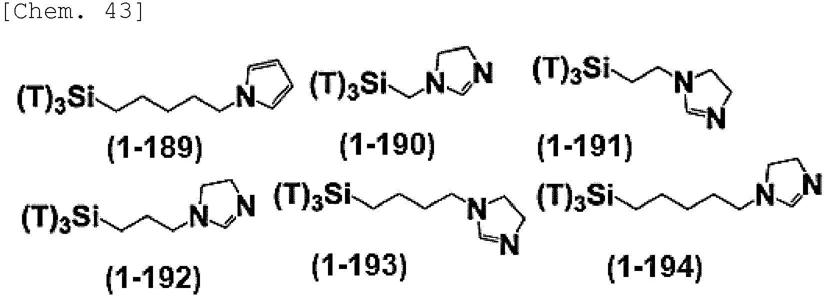

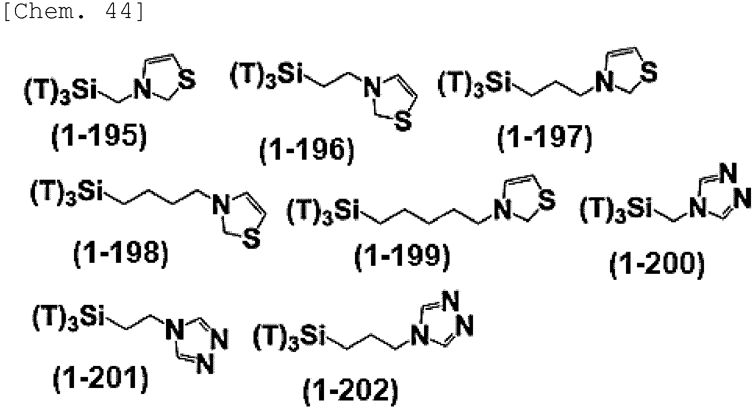

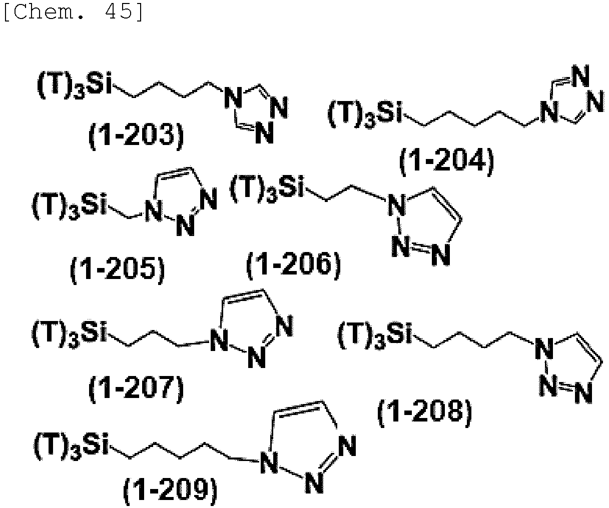

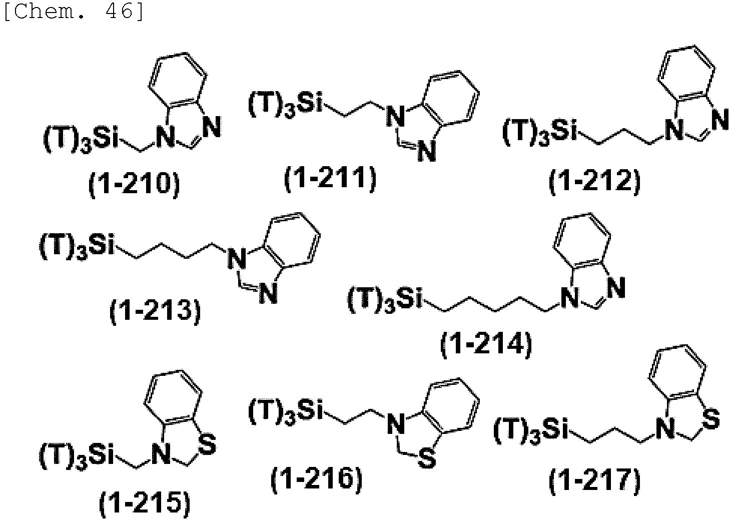

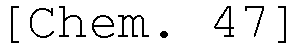

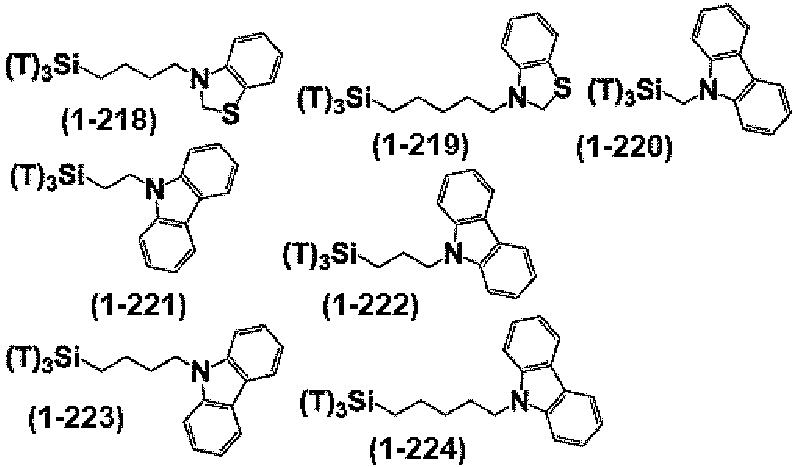

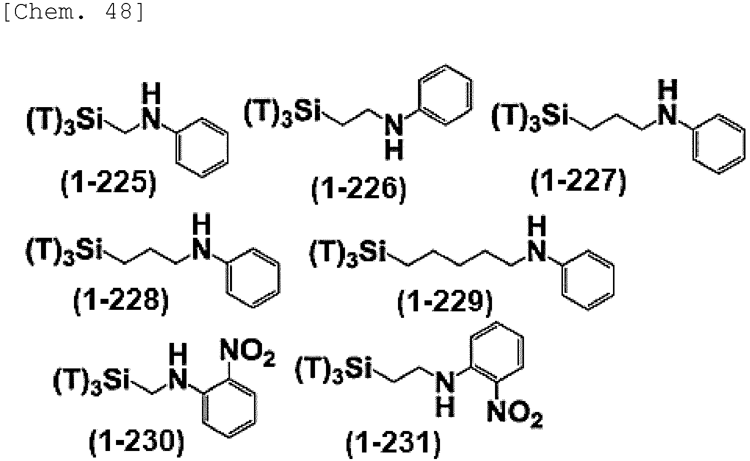

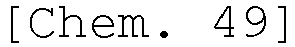

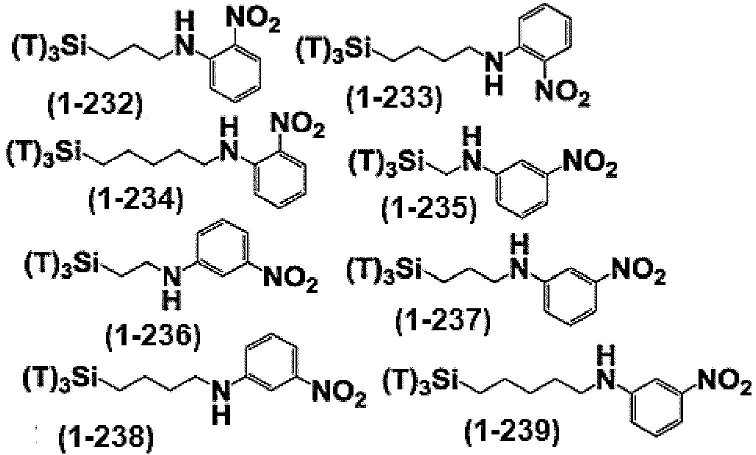

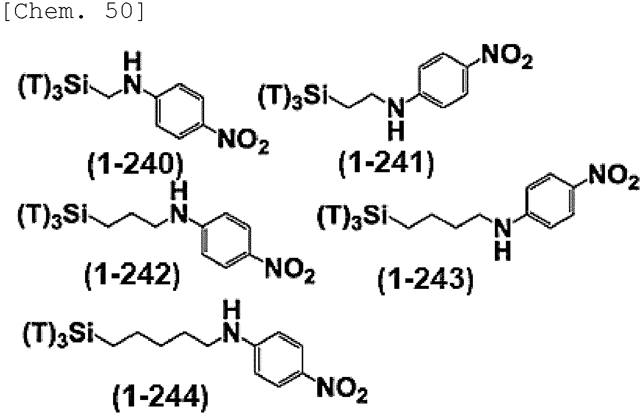

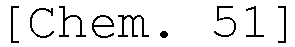

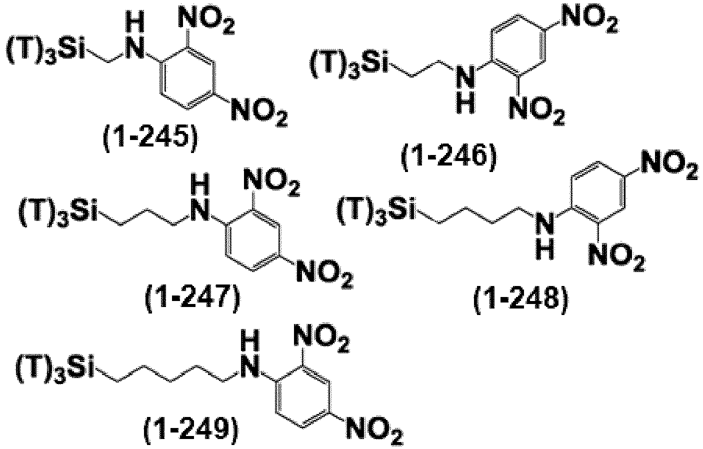

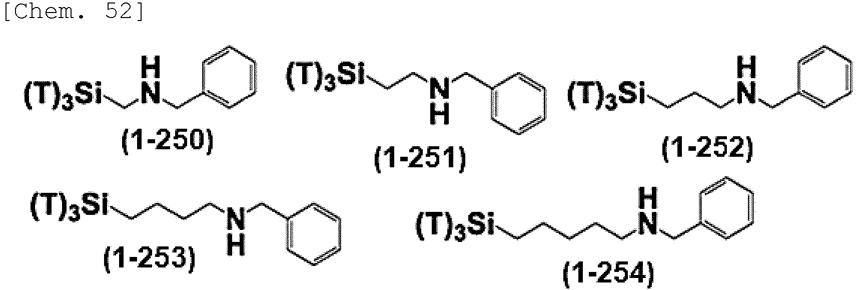

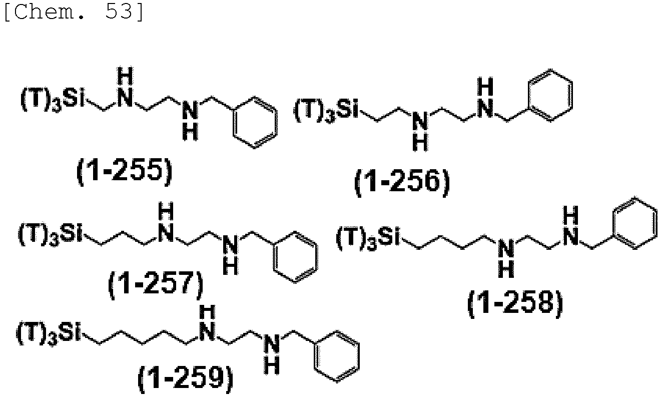

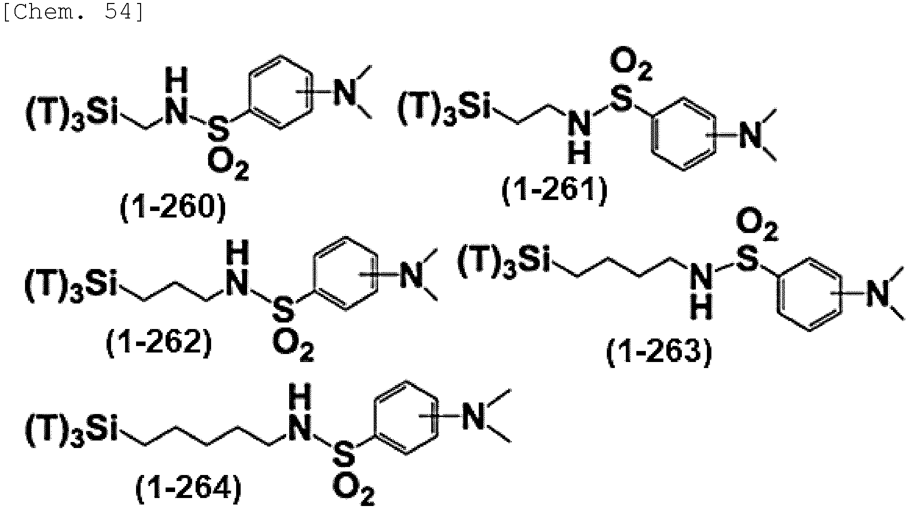

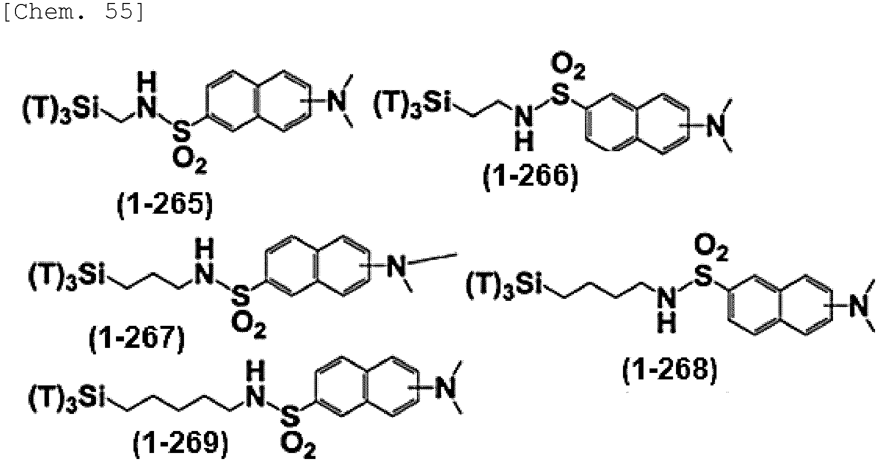

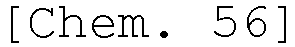

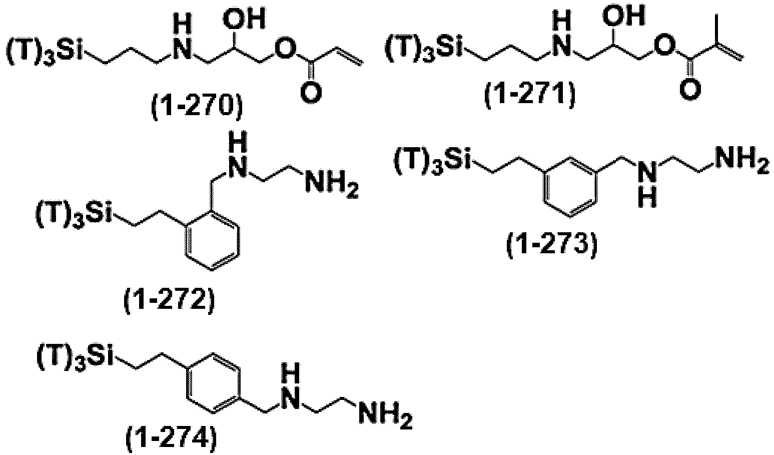

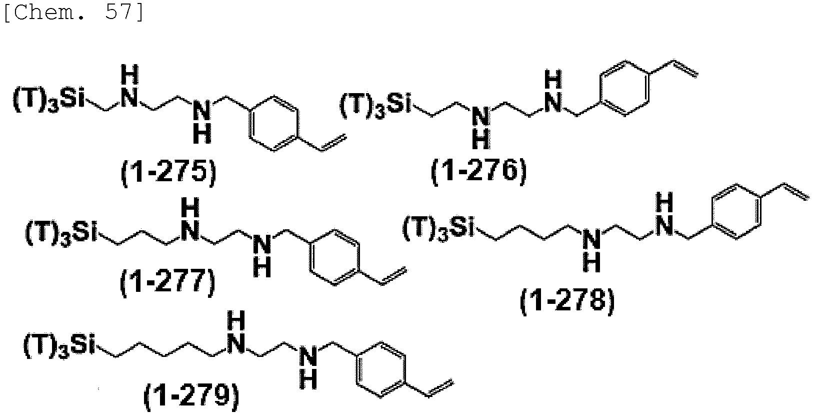

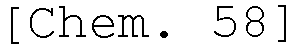

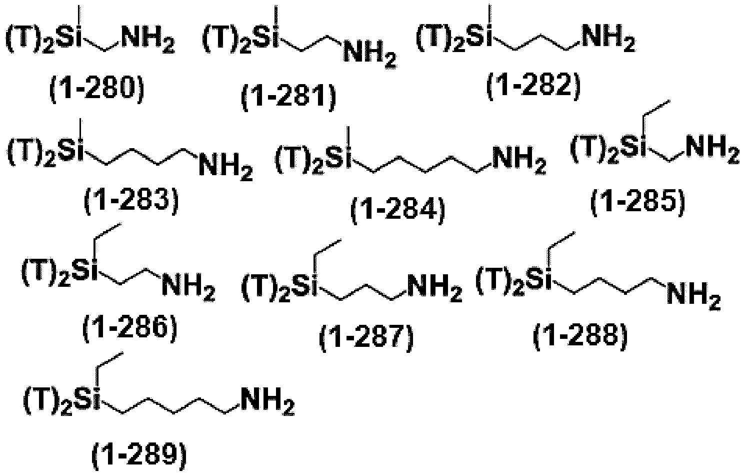

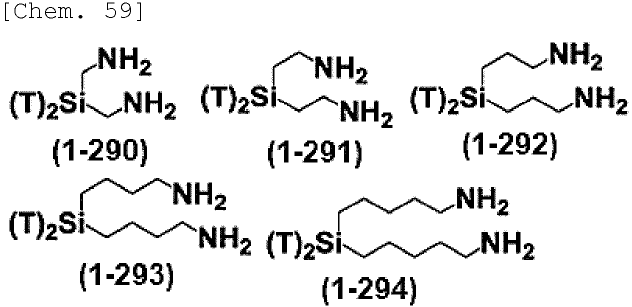

In Formulae (1-1) to (1-294), Ts each independently represent an alkoxy group, an acyloxy group, or a halogen group, and represent preferably a methoxy group or an ethoxy group, for example.

The polysiloxane may be, for example, a hydrolysis condensate of a hydrolyzable silane containing the hydrolyzable silane represented by the following Formula (2) together with the hydrolyzable silane represented by Formula (1) or in place of the hydrolyzable silane represented by Formula (1).
--Formula (2)--
[Chem. 60]

[R^{3b}Si(R⁴)_{3-b}]₂R⁵_{c} (2)

In Formula (2), R³ is a group bonded to a silicon atom, and represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more of these groups.

R⁴ is a group or atom bonded to a silicon atom, and each independently represents an alkoxy group, an aralkyloxy group, an acyloxy group, or a halogen atom.

R⁵ is a group bonded to a silicon atom, and each independently represents an alkylene group or an arylene group.

b represents 0 or 1, and c represents 0 or 1.

Specific examples of the groups of R³ and preferred number of carbon atoms thereof are the same as the groups and the number of carbon atoms thereof described above regarding R¹.

Specific examples of the groups and atoms of R⁴ and preferred number of carbon atoms thereof are the same as the groups and the number of carbon atoms thereof described above regarding R².

Specific examples of the alkylene group in R⁵ include, but are not limited to, alkylene groups, for example, linear alkylene groups such as a methylene group, an ethylene group, a trimethylene group, a tetramethylene group, a pentamethylene group, a hexamethylene group, a heptamethylene group, an octamethylene group, a nonamethylene group, a decamethylene group; branched alkylene groups, such as a 1-methyltrimethylene group, a 2-methyltrimethylene group, a 1,1-dimethylethylene group, a 1-methyltetramethylene group, a 2-methyltetramethylene group, a 1,1-dimethyltrimethylene group, a 1,2-dimethyltrimethylene group, a 2,2-dimethyltrimethylene group, a 1-ethyltrimethylene group; and alkanetriyl groups, such as a methanetriyl group, an ethane-1,1,2-triyl group, an ethane-1,2,2-triyl group, an ethane-2,2,2-triyl group, a propane-1,1,1-triyl group; a propane-1,1,2-triyl group, a propane-1,2,3-triyl group, a propane-1,2,2-triyl group, a propane-1,1,3-triyl group, a butane-1,1,1-triyl group, a butane-1,1,2-triyl group, a butane-1,1,3-triyl group, a butane-1,2,3-triyl group, a butane-1,2,4-triyl group, a butane-1,2,2-triyl group, a butane-2,2,3-triyl group, a 2-methylpropane-1,1,1-triyl group, a 2-methylpropane-1,1,2-triyl group, and a 2-methylpropane-1,1,3-triyl group.

Specific examples of the arylene group in R⁵ include a 1,2-phenylene group, a 1,3-phenylene group, and a 1,4-phenylene group; groups derived by removing two hydrogen atoms on the aromatic ring of a condensed-ring aromatic hydrocarbon compound such as a 1,5-naphthalenediyl group, a 1,8-naphthalenediyl group, a 2,6-naphthalenediyl group, a 2,7-naphthalenediyl group, a 1,2-anthracenediyl group, a 1,3-anthracenediyl group, a 1,4-anthracenediyl group, a 1,5-anthracenediyl group, a 1,6-anthracenediyl group, a 1,7-anthracenediyl group, a 1,8-anthracenediyl group, a 2,3-anthracenediyl group, a 2,6-anthracenediyl group, a 2,7-anthracenediyl group, a 2,9-anthracenediyl group, a 2,10-anthracenediyl group, and a 9,10-anthracenediyl group; groups derived by removing two hydrogen atoms on the aromatic ring of a linked-ring aromatic hydrocarbon compound of a 4,4'-biphenyldiyl group and a 4,4"-p-terphenyldiyl group, and the like, but are not limited thereto.

b is preferably 0.

c is preferably 1.

Specific examples of the hydrolyzable silane represented by Formula (2) include, but are not limited to, methylenebistrimethoxysilane, methylenebistrichlorosilane, methylenebistriacetoxysilane, ethylenebistriethoxysilane, ethylenebistrichlorosilane, ethylenebistriacetoxysilane, propylenebistriethoxysilane, butylenebistrimethoxysilane, phenylenebistrimethoxysilane, phenylenebistriethoxysilane, phenylenebismethyldiethoxysilane, phenylenebismethyldimethoxysilane, naphthylenebistrimethoxysilane, bistrimethoxydisilane, bistrimethoxydisilane, bistriethoxydisilane, bisethyldiethoxydisilane, and bismethyldimethoxydisilane.

Examples of the polysiloxane include a hydrolysis condensate of a hydrolyzable silane including the hydrolyzable silane represented by Formula (1) and/or the hydrolyzable silane represented by Formula (2), or a hydrolysis condensate of a hydrolyzable silane including other hydrolyzable silanes described below in place of those hydrolyzable silanes.

Examples of the other hydrolyzable silane include, but are not limited to, silane compounds having an onium group in the molecule, silane compounds having a sulfone group, silane compounds having a sulfonamide group, and silane compounds having a cyclic urea skeleton in the molecule.

### --Silane Compounds (Hydrolyzable Organosilanes) Having Onium Group in Molecule--

A silane compound having an onium group in the molecule is expected to effectively and efficiently promote the crosslinking reaction of a hydrolyzable silane.

One preferred example of the silane compound having an onium group in the molecule is shown in Formula (3).
[Chem. 61]

R¹¹_{f}R¹²_{g}Si(R¹³)_{4-(f+g)} (3)

R¹¹ is a group bonded to a silicon atom, and represents an onium group or an organic group having the onium group.

R¹² is a group bonded to a silicon atom, and each independently represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an amino group, or an organic group having a cyano group, or a combination of two or more of these groups.

R¹³ is a group or atom bonded to a silicon atom, and each independently represents an alkoxy group, an aralkyloxy group, an acyloxy group, or a halogen atom.

f represents 1 or 2, g represents 0 or 1, and 1 ≤ f + g ≤ 2 is satisfied.

Specific examples of the alkyl group, the aryl group, the aralkyl group, the alkyl halide group, the aryl halide group, the aralkyl halide group, the alkoxyalkyl group, the alkoxyaryl group, the alkoxyaralkyl group, the alkenyl group, and the organic group having an optionally ring-opened epoxy group, the organic group having an acryloyl group, the organic group having a methacryloyl group, the organic group having a mercapto group, the organic group having an amino group and the organic group having a cyano group, the alkoxy group, the aralkyloxy group, the acyloxy group, and the halogen atom, specific examples of substituents of the alkyl group, the aryl group, the aralkyl group, the alkyl halide, the aryl halide group, the aralkyl halide group, the alkoxyaryl group, the alkoxyaralkyl group, and the alkenyl group, and the preferred number of carbon atoms thereof include, for R¹², those described above regarding R¹, and for R¹³, those described above regarding R².

More specifically, the onium group is, for example, a cyclic ammonium group or a chain ammonium group, and is preferably a tertiary ammonium group or a quaternary ammonium group.

That is, preferred specific examples of the onium group or the organic group having the onium group include a cyclic ammonium group, a chain ammonium group, or an organic group containing at least one of the cyclic ammonium group or the chain ammonium group. Preferred is a tertiary ammonium group or a quaternary ammonium group or an organic group containing at least one of the tertiary ammonium group or the quaternary ammonium group.

When the onium group is a cyclic ammonium group, a nitrogen atom forming the ammonium group also serves as an atom constituting the ring. In this case, the nitrogen atom forming the ring and the silicon atom are bonded directly or via a divalent linking group, or the carbon atom forming the ring and the silicon atom are bonded directly or via a divalent linking group.

In one preferred aspect, R¹¹, i.e. the group bonding to the silicon atom, is a heteroaromatic cyclic ammonium group represented by the following Formula (S1).

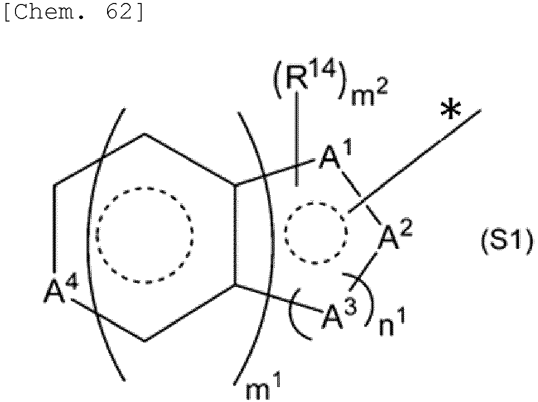

In Formula (S1), A¹, A², A³, and A⁴ each independently represent a group represented by any one of the following Formulae (J1) to (J3), and at least one of A¹ to A⁴ is a group represented by the following Formula (J2), and the bond between each of A¹ to A⁴ and the atom adjacent thereto and constituting the ring is determined to be a single bond or a double bond according to which of A¹ to A⁴ the silicon atom in Formula (3) is bonded, such that the constituted ring exhibits aromaticity. An asterisk * represents a bonding site.

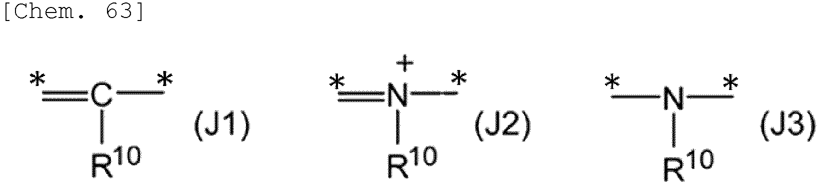

In Formulae (J1) to (J3), each R¹⁰ independently represents a single bond, a hydrogen atom, an alkyl group, an aryl group, an aralkyl group, an alkyl halide group, an aryl halide group, an aralkyl halide group or an alkenyl group. Specific examples of the alkyl group, the aryl group, the aralkyl group, the alkyl halide group, the aryl halide group, the aralkyl halide group, and the alkenyl group, and the preferred number of carbon atoms thereof are the same as those described above. Each asterisk * represents a bonding site.

In Formula (S1), each R¹⁴ independently represents an alkyl group, an aryl group, an aralkyl group, an alkyl halide group, an aryl halide group, an aralkyl halide group, an alkenyl group or a hydroxy group. When two or more R¹⁴s are present, the two R¹⁴s may be bonded to each other to form a ring. A ring formed by two R¹⁴s may have a crosslinked ring structure, and in such a case, the cyclic ammonium group has an adamantane ring, a norbornene ring, a spiro ring or the like.

Specific examples of such an alkyl group, an aryl group, an aralkyl group, an alkyl halide group, an aryl halide group, an aralkyl halide group, and an alkenyl group, and the preferred number of carbon atoms thereof are the same as those described above.

In Formula (S1), n¹ is an integer of 1 to 8, m¹ is 0 or 1, and m² is 0 or a positive integer ranging from 1 to the possible maximum number being substituted on a monocyclic or polycyclic ring.

When m¹ is 0, a (4+n¹)-membered ring including A¹ to A⁴ is formed. That is, when n¹ is 1, a 5-membered ring is formed; when n¹ is 2, a 6-membered ring is formed; when n¹ is 3, a 7-membered ring is formed; when n¹ is 4, an 8-membered ring is formed; when n¹ is 5, a 9-membered ring is formed; when n¹ is 6, a 10-membered ring is formed; when n¹ is 7, an 11-membered ring is formed; and when n¹ is 8, a 12-membered ring is formed.

When m¹ is 1, a condensed ring is formed by condensation between a (4+n¹)-membered ring including A¹ to A³ and a 6-membered ring including A⁴.

Since each of A¹ to A⁴ is any of the groups of Formulae (J1) to (J3), the ring-forming atom has or does not have a hydrogen atom. In each of A¹ to A⁴, when the ring-forming atom has a hydrogen atom, the hydrogen atom may be substituted with R¹⁴. Alternatively, a ring-forming atom other than the ring-forming atom in each of A¹ to A⁴ may be substituted with R¹⁴. Because of such circumstances, as described above, m² is selected from 0 or an integer ranging from 1 to the maximum number that can be substituted on a monocyclic or polycyclic ring.

The bonding site of the heteroaromatic cyclic ammonium group represented by Formula (S1) is present on any carbon atom or nitrogen atom present in such a monocyclic ring or condensed ring, and is directly bonded to a silicon atom. Alternatively, the bonding site is bonded to a linking group to form an organic group containing the cyclic ammonium group, and the organic group is bonded to a silicon atom.

Examples of the linking group include, but are not limited thereto, an alkylene group, an arylene group, and an alkenylene group.

Specific examples of the alkylene group and the arylene group and preferred number of carbon atoms are the same as those described above.

The alkenylene group is a divalent group derived by further removing one hydrogen atom from the alkenyl group, and specific examples of the alkenyl group are the same as those described above. The number of carbon atoms in the alkenylene group is not particularly limited, but is preferably 40 or less, more preferably 30 or less, and still more preferably 20 or less.

Specific examples thereof include, but are not limited thereto, vinylene, 1-methylvinylene, propenylene, 1-butenylene, 2-butenylene, 1-pentenylene, and 2-pentenylene group.

Specific examples of the silane compound (hydrolyzable organosilane) represented by Formula (3) having the heteroaromatic cyclic ammonium group represented by Formula (S1) include, but are not limited to, silanes represented by the following Formulae (I-1) to (I-50).

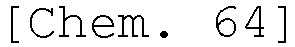

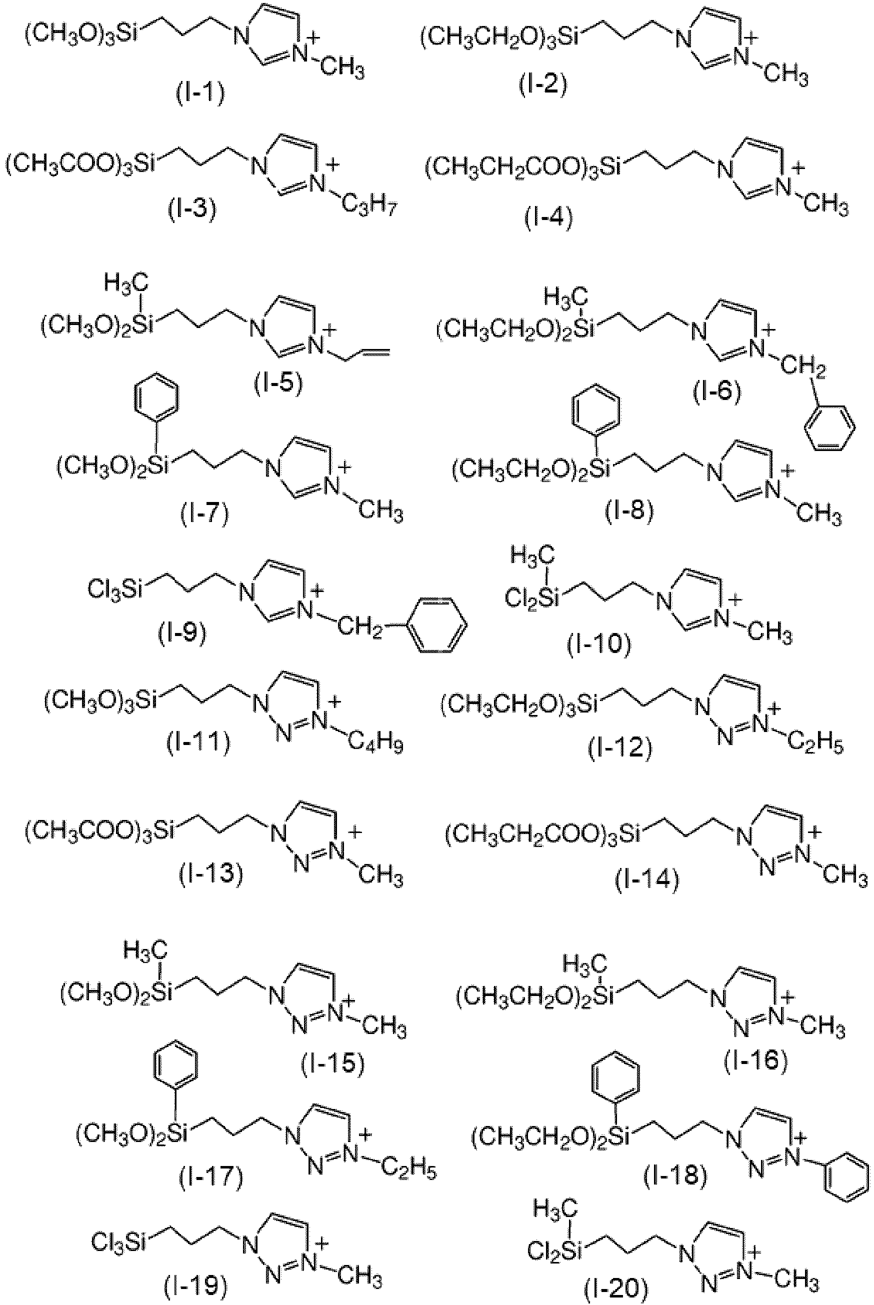

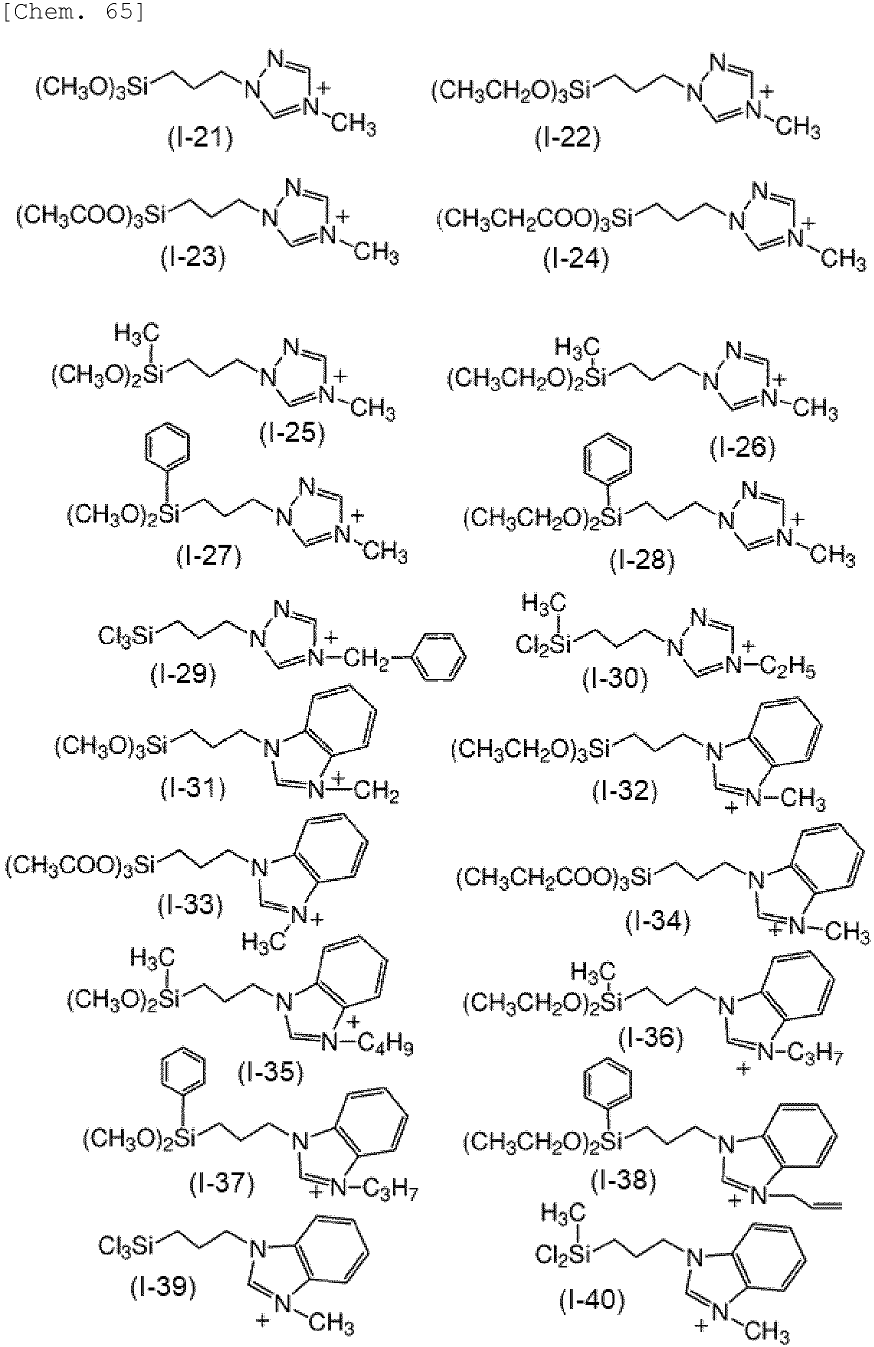

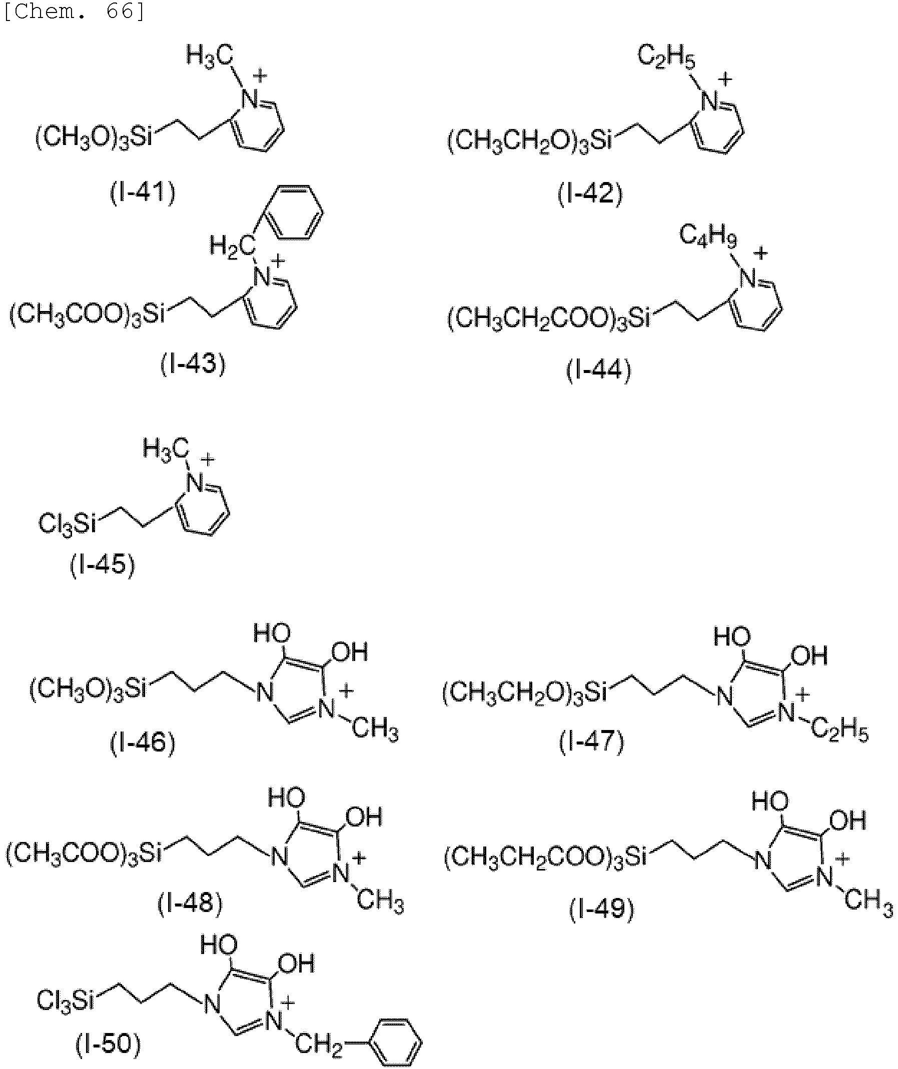

In another example, R¹¹, i.e. the group bonding to the silicon atom in Formula (3), may be a heteroaliphatic cyclic ammonium group represented by the following Formula (S2) .

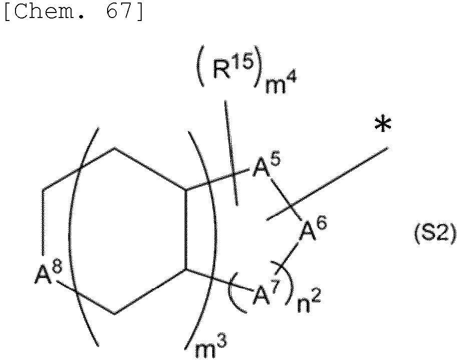

In the Formula (S2), A⁵, A⁶, A⁷, and A⁸ each independently represent a group represented by any one of the following Formulae (J4) to (J6), and at least one of A⁵ to A⁸ represents a group represented by the following Formula (J5). Depending on to which atom of A⁵ to A⁸ a silicon atom in Formula (3) is bonded, it is determined whether a bond between any one of A⁵ to A⁸ and a ring-forming atom adjacent to the any one is a single bond or a double bond so that the ring to be formed exhibits non-aromaticity. An asterisk * represents a bonding site.

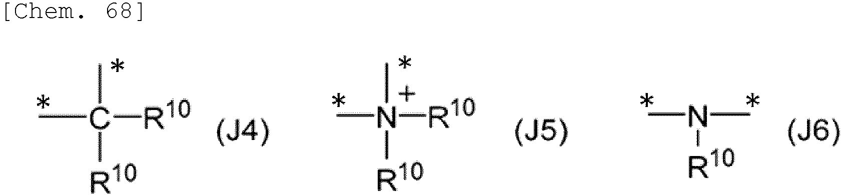

In Formulae (J4) to (J6), each R¹⁰ independently represents a single bond, a hydrogen atom, an alkyl group, an aryl group, an aralkyl group, an alkyl halide group, an aryl halide group, an aralkyl halide group or an alkenyl group. Specific examples of the alkyl group, the aryl group, the aralkyl group, the alkyl halide group, the aryl halide group, the aralkyl halide group, and the alkenyl group, and the preferred number of carbon atoms thereof are the same as those described above. An asterisk * represents a bonding site.

In Formula (S2), each R¹⁵ independently represents an alkyl group, an aryl group, an aralkyl group, an alkyl halide group, an aryl halide group, an aralkyl halide group, an alkenyl group or a hydroxy group. When two or more R¹⁵s are present, the two R¹⁵s may be bonded to each other to form a ring. A ring formed by two R¹⁵s may have a crosslinked ring structure, and in such a case, the cyclic ammonium group has an adamantane ring, a norbornene ring, a spiro ring or the like.

Specific examples of the alkyl group, the aryl group, the aralkyl group, the alkyl halide group, the aryl halide group, the aralkyl halide group, and the alkenyl group, and the preferred number of carbon atoms thereof are the same as those described above.

In Formula (S2), n² is an integer of 1 to 8, m³ is 0 or 1, and m⁴ is 0 or a positive integer ranging from 1 to the possible maximum number being substituted on a monocyclic or polycyclic ring.

When m³ is 0, a (4+n²)-membered ring including A⁵ to A⁸ is formed. That is, when n² is 1, a 5-membered ring is formed; when n² is 2, a 6-membered ring is formed; when n² is 3, a 7-membered ring is formed; when n² is 4, an 8-membered ring is formed; when n² is 5, a 9-membered ring is formed; when n² is 6, a 10-membered ring is formed; when n² is 7, an 11-membered ring is formed; and when n² is 8, a 12-membered ring is formed.

When m³ is 1, a condensed ring is formed by condensation between a (4+n²)-membered ring including A⁵ to A⁷ and a 6-membered ring including A⁸.

Since each of A⁵ to A⁸ is any of the groups of Formulae (J4) to (J6), the ring-forming atom has or does not have a hydrogen atom. In each of A⁵ to A⁸, when the ring-forming atom has a hydrogen atom, the hydrogen atom may be substituted with R¹⁵. Alternatively, a ring-forming atom other than the ring-forming atom in each of A⁵ to A⁸ may be substituted with R¹⁵.

Because of such circumstances, as described above, m⁴ is selected from 0 or an integer ranging from 1 to the possible maximum number being substituted on a monocyclic or polycyclic ring.

The bonding site of the heteroaliphatic cyclic ammonium group represented by Formula (S2) is present on any carbon atom or nitrogen atom present in such a monocyclic ring or condensed ring, and is directly bonded to a silicon atom. Alternatively, the bonding site is bonded to a linking group to form an organic group containing the cyclic ammonium group, and the organic group is bonded to a silicon atom.

The linking group is, for example, an alkylene group, an arylene group, or an alkenylene group. Specific examples of the alkylene group, the arylene group, and the alkenylene group and the preferred number of carbon atoms are the same as those described above.

Specific examples of the silane compound (hydrolyzable organosilane) represented by Formula (3) having the heteroaliphatic cyclic ammonium group represented by Formula (S2) include, but are not limited to, silanes represented by the following Formulae (II-1) to (II-30).

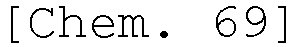

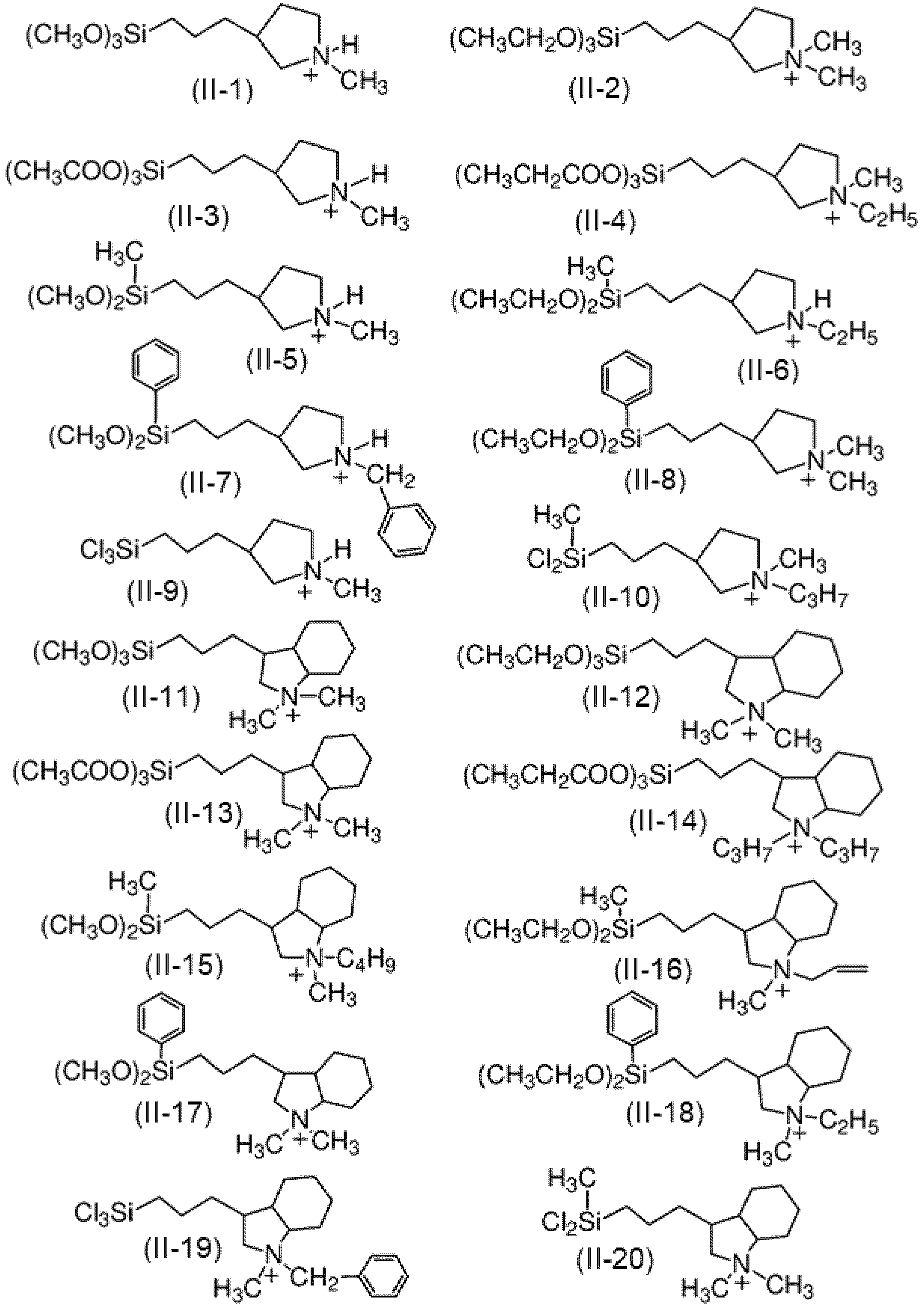

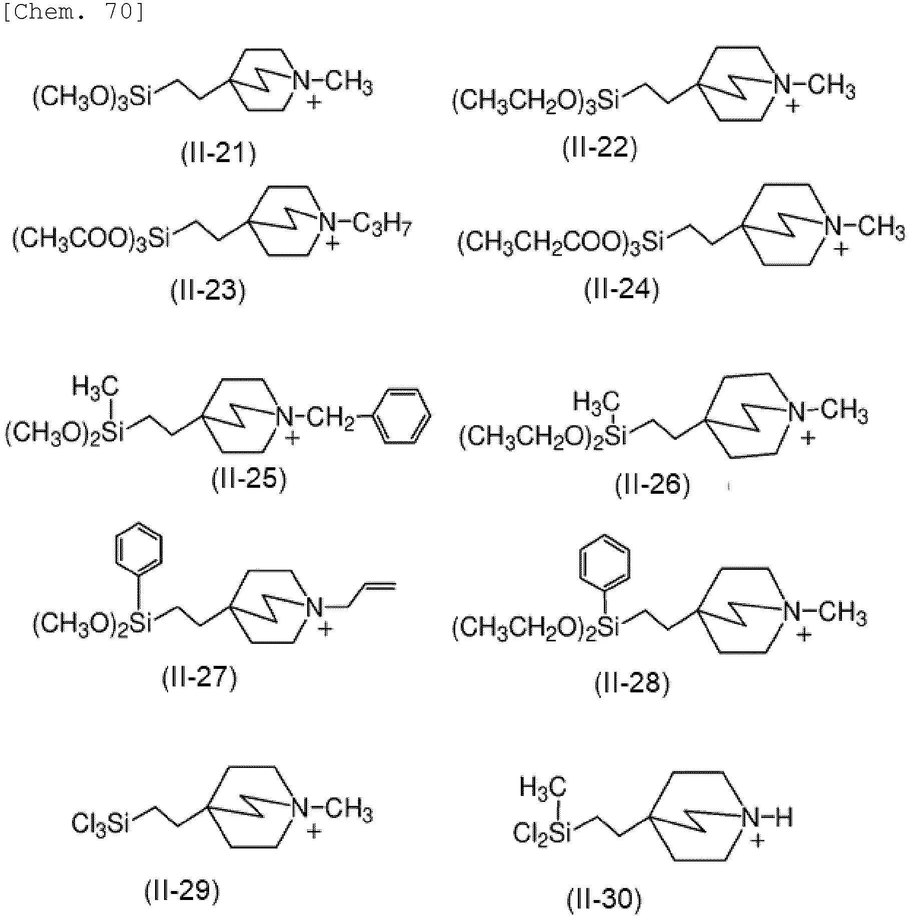

In another example, R¹¹, i.e. the group bonding to the silicon atom in Formula (3), may be a chain ammonium group represented by the following Formula (S3).

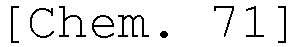

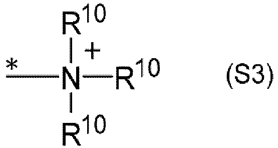

In Formula (S3), each R¹⁰ independently represents a hydrogen atom, an alkyl group, an aryl group, an aralkyl group, an alkyl halide group, an aryl halide group, an aralkyl halide group or an alkenyl group. Specific examples of the alkyl group, the aryl group, the aralkyl group, the alkyl halide group, the aryl halide group, the aralkyl halide group, and the alkenyl group, and the preferred number of carbon atoms thereof are the same as those described above. An asterisk * represents a bonding site.

The chain ammonium group represented by Formula (S3) is directly bonded to a silicon atom. Alternatively, the chain ammonium group is bonded to a linking group to form an organic group containing the chain ammonium group, and the organic group is bonded to a silicon atom.

The linking group is, for example, an alkylene group, an arylene group, or an alkenylene group. Specific examples of the alkylene group, the arylene group, and the alkenylene group are the same as those described above.

Specific examples of the silane compound (hydrolyzable organosilane) represented by Formula (3) having the chain ammonium group represented by Formula (S3) include, but are not limited to, silanes represented by the following Formulae (III-1) to (III-28).

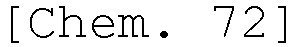

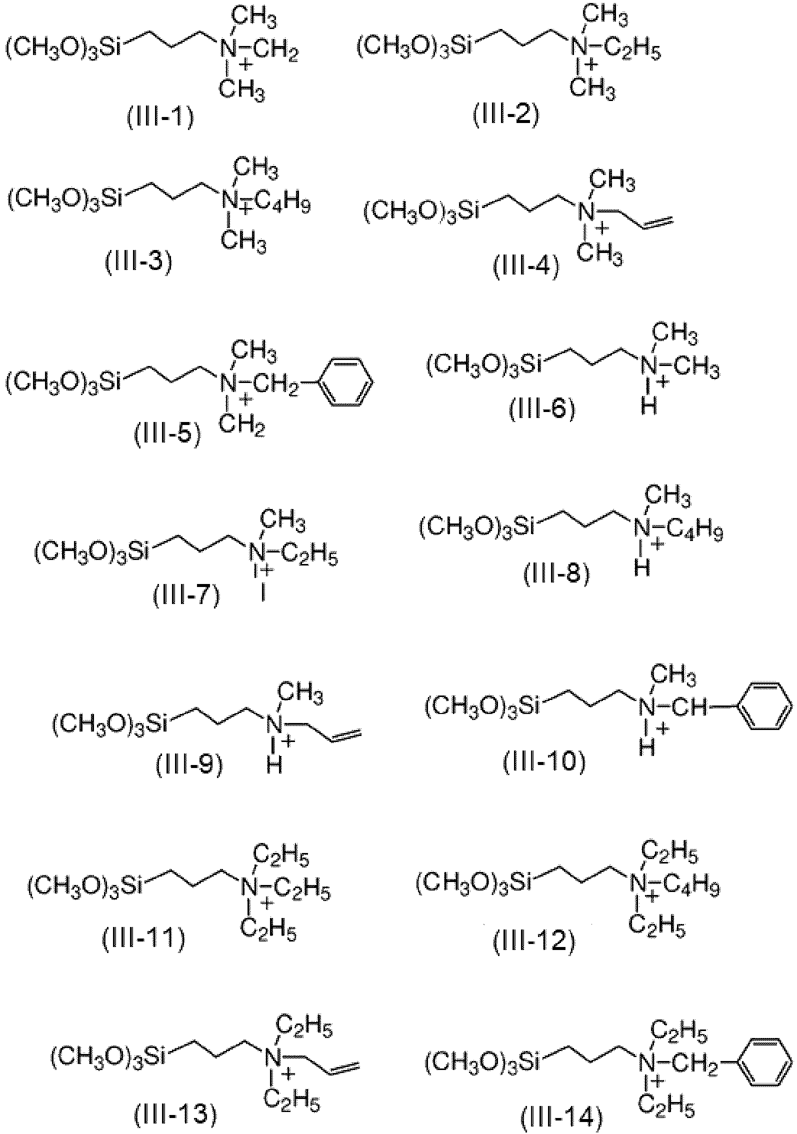

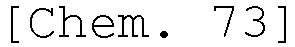

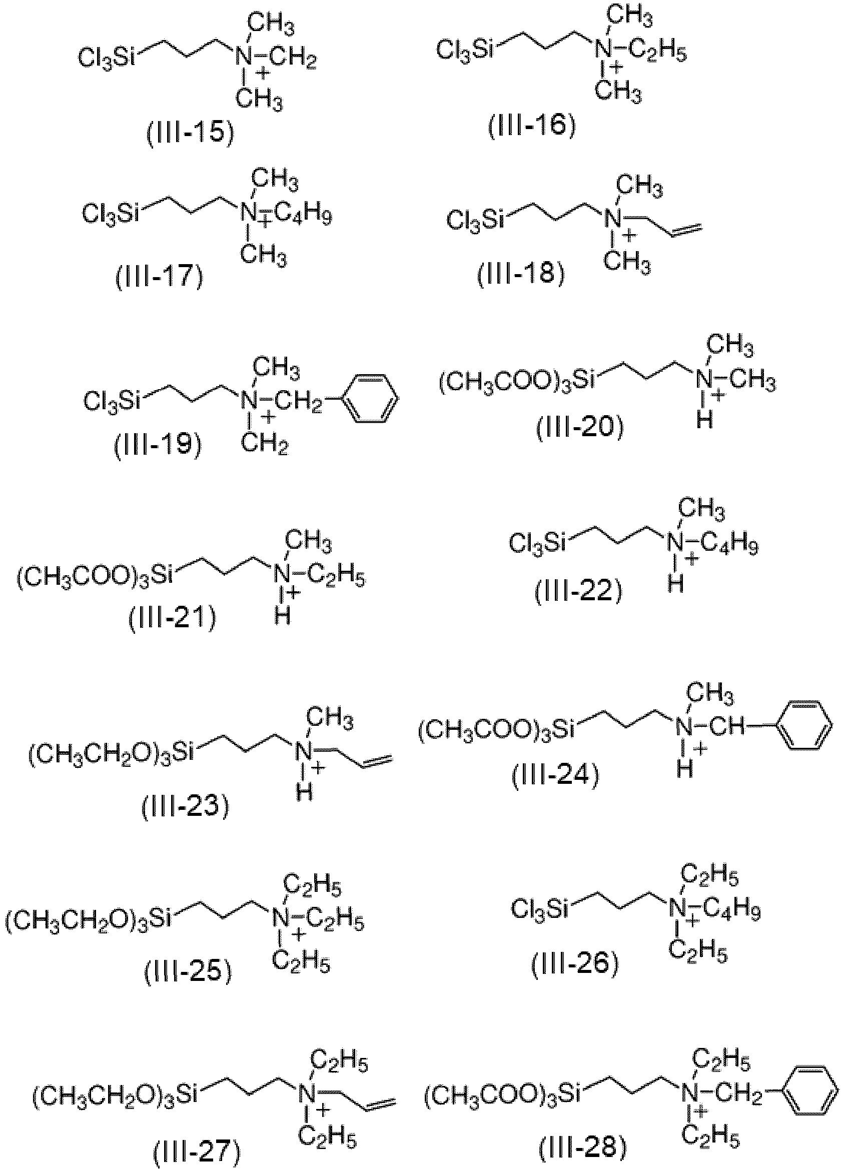

### --Silane Compounds (Hydrolyzable Organosilanes) Having Sulfone Group or Sulfonamide Group--

Examples of the silane compounds having a sulfone group and the silane compounds having a sulfonamide group include, but are not limited to, compounds represented by the following Formulae (B-1) to (B-36).

In the following Formulae, Me represents a methyl group, and Et represents an ethyl group.

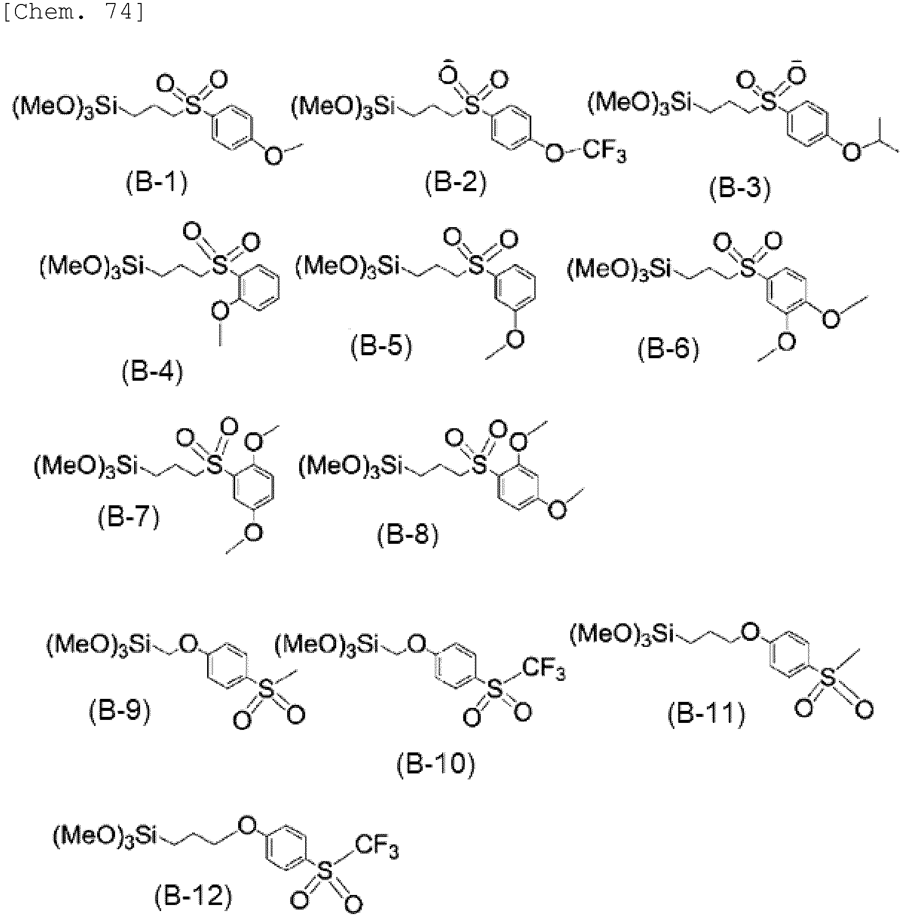

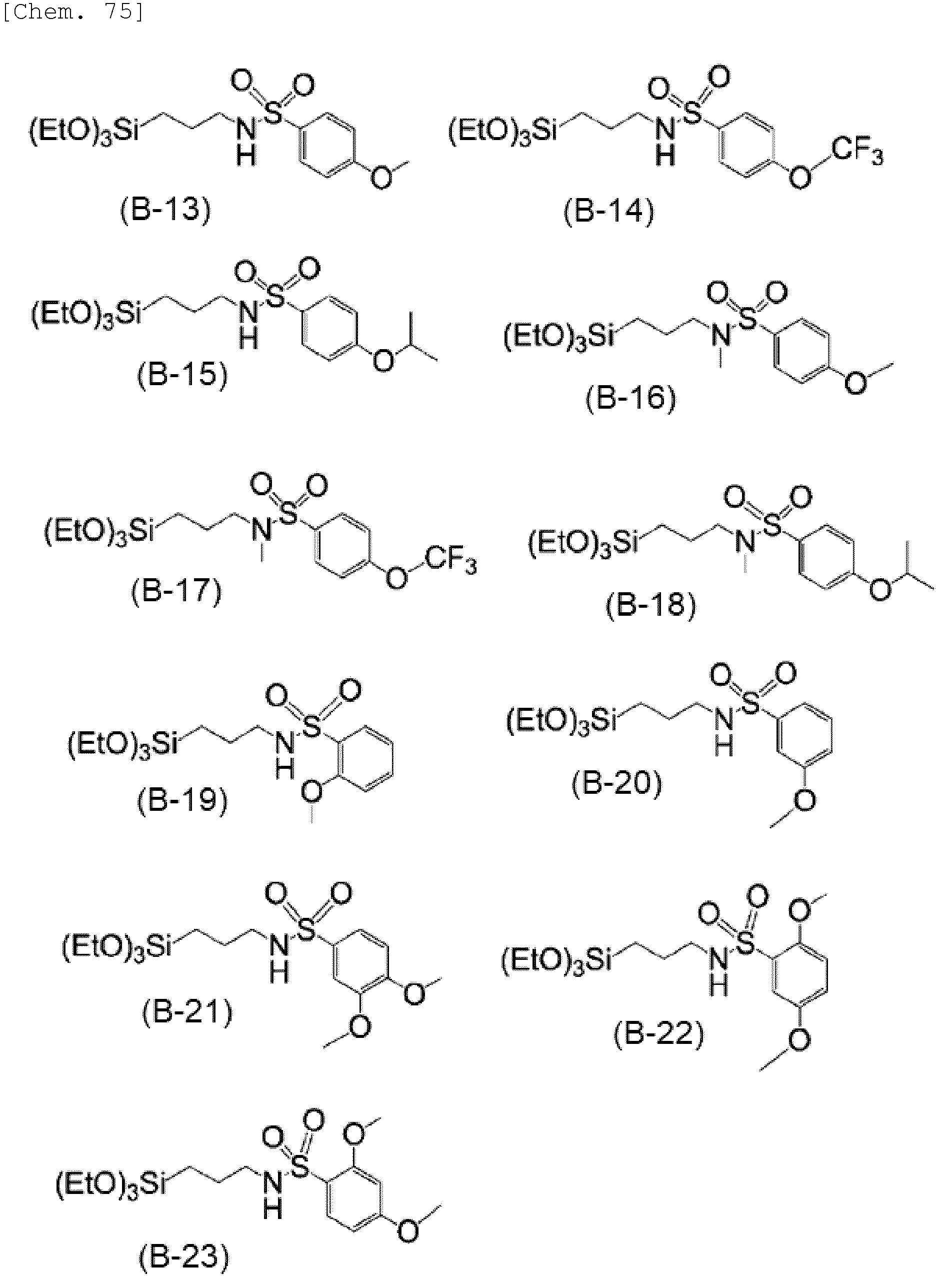

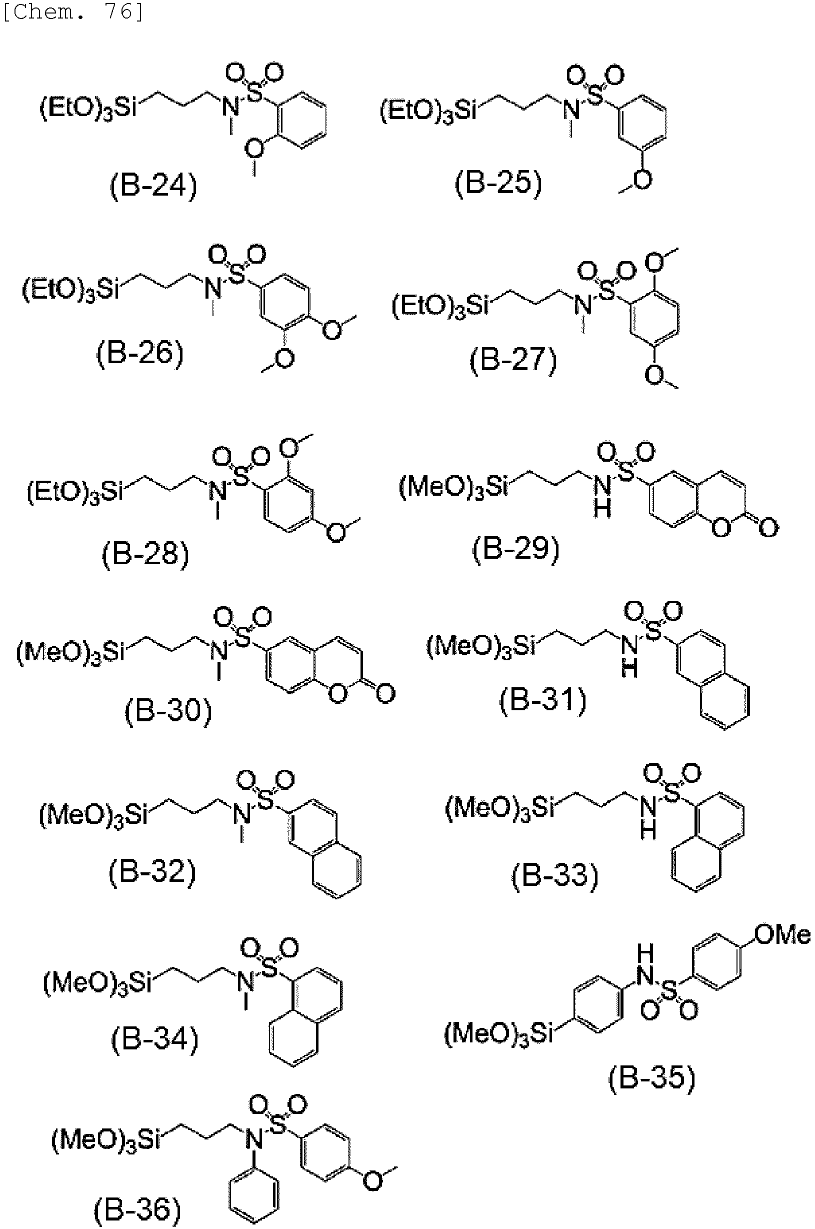

--Silane Compounds (Hydrolyzable Organosilanes) Having Cyclic Urea Skeleton in Molecule--

Examples of the hydrolyzable organosilanes having a cyclic urea skeleton in the molecule include hydrolyzable organosilanes represented by the following Formula (4-1).
[Chem. 77]

R⁴⁰¹ₓR⁴⁰²_{y}Si(R⁴⁰³)_{4-(x+y)} (4-1)

In Formula (4-1), R⁴⁰¹ is a group bonded to a silicon atom, and independently represents a group represented by Formula (4-2) described below.

R⁴⁰² is a group bonded to a silicon atom, and represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or represents an organic group having an optionally ring-opened epoxy group, an organic group having an acryloyl group, an organic group having a methacryloyl group, an organic group having a mercapto group, or an organic group having a cyano group, or a combination of two or more of these groups.

R⁴⁰³ is a group or atom bonded to a silicon atom, and independently represents an alkoxy group, an aralkyloxy group, an acyloxy group, or a halogen atom.

x is 1 or 2, y is 0 or 1, and x+y ≤ 2 is satisfied.

Specific examples of the alkyl group, the aryl group, the aralkyl group, the alkyl halide group, the aryl halide group, the aralkyl halide group, the alkoxyalkyl group, the alkoxyaryl group, the alkoxyaralkyl group, the alkenyl group, the organic group having an optionally ring-opened epoxy group, the organic group having an acryloyl group, the organic group having a methacryloyl group, the organic group having a mercapto group, and the organic group having a cyano group of R⁴⁰², and the alkoxy group, the aralkyloxy group, the acyloxy group, and the halogen atom of R⁴⁰³, and substituent groups thereof, the preferred number of carbon atoms, and the like include those described above regarding R¹ and R². 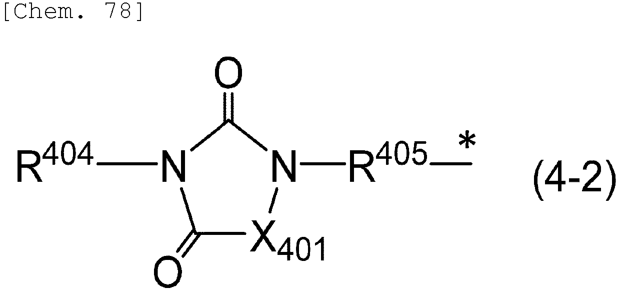 In Formula (4-2), each R⁴⁰⁴ independently represents a hydrogen atom, an optionally substituted alkyl group, an optionally substituted alkenyl group, or an organic group having an epoxy group or an organic group having a sulfonyl group, and each R⁴⁰⁵ independently represents an alkylene group, a hydroxyalkylene group, a sulfide bond (-S-), an ether bond (-O-), or an ester bond (-CO-O- or -O-CO-). An asterisk * represents a bonding site.

Note that with regard to R⁴⁰⁴, specific examples of the optionally substituted alkyl group, the optionally substituted alkenyl group, and the organic group having an epoxy group, and the preferred number of carbon atoms are the same as those described above regarding R¹. In addition, the optionally substituted alkyl group of R⁴⁰⁴ is preferably an alkyl group in which a terminal hydrogen atom is substituted with a vinyl group, and specific examples thereof include an allyl group, a 2-vinylethyl group, a 3-vinylpropyl group, and a 4-vinylbutyl group.

The organic group having a sulfonyl group is not particularly limited as long as it contains a sulfonyl group, and examples thereof include an alkylsulfonyl group which may be substituted, an arylsulfonyl group which may be substituted, an aralkylsulfonyl group which may be substituted, an alkylsulfonyl halide group which may be substituted, an arylsulfonyl halide group which may be substituted, an aralkylsulfonyl halide group which may be substituted, an alkoxyalkylsulfonyl group which may be substituted, an alkoxyarylsulfonyl group which may be substituted, an alkoxyaralkylsulfonyl group which may be substituted, and an alkenylsulfonyl group which may be substituted.

Specific examples of the alkyl group, aryl group, aralkyl group, alkyl halide group, aryl halide group, aralkyl halide group, alkoxyalkyl group, alkoxyaryl group, alkoxyaralkyl group, and alkenyl group in these groups, substituents thereof, and the preferred number of carbon atoms thereof are the same as those described above regarding R¹.

The alkylene group is a divalent group derived by further removing one hydrogen atom from the alkyl group, and may be linear, branched, or cyclic. Specific examples of the alkylene group are the same as those described above. The number of carbon atoms of the alkylene group is not particularly limited, but is preferably 40 or less, more preferably 30 or less, still more preferably 20 or less, and yet still more preferably 10 or less.

In addition, the alkylene group of R⁴⁰⁵ may have one or more types of bonds selected from a sulfide bond, an ether bond, and an ester bond at terminal ends or in the middle, and preferably in the middle.

Specific examples of the alkylene group include, but are not limited to, linear alkylene groups such as a methylene group, an ethylene group, a trimethylene group, a tetramethylene group, a pentamethylene group, a hexamethylene group, a heptamethylene group, an octamethylene group, a nonamethylene group and a decamethylene group; branched alkylene groups such as a methylethylene group, a 1-methyltrimethylene group, a 2-methyltrimethylene group, a 1,1-dimethylethylene group, a 1-methyltetramethylene group, a 2-methyltetramethylene group, a 1,1-dimethyltrimethylene group, a 1,2-dimethyltrimethylene group, a 2,2-dimethyltrimethylene group and a 1-ethyltrimethylene group; cyclic alkylene groups such as a 1,2-cyclopropanediyl group, a 1,2-cyclobutanediyl group, a 1,3-cyclobutanediyl group, a 1,2-cyclohexanediyl group and a 1,3-cyclohexanediyl group; and alkylene groups containing an ether group or the like, such as -CH₂OCH₂-, -CH₂CH₂OCH₂-, -CH₂CH₂OCH₂CH₂-, - CH₂CH₂CH₂OCH₂CH₂-, -CH₂CH₂OCH₂CH₂CH₂-, -CH₂CH₂CH₂OCH₂CH₂CH₂-, - CH₂SCH₂-, -CH₂CH₂SCH₂-, -CH₂CH₂SCH₂CH₂-, -CH₂CH₂CH₂SCH₂CH₂-, - CH₂CH₂SCH₂CH₂CH₂-, -CH₂CH₂CH₂SCH₂CH₂CH₂-, and -CH₂OCH₂CH₂SCH₂-.

The hydroxyalkylene group is a group in which at least one hydrogen atom of the above-described alkylene group is replaced with a hydroxy group. Specific examples of the hydroxyalkylene group include, but are not limited to, a hydroxymethylene group, a 1-hydroxyethylene group, a 2-hydroxyethylene group, a 1,2-dihydroxyethylene group, a 1-hydroxytrimethylene group, a 2-hydroxytrimethylene group, a 3-hydroxytrimethylene group, a 1-hydroxytetramethylene group, a 2-hydroxytetramethylene group, a 3-hydroxytetramethylene group, a 4-hydroxytetramethylene group, a 1,2-dihydroxytetramethylene group, a 1,3-dihydroxytetramethylene group, a 1,4-dihydroxytetramethylene group, a 2,3-dihydroxytetramethylene group, a 2,4-dihydroxytetramethylene group, and a 4,4-dihydroxytetramethylene group.

In Formula (4-2), each X₄₀₂ independently represents any one of groups represented by the following Formulae (4-3) to (4-5), and a carbon atom of a ketone group in the following Formulae (4-4) and (4-5) is bonded to a nitrogen atom to which R⁴⁰⁵ in Formula (4-2) is bonded.

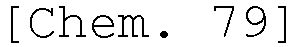

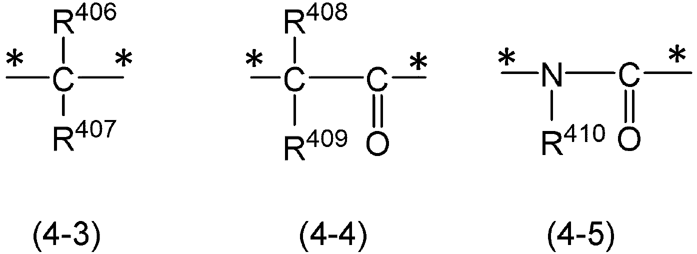

In Formulae (4-3) to (4-5), R⁴⁰⁶ to R⁴¹⁰ each independently represents a hydrogen atom, an optionally substituted alkyl group, an optionally substituted alkenyl group, or an organic group having an epoxy group or a sulfonyl group. Specific examples of the optionally substituted alkyl group, the optionally substituted alkenyl group, and the organic group having an epoxy group or a sulfonyl group, and the preferred number of carbon atoms thereof are the same as those described above regarding R¹. Specific examples of the organic group having a sulfonyl group and the preferred number of carbon atoms are the same as those described above regarding R⁴⁰⁴. An asterisk * represents a bonding site.

From the viewpoint of realizing excellent lithography characteristics with good reproducibility in the case of using the formed laminate in EUV lithography or electron beam lithography, X₄₀₁ is preferably a group represented by Formula (4-5) among the above Formulae.

From the viewpoint of realizing excellent lithography characteristics with good reproducibility in the case of using the formed laminate in EUV lithography or electron beam lithography, at least one of R⁴⁰⁴ and R⁴⁰⁶ to R⁴¹⁰ is preferably an alkyl group in which a terminal hydrogen atom is substituted with a vinyl group.

As the hydrolyzable organosilane represented by Formula (4-1), a commercially available product may be used. The hydrolyzable organosilane can also be synthesized by a known method described in WO 2011/102470 A or the like.

Hereinafter, specific examples of the hydrolyzable organosilane represented by Formula (4-1) include, but are not limited to, silanes represented by the following Formulae (4-1-1) to (4-1-29).

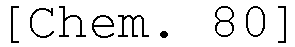

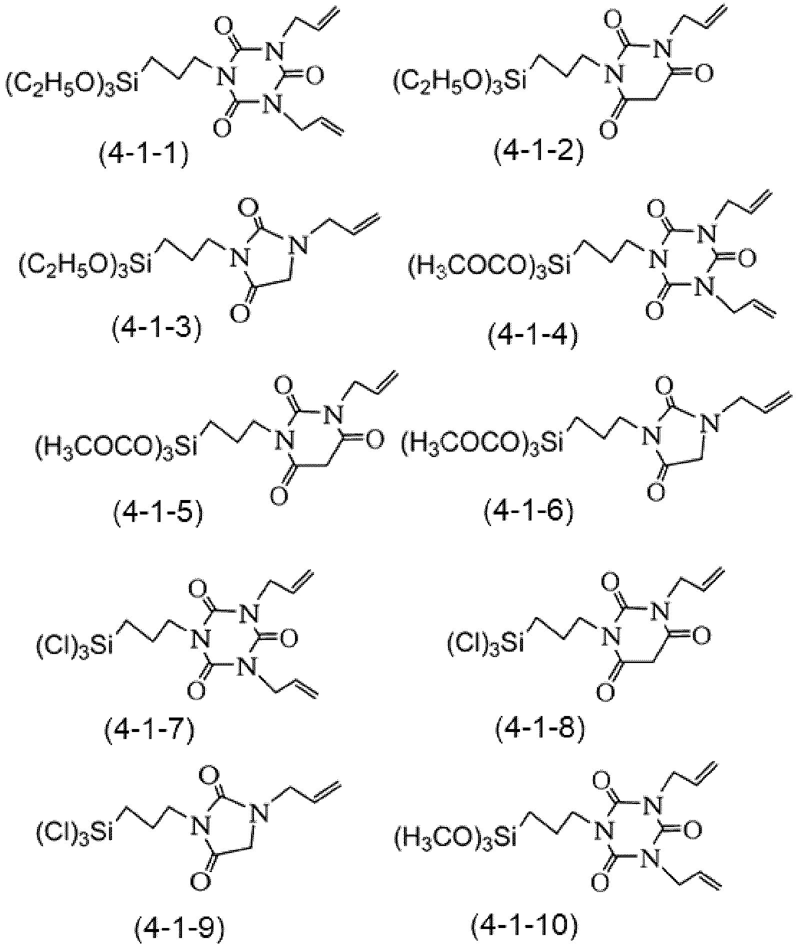

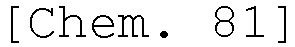

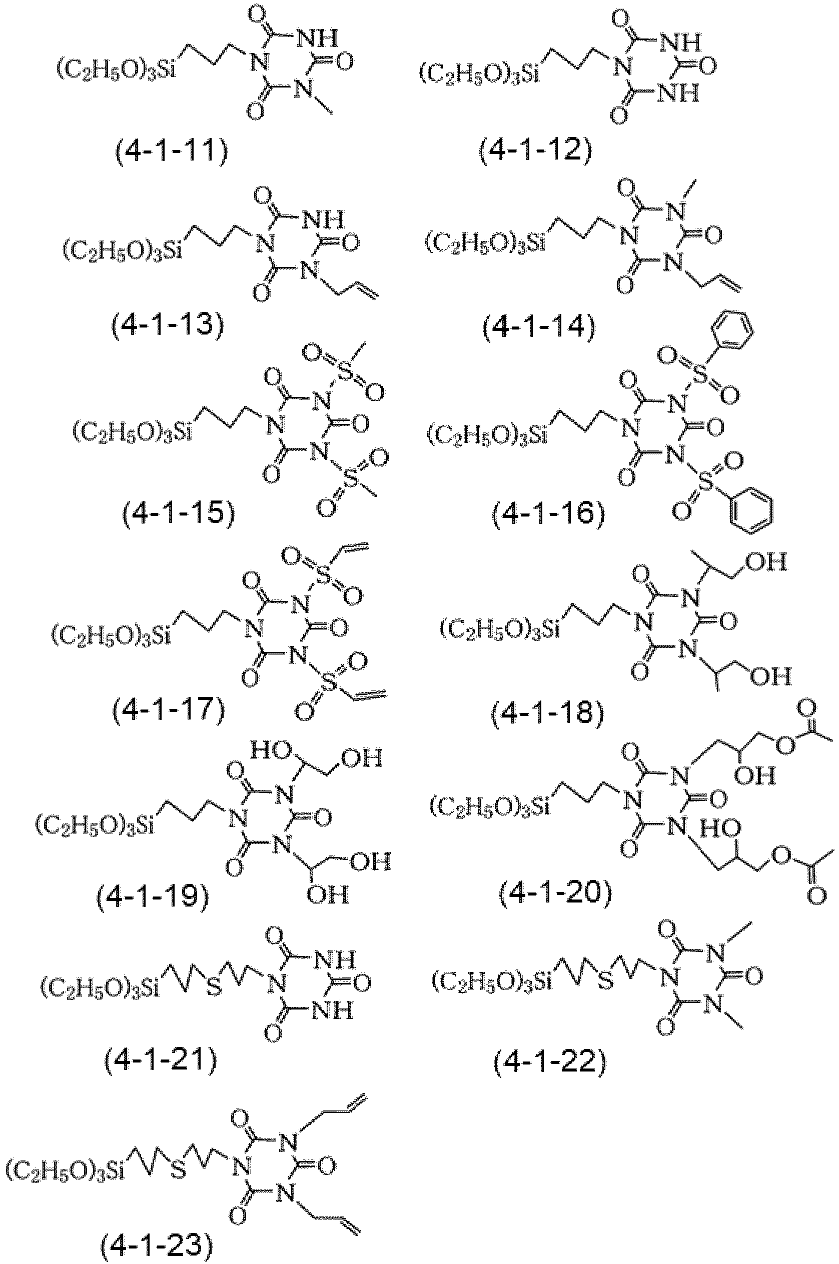

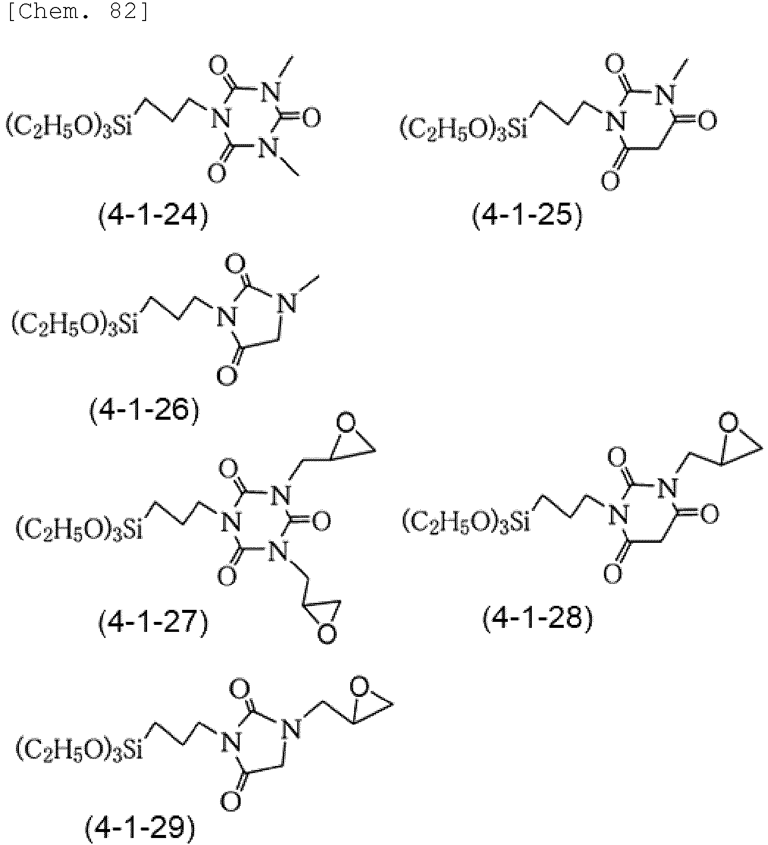

The polysiloxane may be a hydrolysis condensate of a hydrolyzable silane containing a silane compound other than those exemplified above as long as the effects of the present invention are not impaired.

As described above, as the polysiloxane, a modified polysiloxane in which at least some of silanol groups are modified can be used. For example, a polysiloxane modified product in which some of silanol groups are alcoholmodified or acetal-protected can be used.

Examples of the polysiloxane as the modified product include a product prepared by a reaction between at least some of silanol groups of the above-described hydrolysis condensate of hydrolyzable silane and a hydroxy group of an alcohol, a product prepared by dehydration reaction between the condensate and an alcohol, and a modified product prepared by protection of at least some of silanol groups of the condensate with an acetal group.

As the alcohol, a monohydric alcohol can be used. Examples of the monohydric alcohol include methanol, ethanol, 2-propanol, 1-butanol, 2-butanol, isobutyl alcohol, tert-butyl alcohol, 1-pentanol, 2-pentanol, 3-pentanol, 1-heptanol, 2-heptanol, tert-amyl alcohol, neopentyl alcohol, 2-methyl-1-propanol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-diethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, and cyclohexanol.

For example, alkoxy group-containing alcohols such as 3-methoxybutanol, ethylene glycol monomethyl ether, ethylene glycol monoethyl ether, diethylene glycol monomethyl ether, diethylene glycol monoethyl ether, propylene glycol monomethyl ether (1-methoxy-2-propanol), propylene glycol monoethyl ether (1-ethoxy-2-propanol), and propylene glycol monobutyl ether (1-butoxy-2-propanol) can be used.

The reaction between silanol groups of the condensate and hydroxy groups of the alcohol is performed by bringing the polysiloxane in to contact with the alcohol. A modified polysiloxane containing capped silanol groups is prepared by performing the reaction at a temperature of 40 to 160°C (e.g. 60°C) for 0.1 to 48 hours (e.g. 24 hours). In this case, the alcohol serving as a capping agent may be used as a solvent in the composition containing the polysiloxane.

A dehydration reaction product of a polysiloxane formed of a hydrolysis condensate of a hydrolyzable silane and an alcohol can be produced by allowing the polysiloxane to react with an alcohol in the presence of an acid as a catalyst, capping a silanol group with the alcohol, and removing water generated by dehydration to the outside of the reaction system.

The acid may be an organic acid having an acid dissociation constant (pKa) of -1 to 5, preferably 4 to 5. Examples of the acid include trifluoroacetic acid, maleic acid, benzoic acid, isobutyric acid, and acetic acid. In particular, benzoic acid, isobutyric acid, and acetic acid can be exemplified.

As the acid, an acid having a boiling point of 70 to 160°C may be used. Examples of the acid include trifluoroacetic acid, isobutyric acid, acetic acid, and nitric acid.

Preferably, the acid described above has either an acid dissociation constant (pKa) of 4 to 5 or a boiling point of 70 to 160°C. That is, the acid to be used may be an acid having a weak acidity, or an acid having a strong acidity and a low boiling point.

Either of these properties: acid dissociation constant and boiling point of the acid may be utilized.

The acetal protection of silanol groups of the condensate can be performed with a vinyl ether; for example, a vinyl ether represented by the following Formula (5). Such a reaction can be performed to introduce a partial structure represented by the following Formula (6) into the polysiloxane.

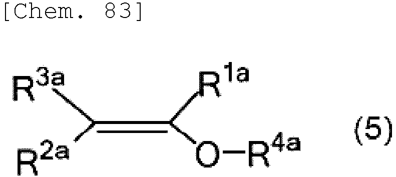

In Formula (5), R^{1a}, R^{2a}, and R^{3a} each represent a hydrogen atom or an alkyl group having 1 to 10 carbon atoms, R^{4a} represents an alkyl group having 1 to 10 carbon atoms, and R^{2a} and R^{4a} may be bonded together to form a ring. Examples of the alkyl group include the examples described above.

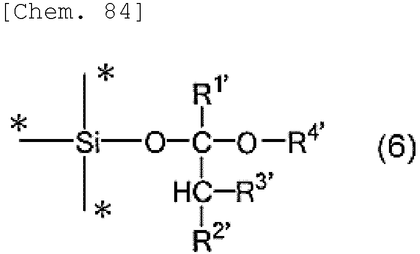

In Formula (6), R¹', R²', and R³' each represent a hydrogen atom or an alkyl group having 1 to 10 carbon atoms, R⁴' represents an alkyl group having 1 to 10 carbon atoms, and R²' and R⁴' may be bonded together to form a ring. In Formula (6), each asterisk * represents a bond to an adjacent atom. The adjacent atom is, for example, an oxygen atom of a siloxane bond, an oxygen atom of a silanol group, or a carbon atom derived from R¹ of Formula (1). Examples of the alkyl group include the examples described above.

As the vinyl ether represented by Formula (5), for example, aliphatic vinyl ether compounds, such as methyl vinyl ether, ethyl vinyl ether, isopropyl vinyl ether, normal butyl vinyl ether, 2-ethylhexyl vinyl ether, tert-butyl vinyl ether, and cyclohexyl vinyl ether; and cyclic vinyl ether compounds, such as 2,3-dihydrofuran, 4-methyl-2,3-dihydrofuran, and 3,4-dihydro-2H-pyran, may be used. In particular, ethyl vinyl ether, propyl vinyl ether, butyl vinyl ether, ethylhexyl vinyl ether, cyclohexyl vinyl ether, 3,4-dihydro-2H-pyran, or 2,3-dihydrofuran may be preferably used.

The acetal protection of silanol groups can be performed using a polysiloxane, a vinyl ether, and an aprotic solvent such as propylene glycol monomethyl ether acetate, ethyl acetate, dimethylformamide, tetrahydrofuran, or 1,4-dioxane as a solvent, and a catalyst such as pyridinium p-toluenesulfonate, trifluoromethanesulfonic acid, p-toluenesulfonic acid, methanesulfonic acid, hydrochloric acid, or sulfuric acid.

The capping of silanol groups with an alcohol or the acetal protection of silanol groups may be performed simultaneously with the hydrolysis and condensation of the hydrolyzable silane described below.

In a preferred aspect of the present invention, the polysiloxane includes at least one of a hydrolysis condensate of a hydrolyzable silane and a modified product thereof, the hydrolyzable silane including a hydrolyzable silane represented by Formula (1) and, if desired, a hydrolyzable silane represented by Formula (2) and other hydrolyzable silanes.

In a preferred aspect, the polysiloxane includes a dehydration reaction product of a hydrolysis condensate and an alcohol.

The polysiloxane: the hydrolysis condensate of the hydrolyzable silane (which may also include a modified product) may have a weight-average molecular weight of, for example, 500 to 1,000,000. From the viewpoint of preventing the precipitation of the hydrolysis condensate in the composition, the weight-average molecular weight is preferably 500,000 or less, more preferably 250,000 or less, and still more preferably 100,000 or less. From the viewpoint of the compatibility between storage stability and application property, the weight-average molecular weight may be preferably 500 or more, more preferably 600 or more.

The weight-average molecular weight is determined by GPC analysis in terms of polystyrene. The GPC analysis can be performed under the following conditions: GPC apparatus (trade name: HLC-8220GPC, manufactured by Tosoh Corporation), GPC columns (trade name: Shodex (registered trademark) KF803L, KF802, and KF801, manufactured by Showa Denko K.K.), column temperature of 40°C, tetrahydrofuran as an eluent (elution solvent), flow amount (flow rate) of 1.0 mL/min, and polystyrene (Shodex (registered trademark) manufactured by Showa Denko K.K.) as a standard sample.

The hydrolysis condensate of hydrolyzable silane is prepared by hydrolysis and condensation of the above-described silane compound (hydrolyzable silane).

The above-described silane compound (hydrolyzable silane) contains an alkoxy group, aralkyloxy group, acyloxy group, or halogen atom directly bonded to a silicon atom; i.e. an alkoxysilyl group, an aralkyloxysilyl group, an acyloxysilyl group, or a halogenated silyl group (hereinafter, such a group is referred to as "hydrolyzable group").

For the hydrolysis of the hydrolyzable group, ordinarily 0.1 to 100 mol, for example, 0.5 to 100 mol, preferably 1 to 10 mol, of water is used per mol of the hydrolyzable group.

During hydrolysis and condensation, a hydrolysis catalyst may be used for the purpose of promoting the reaction. Alternatively, the hydrolysis and condensation may be performed without use of a hydrolysis catalyst. When a hydrolysis catalyst is used, the amount of the hydrolysis catalyst is ordinarily 0.0001 to 10 mol, preferably 0.001 to 1 mol per mol of the hydrolyzable group.

The reaction temperature for the hydrolysis and condensation is ordinarily equal to or higher than room temperature, or equal to or lower than the reflux temperature at normal pressure of an organic solvent usable for hydrolysis. The reaction temperature may be, for example, 20 to 110°C, or, for example, 20 to 80°C.

The hydrolysis may be performed completely; i.e. all hydrolyzable groups may be converted into silanol groups, or may be performed partially; i.e. unreacted hydrolyzable groups may remain.

Examples of the hydrolysis catalyst usable for the hydrolysis and condensation include a metal chelate compound, an organic acid, an inorganic acid, an organic base, and an inorganic base.

Examples of the metal chelate compound as the hydrolysis catalyst include, but are not limited to, titanium chelate compounds such as triethoxy-mono(acetylacetonate)titanium, tri-n-propoxy-mono(acetylacetonate)titanium, tri-i-propoxy-mono(acetylacetonate)titanium, tri-n-butoxy-mono(acetylacetonate)titanium, tri-sec-butoxy-mono(acetylacetonate)titanium, tri-t-butoxy-mono(acetylacetonate)titanium, diethoxy-bis(acetylacetonate)titanium, di-n-propoxy-bis(acetylacetonate)titanium, di-i-propoxy-bis(acetylacetonate)titanium, di-n-butoxy-bis(acetylacetonate)titanium, di-sec-butoxy-bis(acetylacetonate)titanium, di-t-butoxy-bis(acetylacetonate)titanium, monoethoxy-tris(acetylacetonate)titanium, mono-n-propoxy-tris(acetylacetonate)titanium, mono-i-propoxy-tris(acetylacetonate)titanium, mono-n-butoxy-tris(acetylacetonate)titanium, mono-sec-butoxy-tris(acetylacetonate)titanium, mono-t-butoxy-tris(acetylacetonate)titanium, tetrakis(acetylacetonate)titanium, triethoxy-mono(ethyl acetoacetate)titanium, tri-n-propoxy-mono(ethyl acetoacetate)titanium, tri-i-propoxy-mono(ethyl acetoacetate)titanium, tri-n-butoxy-mono(ethyl acetoacetate)titanium, tri-sec-butoxy-mono(ethyl acetoacetate)titanium, tri-t-butoxy-mono(ethyl acetoacetate)titanium, diethoxy-bis(ethyl acetoacetate)titanium, di-n-propoxy-bis(ethyl acetoacetate)titanium, di-i-propoxy-bis(ethyl acetoacetate)titanium, di-n-butoxy-bis(ethyl acetoacetate)titanium, di-sec-butoxy-bis(ethyl acetoacetate)titanium, di-t-butoxy-bis(ethyl acetoacetate)titanium, monoethoxy-tris(ethyl acetoacetate)titanium, mono-n-propoxy-tris(ethyl acetoacetate)titanium, mono-i-propoxy-tris(ethyl acetoacetate)titanium, mono-n-butoxy-tris(ethyl acetoacetate)titanium, mono-sec-butoxy-tris(ethyl acetoacetate)titanium, mono-t-butoxy-tris(ethyl acetoacetate)titanium, tetrakis(ethyl acetoacetate)titanium, mono(acetylacetonate)tris(ethyl acetoacetate)titanium, bis(acetylacetonate)bis(ethyl acetoacetate)titanium, and tris(acetylacetonate)mono(ethyl acetoacetate)titanium; zirconium chelate compounds such as triethoxy-mono(acetylacetonate) zirconium, tri-n-propoxy-mono(acetylacetonate) zirconium, tri-i-propoxy-mono(acetylacetonate) zirconium, tri-n-butoxy-mono(acetylacetonate) zirconium, tri-sec-butoxy-mono(acetylacetonate) zirconium, tri-t-butoxy-mono(acetylacetonate) zirconium, diethoxy-bis(acetylacetonate) zirconium, di-n-propoxy-bis(acetylacetonate) zirconium, di-i-propoxy-bis(acetylacetonate) zirconium, di-n-butoxy-bis(acetylacetonate) zirconium, di-sec-butoxy-bis(acetylacetonate) zirconium, di-t-butoxy-bis(acetylacetonate) zirconium, monoethoxy-tris(acetylacetonate) zirconium, mono-n-propoxy-tris(acetylacetonate) zirconium, mono-i-propoxy-tris(acetylacetonate) zirconium, mono-n-butoxy-tris(acetylacetonate) zirconium, mono-sec-butoxy-tris(acetylacetonate) zirconium, mono-t-butoxy-tris(acetylacetonate) zirconium, tetrakis(acetylacetonate) zirconium, triethoxy-mono(ethyl acetoacetate) zirconium, tri-n-propoxy-mono(ethyl acetoacetate) zirconium, tri-i-propoxy-mono(ethyl acetoacetate) zirconium, tri-n-butoxy-mono(ethyl acetoacetate) zirconium, tri-sec-butoxy-mono(ethyl acetoacetate) zirconium, tri-t-butoxy-mono(ethyl acetoacetate) zirconium, diethoxy-bis(ethyl acetoacetate) zirconium, di-n-propoxy-bis(ethyl acetoacetate) zirconium, di-i-propoxy-bis(ethyl acetoacetate) zirconium, di-n-butoxy-bis(ethyl acetoacetate) zirconium, di-sec-butoxy-bis(ethyl acetoacetate) zirconium, di-t-butoxy-bis(ethyl acetoacetate) zirconium, monoethoxy-tris(ethyl acetoacetate) zirconium, mono-n-propoxy-tris(ethyl acetoacetate) zirconium, mono-i-propoxy-tris(ethyl acetoacetate) zirconium, mono-n-butoxy-tris(ethyl acetoacetate) zirconium, mono-sec-butoxy-tris(ethyl acetoacetate) zirconium, mono-t-butoxy-tris(ethyl acetoacetate) zirconium, tetrakis(ethyl acetoacetate) zirconium, mono(acetylacetonate)tris(ethyl acetoacetate) zirconium, bis(acetylacetonate)bis(ethyl acetoacetate) zirconium, and tris(acetylacetonate)mono(ethyl acetoacetate) zirconium; and aluminum chelate compounds such as tris(acetylacetonate)aluminum and tris(ethyl acetoacetate)aluminum.

Examples of the organic acid as the hydrolysis catalyst include, but are not limited to, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartaric acid.

Examples of the inorganic acid as the hydrolysis catalyst include, but are not limited to, hydrochloric acid, nitric acid, sulfuric acid, hydrofluoric acid, and phosphoric acid.

Examples of the organic base as the hydrolysis catalyst include, but are not limited to, pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, trimethylphenylammonium hydroxide, benzyltrimethylammonium hydroxide, and benzyltriethylammonium hydroxide.

Examples of the inorganic base as the hydrolysis catalyst include, but are not limited to, ammonia, sodium hydroxide, potassium hydroxide, barium hydroxide, and calcium hydroxide.

Among these catalysts, a metal chelate compound, an organic acid, and an inorganic acid are preferred. These catalysts may be used singly or in combination of two or more kinds thereof.

In particular, nitric acid can be preferably used as a hydrolysis catalyst in the present invention. The use of nitric acid enables an improvement in the storage stability of a reaction solution after the hydrolysis and condensation, and particularly enables suppression of a change in the molecular weight of a hydrolysis condensate. It is known that the stability of the hydrolysis condensate contained in the reaction solution depends on the pH of the solution. As a result of intensive studies, it has been found that the pH of the reaction solution falls in a stable range by use of an appropriate amount of nitric acid.

As described above, nitric acid can also be used for preparation of a modified product of the hydrolysis condensate; for example, for capping of silanol groups with an alcohol. Thus, nitric acid is preferred from the viewpoint that it can contribute to the reactions of hydrolysis and condensation of the hydrolyzable silane, as well as the reaction of capping of the hydrolysis condensate with an alcohol.

When hydrolysis and condensation are performed, an organic solvent may be used as a solvent, and specific examples thereof include aliphatic hydrocarbon-based solvents such as n-pentane, i-pentane, n-hexane, i-hexane, n-heptane, i-heptane, 2,2,4-trimethylpentane, n-octane, i-octane, cyclohexane, and methylcyclohexane; aromatic hydrocarbon-based solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, and n-amylnaphthalene; monoalcohol-based solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol-based solvents such as ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin; ketone-based solvents such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclohexanone, methylcyclohexanone, 2,4-pentanedione, acetonylacetone, diacetone alcohol, acetophenone, and fenchon; ether-based solvents such as ethyl ether, i-propyl ether, n-butyl ether, n-hexyl ether, 2-ethylhexyl ether, ethylene oxide, 1,2-propylene oxide, dioxolane, 4-methyldioxolane, dioxane, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol din-butyl ether, diethylene glycol mono-n-hexyl ether, ethoxy triglycol, tetraethylene glycol di-n-butyl ether, propylene glycol monomethyl ether (1-methoxy-2-propanol), propylene glycol monoethyl ether (1-ethoxy-2-propanol), propylene glycol monopropyl ether, propylene glycol monobutyl ether, propylene glycol monomethyl ether acetate (1-methoxy-2-propanol monoacetate), dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester-based solvents such as diethyl carbonate, methyl acetate, ethyl acetate, γ-butyrolactone, γ-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethylene glycol diacetate, triethylene glycol methyl ether acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-diethylformamide, acetamide, N-methylacetamide, N,N-dimethylacetamide, N-methylpropionamide, and N-methyl-2-pyrrolidone; and sulfur-containing solvents such as dimethyl sulfide, diethyl sulfide, thiophene, tetrahydrothiophene, dimethyl sulfoxide, sulfolane, and 1,3-propane sultone, but are not limited thereto. These solvents can be used singly or in combination of two or more kinds thereof.

After completion of the hydrolysis and condensation reactions, the reaction solution is used as is, or diluted or concentrated. The resultant reaction solution can be neutralized and treated with an ion exchange resin, and thus the hydrolysis catalyst, e.g. an acid or a base, used for the hydrolysis and condensation can be removed. Before or after such a treatment, alcohols: by-products, water, the used hydrolysis catalyst, and the like can be removed from the reaction solution, for example, by distillation under reduced pressure.

The thus-prepared hydrolysis condensate is in the form of a polysiloxane varnish dissolved in an organic solvent, and may be used as is for preparation of a surface modifier. That is, the reaction solution can be used as is (or diluted) for preparation of the surface modifier. In this case, the hydrolysis catalyst used for hydrolysis and condensation, by-products, and the like may remain in the reaction solution as long as the effect of the present invention is not impaired. For example, nitric acid used as a hydrolysis catalyst or used for capping of silanol groups with an alcohol may remain in the polymer varnish solution in an amount of about 100 ppm to 5,000 ppm.

The resultant polysiloxane varnish may be subjected to solvent replacement, or may be appropriately diluted with a solvent. In a case where the storage stability of the resultant polysiloxane varnish is not poor, the organic solvent may be distilled off to achieve a film-forming component concentration of 100%. The film-forming component refers to a component resulted from the removal of a solvent component from all the components of the composition.

The organic solvent used for solvent replacement, dilution, or the like of the polysiloxane varnish may be identical to or different from the organic solvent used for the hydrolysis and condensation reactions of the hydrolyzable silane. The solvent for dilution is not particularly limited, and one kind or two or more kinds of solvents may be arbitrarily selected and used.

### <<Substrate>>

The substrate in the laminate of the present invention is not particularly limited as long as it is, for example, a substrate used for producing a precision integrated circuit element.

Examples of the substrate include a substrate made of a material containing an inorganic material or an organic material.

The substrate may have a film made of a material containing an inorganic material or an organic material.

Examples of the inorganic material for forming a substrate and a film include arsenic, a metal, a metal oxide, a metal nitride, a metal carbide, a metal oxynitride, a metal oxycarbide, and a metal carbonitride. These materials can be used singly or in combination of two or more kinds thereof.

Examples of the metal include silicon, germanium, titanium, tungsten, hafnium, zirconium, chromium, copper, aluminum, indium, gallium, palladium, iron, tantalum, iridium, molybdenum, and alloys of these metals.

Examples of the metal oxide include SiO₂ and TiO₂.

Examples of the metal nitride include SiN, TiN, and TaN.

Examples of the metal carbide include SiC and TiC.

Examples of the metal oxynitride include SiON and TiON.

Examples of the metal oxycarbide include SiOC and TiOC.

Examples of the metal carbonitride include SiCN and TiCN.

Examples of the organic material for forming a substrate and a film include amorphous carbon, graphite, fullerene, carbon nanotube, diamond, diamond-like carbon, and polyimide. These materials can be used singly or in combination of two or more kinds thereof. The organic materials described above may be organic films doped or partially substituted with boron, oxygen, nitrogen, phosphorus, silicon, sulfur, or halogen.

Examples of the substrate described above include a semiconductor substrate such as a silicon wafer coated with a silicon oxide film, a silicon nitride film, or a silicon oxynitride film, a silicon nitride substrate, a quartz substrate, a glass substrate (alkali-free glass, low alkali glass, and crystallized glass are included.), a glass substrate on which an indium tin oxide (ITO) film or an indium zinc oxide (IZO) film is formed, a plastic (such as polyimide or PET) substrate, a low-dielectric constant material (low-k material) coated substrate, and a flexible substrate.

As the substrate, a substrate having a water contact angle of 50 degrees or less may be used, and a substrate having a water contact angle of 40 degrees or less is also preferably used.

### (Method for Producing Laminate)

The method for producing a laminate of the present invention includes a film formation step and an exposure step. The method for producing a laminate of the present invention may further include a thinning step, or may include steps other than the above steps.

The film formation step is a step of applying a photosensitive surface modifier containing a photosensitive polymer and a solvent to a substrate, and then baking the surface modifier to cross-link the polymer and to form a surface modification precursor film.

The exposure step is a step of irradiating the surface modification precursor film with light or an electron beam to form a surface-modified film having an exposed region and an unexposed region.

The laminate formed by the production method of the present invention may have a semiconductor substrate and a surface-modified film having a film thickness of 5 nm or less. The surface-modified film contains a cross-linked photosensitive polymer.

The laminate formed by the production method of the present invention may further have other layers or films. Examples of the other layers include a silicon-containing resist underlayer film and a carbon-containing resist underlayer film. The silicon-containing resist underlayer film or the carbon-containing resist underlayer film is not particularly limited as long as it is a silicon-containing resist underlayer film or a carbon-containing resist underlayer film used in a lithography process.

### <<Photosensitive Surface Modifier>>

The photosensitive surface modifier contains a photosensitive polymer and a solvent.

As the photosensitive polymer, those described above in <<Surface-Modified Film>> may be used.

### <<<Solvent>>>

As the solvent contained in the photosensitive surface modifier, any solvent can be used without particular limitation as long as it is a solvent capable of dissolving and mixing the photosensitive polymer (e.g. polysiloxane), and, if necessary, other components contained in the photosensitive surface modifier.

The solvent is, for example, an organic solvent or water.

Examples of the solvent include alcohols, alkylene glycol alkyl ethers, alkylene glycol monoalkyl ether carboxylic acid esters, and water.

Examples of the alcohols include a monoalcohol-based solvent and a polyhydric alcohol-based solvent. Specific examples of the monoalcohol-based solvent and the polyhydric alcohol-based solvent include the monoalcohol-based solvents and polyhydric alcohol-based solvents described above as the solvents used for hydrolysis and condensation.

Examples of the alkylene glycol alkyl ethers include alkylene glycol monoalkyl ethers and alkylene glycol dialkyl ethers.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Examples of the alkylene glycol dialkyl ether include diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, and propylene glycol dibutyl ether.

Examples of the alkylene glycol monoalkyl ether carboxylic acid esters include alkylene glycol monoalkyl ether acetate.

Examples of the alkylene glycol monoalkyl ether acetate include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, ethylene glycol monomethyl ether acetate, ethylene glycol monoethyl ether acetate, ethylene glycol monopropyl ether acetate, and ethylene glycol monobutyl ether acetate.

Specific examples of other solvents include toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, methyl propyl ketone, methyl butyl ketone, 2-heptanone, 3-heptanone, 4-heptanone, N,N-dimethylformamide, N-methylacetamide, N,N-dimethylacetamide, N-methyl-2-pyrrolidone, 4-methyl-2-pentanol, and γ-butyrolactone.

These solvents can be used singly or in combination of two or more kinds thereof.

The photosensitive surface modifier may contain water as a solvent. When water is contained as the solvent, the content thereof may be, for example, 30 mass% or less, preferably 20 mass% or less, and still more preferably 15 mass% or less relative to the total mass of the solvent contained in the surface modifier.

### <<<Curing Catalyst>>>

The photosensitive surface modifier may be a composition containing no curing catalyst. Alternatively, the surface modifier preferably contains a curing catalyst.

The curing catalyst may be, for example, an ammonium salt, a phosphine compound, a phosphonium salt, a sulfonium salt, an iodonium salt, an oxonium salt. The following salts described as an example of the curing catalyst may be added in the form of a salt or may form a salt in the composition (one that is added as a separate compound at the time of addition and forms a salt in the system).

Examples of the ammonium salt include a quaternary ammonium salt having a structure represented by Formula (D-1) : 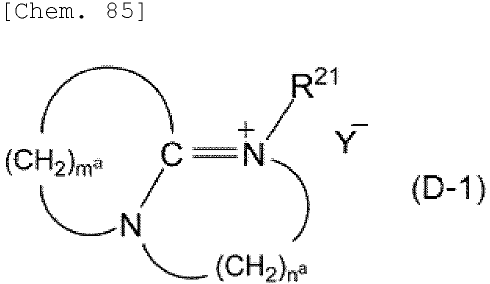
where m^{a} represents an integer of 2 to 11, n^{a} represents an integer of 2 to 3, R²¹ represents an alkyl group, an aryl group, or an aralkyl group, and Y⁻represents an anion;
a quaternary ammonium salt having a structure represented by Formula (D-2):
   [Chem. 86]

   R²²R²³R²⁴R²⁵N⁺Y⁻ (D-2)
where R²², R²³, R²⁴, and R²⁵ each independently represent an alkyl group, an aryl group, or an aralkyl group, Y⁻represents an anion, and R²², R²³, R²⁴, and R²⁵ are each bonded to the nitrogen atom;
a quaternary ammonium salt having a structure represented by Formula (D-3): 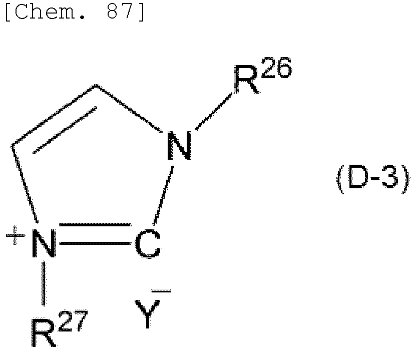
where R²⁶ and R²⁷ each independently represent an alkyl group, an aryl group, or an aralkyl group, and Y-represents an anion;
a quaternary ammonium salt having a structure represented by Formula (D-4): 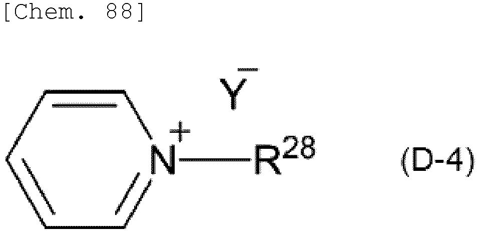
wherein R²⁸ represents an alkyl group, an aryl group, or an aralkyl group, and Y⁻ represents an anion;
a quaternary ammonium salt having a structure represented by Formula (D-5): 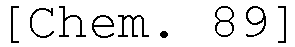 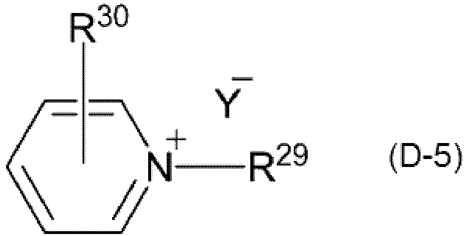
where R²⁹ and R³⁰ each independently represent an alkyl group, an aryl group, or an aralkyl group, and Y⁻represents an anion; and
a tertiary ammonium salt having a structure represented by Formula (D-6): 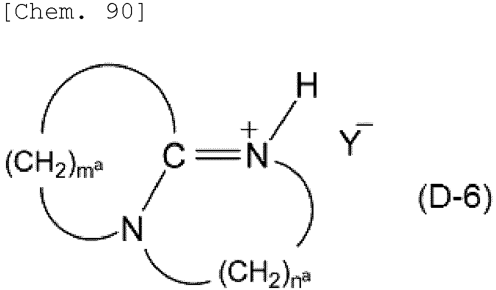
where m^{a} represents an integer of 2 to 11, n^{a} represents an integer of 2 to 3, and Y⁻ represents an anion.

Examples of the phosphonium salt include a quaternary phosphonium salt represented by Formula (D-7):
[Chem. 91]

R³¹R³²R³³R³⁴P⁺Y⁻ (D-7)

where R³¹, R³², R³³, and R³⁴ each independently represent an alkyl group, an aryl group, or an aralkyl group, Y⁻represents an anion, and R³¹, R³², R³³, and R³⁴ are each bonded to the phosphorus atom.

Examples of the sulfonium salt include a tertiary sulfonium salt represented by Formula (D-8):
[Chem. 92]

R³⁵R³⁶R³⁷S⁺Y⁻ (D-8)

where R³⁵, R³⁶, and R³⁷ each independently represent an alkyl group, an aryl group, or an aralkyl group, Y⁻represents an anion, and R³⁵, R³⁶, and R³⁷ are each bonded to the sulfur atom.

The compound of Formula (D-1) is a quaternary ammonium salt derived from an amine, where m^{a} represents an integer of 2 to 11, and n^{a} represents an integer of 2 to 3. R²¹ of the quaternary ammonium salt represents, for example, an alkyl group having 1 to 18 carbon atoms, preferably 2 to 10 carbon atoms, an aryl group having 6 to 18 carbon atoms, or an aralkyl group having 7 to 18 carbon atoms. Examples thereof include linear alkyl groups such as an ethyl group, a propyl group, and a butyl group; a benzyl group, a cyclohexyl group, a cyclohexylmethyl group, and a dicyclopentadienyl group. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻).

The compound of Formula (D-2) is a quaternary ammonium salt represented by R²²R²³R²⁴R²⁵N⁺Y⁻. R²², R²³, R²⁴, and R²⁵ of this quaternary ammonium salt are each, for example, an alkyl group having 1 to 18 carbon atoms such as an ethyl group, a propyl group, a butyl group, a cyclohexyl group, and a cyclohexylmethyl group, an aryl group having 6 to 18 carbon atoms such as a phenyl group, or an aralkyl group having 7 to 18 carbon atoms such as a benzyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The quaternary ammonium salt is commercially available, and examples of the quaternary ammonium salt include tetramethylammonium acetate, tetrabutylammonium acetate, triethylbenzylammonium chloride, triethylbenzylammonium bromide, trioctylmethylammonium chloride, tributylbenzylammonium chloride, and trimethylbenzylammonium chloride.

The compound of Formula (D-3) is a quaternary ammonium salt derived from 1-substituted imidazole. The number of carbon atoms of each of R²⁶ and R²⁷ is, for example, 1 to 18, and the total number of carbon atoms of R²⁶ and R²⁷ is preferably 7 or more. Examples of R²⁶ include alkyl groups, such as a methyl group, an ethyl group, and a propyl group, and aryl groups, such as a phenyl group. Examples of R²⁷ include aralkyl groups, such as a benzyl group, and alkyl groups, such as an octyl group and an octadecyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between an imidazole compound (e.g. 1-methylimidazole or 1-benzylimidazole) and an aralkyl halide, an alkyl halide, or an aryl halide, such as benzyl bromide, methyl bromide, or benzene bromide.

The compound of Formula (D-4) is a quaternary ammonium salt derived from pyridine. R²⁸ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include a butyl group, an octyl group, a benzyl group, and a lauryl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between pyridine and an alkyl halide or an aryl halide, such as lauryl chloride, benzyl chloride, benzyl bromide, methyl bromide, or octyl bromide. Examples of this compound include N-laurylpyridinium chloride and N-benzylpyridinium bromide.

The compound of Formula (D-5) is a quaternary ammonium salt derived from a substituted pyridine, such as picoline. R²⁹ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include a methyl group, an octyl group, a lauryl group, and a benzyl group. R³⁰ is, for example, an alkyl group having 1 to 18 carbon atoms, an aryl group having 6 to 18 carbon atoms, or an aralkyl group having 7 to 18 carbon atoms. For example, R³⁰ is a methyl group when the compound represented by Formula (D-5) is a quaternary ammonium derived from picoline. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between a substituted pyridine (e.g. picoline) and an alkyl halide or an aryl halide, such as methyl bromide, octyl bromide, lauryl chloride, benzyl chloride, or benzyl bromide. Examples of this compound include N-benzylpicolinium chloride, N-benzylpicolinium bromide, and N-laurylpicolinium chloride.

The compound of Formula (D-6) is a tertiary ammonium salt derived from an amine, where m^{a} represents an integer of 2 to 11, and n^{a} represents 2 or 3. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The compound may be produced through reaction between an amine and a weak acid, such as a carboxylic acid or phenol. Examples of the carboxylic acid include formic acid and acetic acid. When formic acid is used, the anion (Y⁻) is (HCOO⁻). When acetic acid is used, the anion (Y⁻) is (CH₃COO⁻). When phenol is used, the anion (Y⁻) is (C₆H₅O⁻).

The compound of the Formula (D-7) is a quaternary phosphonium salt having a structure of R³¹R³²R³³R³⁴P⁺Y⁻. R³¹, R³², R³³, and R³⁴ are each, for example, an alkyl group having 1 to 18 carbon atoms, such as an ethyl group, a propyl group, a butyl group, or cyclohexylmethyl, an aryl group having 6 to 18 carbon atoms, such as a phenyl group, or an aralkyl group having 7 to 18 carbon atoms, such as a benzyl group. Three of four substituents of R³¹ to R³⁴ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). This compound is commercially available, and examples of the compound include tetraalkylphosphonium halides, such as tetra-n-butylphosphonium halide and tetra-n-propylphosphonium halide; trialkylbenzylphosphonium halides, such as triethylbenzylphosphonium halide; triphenylmonoalkylphosphonium halides, such as triphenylmethylphosphonium halide and triphenylethylphosphonium halide; triphenylbenzylphosphonium halide; tetraphenylphosphonium halide; tritolylmonoarylphosphonium halide; or tritolylmonoalkylphosphonium halide, where the halogen atom is a chlorine atom or a bromine atom. Particularly preferred are triphenylmonoalkylphosphonium halides, such as triphenylmethylphosphonium halide and triphenylethylphosphonium halide; triphenylmonoarylphosphonium halides, such as triphenylbenzylphosphonium halide; tritolylmonoarylphosphonium halides, such as tritolylmonophenylphosphonium halide; and tritolylmonoalkylphosphonium halides, such as tritolylmonomethylphosphonium halide, where the halogen atom is a chlorine atom or a bromine atom.

Examples of the phosphine compound include primary phosphines, such as methylphosphine, ethylphosphine, propylphosphine, isopropylphosphine, isobutylphosphine, and phenylphosphine; secondary phosphines, such as dimethylphosphine, diethylphosphine, diisopropylphosphine, diisoamylphosphine, and diphenylphosphine; and tertiary phosphines, such as trimethylphosphine, triethylphosphine, triphenylphosphine, methyldiphenylphosphine, and dimethylphenylphosphine.

The compound of Formula (D-8) is a tertiary sulfonium salt having a structure of R³⁵R³⁶R³⁷S⁺Y⁻. R³⁵, R³⁶, and R³⁷ are each, for example, an alkyl group having 1 to 18 carbon atoms, such as an ethyl group, a propyl group, a butyl group, or a cyclohexylmethyl, an aryl group having 6 to 18 carbon atoms, such as a phenyl group, or an aralkyl group having 7 to 18 carbon atoms, such as a benzyl group. Two of three substituents of R³⁵ to R³⁷ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), alcoholate (-O⁻), maleate anion, and nitrate anion. This compound is commercially available, and examples of the compound include trialkylsulfonium halides, such as tri-n-butylsulfonium halide and tri-n-propylsulfonium halide; dialkylbenzylsulfonium halides, such as diethylbenzylsulfonium halide; diphenylmonoalkylsulfonium halides, such as diphenylmethylsulfonium halide and diphenylethylsulfonium halide; triphenylsulfonium halides, where the halogen atom is a chlorine atom or a bromine atom; trialkylsulfonium carboxylates, such as tri-n-butylsulfonium carboxylate and tri-n-propylsulfonium carboxylate; dialkylbenzylsulfonium carboxylates, such as diethylbenzylsulfonium carboxylate; diphenylmonoalkylsulfonium carboxylates, such as diphenylmethylsulfonium carboxylate and diphenylethylsulfonium carboxylate; and triphenylsulfonium carboxylate. Further, triphenylsulfonium halide and triphenylsulfonium carboxylate are preferably used.

In addition, a nitrogen-containing silane compound may be added as a curing catalyst. Examples of the nitrogen-containing silane compound include silane compounds containing an imidazole ring, such as N-(3-triethoxysilylpropyl)-4,5-dihydroimidazole.

The content of the curing catalyst in the photosensitive surface modifier is preferably 0.01 to 30 parts by mass, more preferably 0.01 to 25 parts by mass, and still more preferably 0.01 to 20 parts by mass, relative to 100 parts by mass of the polymer.

### <<<Acid>>>

The photosensitive surface modifier preferably contains an acid.

The acid may be added during preparation of the photosensitive surface modifier. When the photosensitive surface modifier contains a polysiloxane, acid may be used as a hydrolysis catalyst or used for capping of silanol groups with an alcohol in the production of the polysiloxane described above, and may remain in the resultant polysiloxane varnish.

Examples of the acid include an organic acid and an inorganic acid.

Examples of the organic acid include acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartar.

Examples of the inorganic acid include hydrochloric acid, nitric acid, sulfuric acid, hydrofluoric acid, and phosphoric acid.

The amount of the acid (amount of residual acid) added may be, for example, 0.0001 mass% to 1 mass%, 0.001 mass% to 0.1 mass%, or 0.005 mass% to 0.05 mass% relative to the total mass of the surface modifier.

### <<<Amine and Hydroxide>>>

The photosensitive surface modifier may contain at least one selected from an amine and a hydroxide.

Examples of the amine include ammonia; primary amines such as monomethanolamine, monoethanolamine, monopropanolamine, methylamine, ethylamine, propylamine, and butylamine; secondary amines such as dimethylamine, ethylmethylamine, and diethylamine; tertiary amines such as trimethylamine, triethylamine, tripropylamine, dimethylethylamine, methyldiisopropylamine, diisopropylethylamine, diethylethanolamine, and triethanolamine; amines such as ethylenediamine and tetramethylethylenediamine; and cyclic amines such as pyridine and morpholine.

Examples of the hydroxide include an inorganic alkali hydroxide and an organic alkali hydroxide.

Examples of the inorganic alkali hydroxide include sodium hydroxide and potassium hydroxide.

Examples of the organic alkali hydroxide include tetraalkylammonium hydroxide, triarylsulfonium hydroxide, and diaryliodonium hydroxide. Examples of the tetraalkylammonium hydroxide include tetramethylammonium hydroxide, tetraethylammonium hydroxide, and tetrabutylammonium hydroxide. Examples of the triarylsulfonium hydroxide include triphenylsulfonium hydroxide and tris(t-butylphenyl)sulfonium hydroxide. Examples of the diaryliodonium hydroxide include diphenyliodonium hydroxide and bis(t-butylphenyl)iodonium hydroxide.

The contents of the amine and the hydroxide in the photosensitive surface modifier are not particularly limited, but can be preferably 0.05 to 20 parts by mass, more preferably 0.1 to 15 parts by mass, and still more preferably 0.5 to 10 parts by mass relative to 100 parts by mass of the polysiloxane.

### <<<Other Additives>>>

Various additives can be added to the photosensitive surface modifier depending on the intended use of the composition.

Examples of the additives include known additives incorporated in materials (compositions) for forming various films (e.g. resist underlayer film, anti-reflective coating, and pattern reversing film) that can be used in the production of a semiconductor device, such as a crosslinking agent, a crosslinking catalyst, a stabilizer (e.g. an organic acid, water, or an alcohol), an organic polymer, an acid generator, a surfactant (e.g. a nonionic surfactant, an anionic surfactant, a cationic surfactant, a silicon-based surfactant, a fluorine-based surfactant, or an UV-curable surfactant), a pH adjuster, a metal oxide, a rheology controlling agent, and an adhesion aid.

Hereinafter, various additives will be exemplified, but the additives are not limited thereto.

### -Stabilizer-

When the photosensitive surface modifier contains a polysiloxane, the stabilizer may be added for the purpose of stabilizing the hydrolysis condensate of the hydrolyzable silane mixture, or the like. Specific example of the stabilizer that may be added includes an organic acid, water, alcohol, or a combination thereof.

Examples of the organic acid include oxalic acid, malonic acid, methylmalonic acid, succinic acid, maleic acid, malic acid, tartaric acid, phthalic acid, citric acid, glutaric acid, lactic acid, and salicylic acid. Among these organic acids, oxalic acid and maleic acid are preferred. When the organic acid is added, the amount of the organic acid added is 0.1 to 5.0 mass% relative to the mass of the hydrolysis condensate of the hydrolyzable silane mixture. These organic acids may also serve as pH adjusters.

As the water, pure water, ultrapure water, ion exchanged water, or the like may be used. When pure water, ultrapure water, or ion exchanged water is used, the amount of the water added can be 0.1 to 20 parts by mass relative to 100 parts by mass of the photosensitive surface modifier.

The alcohol is preferably an alcohol that is easily scattered by heating after the application, and examples of the alcohol include methanol, ethanol, propanol, i-propanol, and butanol. When an alcohol is added, the amount of the alcohol added may be 0.1 to 20 parts by mass relative to 100 parts by mass of the photosensitive surface modifier.

### -Organic Polymer-

In a case where the photosensitive surface modifier contains a polysiloxane, addition of an organic polymer to the photosensitive surface modifier enables adjustment of the dry etching rate (amount of reduction in film thickness per unit time), attenuation coefficient, refractive index, and the like of the surface-modified film formed from the photosensitive surface modifier. The organic polymer is not particularly limited, and is appropriately selected from various organic polymers (polycondensation polymer and addition polymerization polymer) depending on the purpose of addition thereof.

Specific examples of the organic polymer include addition polymerization polymers and polycondensation polymers, such as polyester, polystyrene, polyimide, acrylic polymer, methacrylic polymer, polyvinyl ether, phenol novolac, naphthol novolac, polyether, polyamide, and polycarbonate.

In the present invention, an organic polymer containing an aromatic ring or a heteroaromatic ring such as a benzene ring, a naphthalene ring, an anthracene ring, a triazine ring, a quinoline ring, or a quinoxaline ring, which functions as a light-absorbing moiety, can also be preferably used when such a function is required. Specific examples of such an organic polymer include, but are not limited to, addition polymerization polymers containing, as structural units, addition polymerizable monomers, such as benzyl acrylate, benzyl methacrylate, phenyl acrylate, naphthyl acrylate, anthryl methacrylate, anthrylmethyl methacrylate, styrene, hydroxystyrene, benzyl vinyl ether, and N-phenylmaleimide, and polycondensation polymers, such as phenol novolac and naphthol novolac.

When an addition polymerization polymer is used as an organic polymer, the polymer may be either a homopolymer or a copolymer.

An addition polymerizable monomer is used for the production of the addition polymerization polymer. Specific examples of the addition polymerizable monomer include, but are not limited to, acrylic acid, methacrylic acid, an acrylate ester compound, a methacrylate ester compound, an acrylamide compound, a methacrylamide compound, a vinyl compound, a styrene compound, a maleimide compound, maleic anhydride, and acrylonitrile.

Specific examples of the acrylate ester compound include, but are not limited to, methyl acrylate, ethyl acrylate, normal hexyl acrylate, i-propyl acrylate, cyclohexyl acrylate, benzyl acrylate, phenyl acrylate, anthrylmethyl acrylate, 2-hydroxyethyl acrylate, 3-chloro-2-hydroxypropyl acrylate, 2-hydroxypropyl acrylate, 2,2,2-trifluoroethyl acrylate, 2,2,2-trichloroethyl acrylate, 2-bromoethyl acrylate, 4-hydroxybutyl acrylate, 2-methoxyethyl acrylate, tetrahydrofurfuryl acrylate, 2-methyl-2-adamantyl acrylate, 5-acryloyloxy-6-hydroxynorbornene-2-carboxylic-6-lactone, 3-acryloxypropyltriethoxysilane, and glycidyl acrylate.

Specific examples of the methacrylate ester compound include, but are not limited to, methyl methacrylate, ethyl methacrylate, normal hexyl methacrylate, i-propyl methacrylate, cyclohexyl methacrylate, benzyl methacrylate, phenyl methacrylate, anthrylmethyl methacrylate, 2-hydroxyethyl methacrylate, 2-hydroxypropyl methacrylate, 2,2,2-trifluoroethyl methacrylate, 2,2,2-trichloroethyl methacrylate, 2-bromoethyl methacrylate, 4-hydroxybutyl methacrylate, 2-methoxyethyl methacrylate, tetrahydrofurfuryl methacrylate, 2-methyl-2-adamantyl methacrylate, 5-methacryloyloxy-6-hydroxynorbornene-2-carboxylic-6-lactone, 3-methacryloxypropyltriethoxysilane, glycidyl methacrylate, 2-phenylethyl methacrylate, hydroxyphenyl methacrylate, and bromophenyl methacrylate.

Specific examples of the acrylamide compound include, but are not limited to, acrylamide, N-methylacrylamide, N-ethylacrylamide, N-benzylacrylamide, N-phenylacrylamide, N,N-dimethylacrylamide, and N-anthrylacrylamide.

Specific examples of the methacrylamide compound include, but are not limited to, methacrylamide, N-methylmethacrylamide, N-ethylmethacrylamide, N-benzylmethacrylamide, N-phenylmethacrylamide, N,N-dimethylmethacrylamide, and N-anthrylmethacrylamide.

Specific examples of the vinyl compound include, but are not limited to, vinyl alcohol, 2-hydroxyethyl vinyl ether, methyl vinyl ether, ethyl vinyl ether, benzyl vinyl ether, vinyl acetic acid, vinyltrimethoxysilane, 2-chloroethyl vinyl ether, 2-methoxyethyl vinyl ether, vinylnaphthalene, and vinylanthracene.

Specific examples of the styrene compound include, but are not limited to, styrene, hydroxystyrene, chlorostyrene, bromostyrene, methoxystyrene, cyanostyrene, and acetylstyrene.

Examples of the maleimide compound include, but are not limited to, maleimide, N-methylmaleimide, N-phenylmaleimide, N-cyclohexylmaleimide, N-benzylmaleimide, and N-hydroxyethylmaleimide.

When a polycondensation polymer is used as the polymer, the polymer is, for example, a polycondensation polymer composed of a glycol compound and a dicarboxylic acid compound. Examples of the glycol compound include diethylene glycol, hexamethylene glycol, and butylene glycol. Examples of the dicarboxylic acid compound include succinic acid, adipic acid, terephthalic acid, and maleic anhydride. Further, examples of the polymer include, but are not limited to, polyesters, polyamides, and polyimides, such as polypyromellitimide, poly(p-phenyleneterephthalamide), polybutylene terephthalate, and polyethylene terephthalate.

When the organic polymer contains a hydroxy group, the hydroxy group may be crosslinked with a hydrolysis condensate, or the like.

The organic polymer may ordinarily have a weight-average molecular weight of 1,000 to 1,000,000. From the viewpoint of sufficiently achieving the effect of the polymer function and preventing the precipitation of the polymer in the composition, the weight-average molecular weight of the organic polymer to be added may be, for example, 3,000 to 300,000, 5,000 to 300,000, or 10,000 to 200,000.

Such an organic polymer may be used singly or in combination of two or more kinds thereof.

When the photosensitive surface modifier contains an organic polymer in addition to the polysiloxane, the content of the organic polymer cannot be univocally determined, since the content should be appropriately determined in consideration of the function of the organic polymer or the like. Ordinarily, the content may be 1 to 200 mass% relative to the polysiloxane. From the viewpoint of preventing the precipitation of the organic polymer in the composition and the like, the content may be, for example, 100 mass% or less, preferably 50 mass% or less, and more preferably 30 mass% or less. From the viewpoint of sufficiently achieving the effect of the polymer and the like, the content may be, for example, 5 mass% or more, preferably 10 mass% or more, more preferably 30 mass% or more.

### -Acid Generator-

Examples of the acid generator include a thermal acid generator and a photoacid generator, and a photoacid generator may be preferably used.

Examples of the photoacid generator include, but are not limited to, onium salt compounds such as a sulfonium salt, a phosphonium salt, an ammonium salt, an iodonium salt, and an oxonium salt, a sulfonimide compound, and a disulfonyl diazomethane compound. The photoacid generator may also function as a curing catalyst depending on the type thereof, for example, a nitrate salt, a carboxylate salt such as maleate, or a hydrochloride salt of an onium salt compound described below.

Examples of the thermal acid generator include, but are not limited to, tetramethylammonium nitrate.

Specific examples of the onium salt compound include, but are not limited to, iodonium salt compounds, such as diphenyliodonium hexafluorophosphate, diphenyliodonium trifluoromethanesulfonate, diphenyliodonium nonafluoro normal butanesulfonate, diphenyliodonium perfluoro normal octanesulfonate, diphenyliodonium camphorsulfonate, bis(4-t-butylphenyl)iodonium camphorsulfonate, and bis(4-t-butylphenyl)iodonium trifluoromethanesulfonate; and sulfonium salt compounds, such as triphenylsulfonium hexafluoroantimonate, triphenylsulfonium nonafluoro normal butanesulfonate, triphenylsulfonium camphorsulfonate, triphenylsulfonium trifluoromethanesulfonate, triphenylsulfonium nitrate, triphenylsulfonium trifluoroacetate, triphenylsulfonium maleate, and triphenylsulfonium chloride.

Specific examples of the sulfonimide compound include, but are not limited to, N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

When the photosensitive surface modifier contains an acid generator, the content of the acid generator cannot be univocally determined, since the amount should be appropriately determined in consideration of the type of the acid generator and the like. Ordinarily, the content of the acid generator is 0.01 to 5 mass% relative to the mass of the polymer. From the viewpoint of preventing the precipitation of the acid generator in the composition and the like, the content is preferably 3 mass% or less, more preferably 1 mass% or less. From the viewpoint of sufficiently achieving the effect of the acid generator and the like, the content is preferably 0.1 mass% or more, more preferably 0.5 mass% or more.

The acid generators may be used singly or in combination of two or more kinds thereof. A photoacid generator and a thermal acid generator may be used in combination.

### -Surfactant-

When the photosensitive surface modifier is applied to a substrate, a surfactant is effective in prevention of formation of pinholes, striations, and the like. Examples of the surfactant include a nonionic surfactant, an anionic surfactant, a cationic surfactant, a silicon-based surfactant, a fluorine-based surfactant, and a UV-curable surfactant. Specific examples of the surfactant include, but are not limited to, nonionic surfactants, for example, polyoxyethylene alkyl ethers, such as polyoxyethylene lauryl ether, polyoxyethylene stearyl ether, polyoxyethylene cetyl ether, and polyoxyethylene oleyl ether, polyoxyethylene alkylaryl ethers, such as polyoxyethylene octylphenol ether and polyoxyethylene nonylphenol ether, polyoxyethylene-polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as trade names EFTOP (registered trademark) EF301, EF303, and EF352 (manufactured by Mitsubishi Materials Electronic Chemicals Co., Ltd. (former Tohkem Products Corporation)), trade names MEGAFACE (registered trademark) F171, F173, R-08, R-30, R-30N, and R-40LM (manufactured by DIC Corporation), Fluorad FC430 and FC431 (manufactured by 3M Japan Limited), trade name AsahiGuard (registered trademark) AG710 (manufactured by AGC Inc.), and trade names SURFLON (registered trademark) S-382, SC101, SC102, SC103, SC104, SC105, and SC106 (manufactured by AGC Seimi Chemical Co., Ltd.); and Organosiloxane Polymer KP341 (manufactured by Shin-Etsu Chemical Co., Ltd.).

The surfactants may be used singly or in combination of two or more kinds thereof.

When the photosensitive surface modifier contains a surfactant, the content of the surfactant is ordinarily 0.0001 to 5 mass%, preferably 0.001 to 4 mass%, and more preferably 0.01 to 3 mass% relative to the mass of the polymer.

### -Rheology Controlling Agent-

The rheology controlling agent is added mainly for the purpose of improving the fluidity of the photosensitive surface modifier, particularly in a baking step, improving the uniformity of the film thickness of a film to be formed, or improving the fillability of the composition into holes. Specific examples of the rheology controlling agent include phthalic acid derivatives, such as dimethyl phthalate, diethyl phthalate, di-i-butyl phthalate, dihexyl phthalate, and butyl-i-decyl phthalate; adipic acid derivatives, such as di-normal butyl adipate, di-i-butyl adipate, di-i-octyl adipate, and octyl decyl adipate; maleic acid derivatives, such as di-normal butyl maleate, diethyl maleate, and dinonyl maleate; oleic acid derivatives, such as methyl oleate, butyl oleate, and tetrahydrofurfuryl oleate; and stearic acid derivatives, such as normal butyl stearate and glyceryl stearate.

When such a rheology controlling agent is used, the amount of the rheology controlling agent added is ordinarily less than 30 mass% relative to all film-forming components of the photosensitive surface modifier.

### -Adhesion Aid-

The adhesion aid is added for the purpose of mainly improving the adhesion between a substrate or a resist and a film (surface-modified layer) formed from the photosensitive surface modifier, in particular, suppressing or preventing the peeling of the resist during development. Specific examples of the adhesion aid include chlorosilanes, such as trimethylchlorosilane, dimethylvinylchlorosilane, methyldiphenylchlorosilane, and chloromethyldimethylchlorosilane; alkoxysilanes, such as trimethylmethoxysilane, dimethyldiethoxysilane, methyldimethoxysilane, and dimethylvinylethoxysilane; silazanes, such as hexamethyldisilazane, N,N'-bis(trimethylsilyl)urea, dimethyltrimethylsilylamine, and trimethylsilyl imidazole; other silanes, such as γ-chloropropyltrimethoxysilane, γ-aminopropyltriethoxysilane, and γ-glycidoxypropyltrimethoxysilane; heterocyclic compounds, such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, mercaptopyrimidine; and urea or thiourea compounds, such as 1,1-dimethylurea and 1,3-dimethylurea.

When such an adhesion aid is used, the amount of the adhesion aid added is ordinarily less than 5 mass%, preferably less than 2 mass%, relative to the film-forming components of the photosensitive surface modifier.

### -pH Adjuster-

In addition, the pH adjuster may be an acid having one or two or more carboxylic acid groups, for example, an organic acid described above in -Stabilizer-. When a pH adjuster is used, the amount of the pH adjuster added may be 0.01 to 20 parts by mass, 0.01 to 10 parts by mass, or 0.01 to 5 parts by mass relative to 100 parts by mass of the polymer.

### -Metal Oxide-

Examples of the metal oxide that may be added to the photosensitive surface modifier include, but are not limited to, oxides of a combination of one or more selected from among metals, such as tin (Sn), titanium (Ti), aluminum (Al), zirconium (Zr), zinc (Zn), niobium (Nb), tantalum (Ta), and W (tungsten), and semimetals, such as boron (B), silicon (Si), germanium (Ge), arsenic (As), antimony (Sb), and tellurium (Te).

The concentration of the film-forming component in the photosensitive surface modifier may be, for example, 0.01 to 50 mass%, 0.01 to 30 mass%, 0.01 to 25 mass%, or 0.01 to 20 mass% relative to the total mass of the composition.

The content of the polymer in the film-forming component is ordinarily 20 mass% to 100 mass%. From the viewpoint of achieving the effects of the present invention at high reproducibility or the like, the lower limit of the content is preferably 50 mass%, more preferably 60 mass%, still more preferably 70 mass%, and yet still more preferably 80 mass%. The upper limit of the content is preferably 99 mass%. The balance may be an additive described above.

Further, the photosensitive surface modifier preferably has a pH of 1 to 5, more preferably a pH of 2 to 4.

The photosensitive surface modifier can be produced by mixing a polymer, a solvent, and, if desired, an additional component. In this case, a solution containing the polymer (e.g. polysiloxane) may be prepared in advance, and this solution may be mixed with a solvent or an additional component.

During preparation of the photosensitive surface modifier, the components may be appropriately heated so long as the components are not decomposed or denatured.

During the production of the photosensitive surface modifier, or after all the components have been mixed, filtration may be performed using a submicrometer-order filter or the like. Although the material type of the filter used at this time is not limited, for example, a polyethylene filter, a nylon filter, a fluororesin filter, a polyimide filter, or the like can be used.

### <Film Formation Step>

The film formation step is a step of forming a surface modification precursor film.

In the film formation step, the substrate is coated with the photosensitive surface modifier and then baked to cross-link the polymer and to form a surface-modified layer precursor.

The substrate is not particularly limited as long as it is, for example, a substrate used for producing a precision integrated circuit element. As the substrate, those described above in (Laminate) can be used.

The method for applying the photosensitive surface modifier to the substrate is not particularly limited. For example, the photosensitive surface modifier can be applied by an appropriate applying method such as a spinner or a coater.

The baking after applying the photosensitive surface modifier to the substrate can be performed using, for example, a heating means such as a hot plate.

The baking conditions are appropriately selected from a baking temperature of 40°C to 400°C, or 80°C to 250°C, and a baking time of 0.3 minutes to 60 minutes. Preferably, the baking temperature is 150°C to 250°C, and the baking time is 0.5 minutes to 2 minutes.

The solvent in the photosensitive surface modifier is evaporated by the baking process, and the polymer is cross-linked to form a layered surface modification precursor film. The cross-linking includes partial cross-linking.

The surface modification precursor film formed here has a film thickness of, for example, 1 nm to 1,000 nm, or 1 nm to 500 nm, or 1 nm to 300 nm, or 1 nm to 200 nm, or 1 to 150 nm.

In the surface modification precursor film formed in the film formation step, the contact angle of water tends to be larger than the contact angle of the substrate. The contact angle of water of the surface modification precursor film is preferably larger than the contact angle of the substrate by 20 degrees or more, more preferably 30 degrees or more, and particularly preferably 40 degrees or more.

As described above, in a case where the contact angle of water of the surface modification precursor film is larger than the contact angle of the substrate, there is likely to be a difference in the contact angle between the exposed region and the unexposed region in the surface-modified film after the exposure step described below. When the difference in contact angle between the exposed region and the unexposed region is large, the upper layer is likely to be selectively deposited only in one of the regions in a selective film formation step.

### <Exposure Step>

In the exposure step, for example, an exposed region and an unexposed region are formed on the surface modification precursor film through a predetermined mask (reticle). The light exposure may be performed using a KrF excimer laser (wavelength: 248 nm), an ArF excimer laser (wavelength: 193 nm), an F₂ excimer laser (wavelength: 157 nm), EUV (wavelength: 13.5 nm), electron beams, or the like.

The exposure step is preferably performed until the contact angle of water between the exposed region and the unexposed region differs by 10 degrees or more, particularly preferably by 20 degrees or more, and more preferably by 30 degrees or more. This is because when the difference in the contact angle of water between the exposed region and the unexposed region is within the above range, a laminate in which an upper layer is likely to be formed in a region-selective manner is obtained. Specifically, in the exposure step, the surface modification precursor film is exposed to light with an exposure amount of 20 mJ/cm² or more, thus a surface-modified film within the range of the contact angle is likely to be formed.

### <Thinning Step>

The thinning step is a step of bringing the surface-modified film after the exposure step into contact with a thinning liquid to thin the surface-modified film and to form a surface-modified film having a film thickness of 5 nm or less. The thinning step may be performed on the surface modification precursor film after the film formation step and before the exposure step to form a surface modification precursor film having a film thickness of 5 nm or less, and then the exposure step may be performed.

The substrate is coated with the photosensitive surface modifier containing a polymer and a solvent and then baked, and thus a film having a cross-linked polymer is formed. However, it is not easy to form a thin film (e.g. a film having a film thickness of 5 nm or less) without film defects such as pinholes and non-uniformity in application only by this step, and it is necessary to sufficiently control application conditions, baking conditions, and the like.

Accordingly, as a method for producing a laminate capable of forming a thin surface-modified layer, the thinning step can be used to form a thin surface-modified layer by forming a layer having a film thickness thicker than a target film thickness and then bringing the layer into contact with a thinning liquid to thin the layer.

Cross-linking of the polymer in the film formation step makes it possible to prevent the surface-modified layer from being excessively dissolved in the thinning liquid in the thinning step.

In the thinning step, the method of bringing the surface-modified film into contact with the thinning liquid is not particularly limited. Spin coating is preferred from the viewpoint that the thickness can be uniformly thinned and the degree of thinning can be easily controlled with high accuracy. That is, the thinning step is preferably a step of spin-coating the surface-modified film with a thinning liquid to thin the surface-modified film and to form a surface-modified film having a film thickness of 5 nm or less.

The conditions for spin coating are not particularly limited, and include, for example, an application treatment of applying a thinning liquid to the surface-modified film of the substrate on which the surface-modified film is formed, and a rotation treatment of rotating the substrate.

In the application treatment, for example, when the thinning liquid is applied to the surface-modified film, the substrate is not rotated or rotated at a low speed (e.g. 1000 rpm or less). In the application treatment, the thinning liquid is brought into contact with the surface-modified film, and thus the components in the surface-modified film are transferred to the thinning liquid.

In the rotation treatment, for example, the substrate is rotated at a high speed (e.g. more than 1,000 rpm and 5,000 rpm or less), and the thinning liquid is removed from the substrate with the surface-modified film.

As a result of this process, the surface-modified film is thinned to the extent that the components in the surface-modified film are transferred to the thinning liquid. Consequently, a surface-modified film having a film thickness of 5 nm or less is formed.

The time required for the application treatment is, for example, 10 seconds to 2 minutes.

The time required for the rotation treatment is, for example, 5 seconds to 1 minute.

At the time of rotation, for example, an axis orthogonal to the surface of the substrate is set as a rotation axis.

In the thinning step, the film thickness of the surface-modified film is preferably reduced to 0.5 nm or more and 10 nm or less, more preferably 1 nm or more and 5 nm or less.

### <<Thinning Liquid>>

The thinning liquid is not particularly limited as long as it is a liquid in which the surface-modified film is brought into contact with the thinning liquid to thin the surface-modified film, and examples thereof include an organic solvent, water, and an alkaline aqueous solution. These materials can be used singly or in combination of two or more kinds thereof.

Examples of the organic solvent include alcohols, alkylene glycol alkyl ethers, and alkylene glycol monoalkyl ether carboxylic acid esters.

Examples of the alcohols include a monoalcohol-based solvent and a polyhydric alcohol-based solvent. Specific examples of the monoalcohol-based solvent and the polyhydric alcohol-based solvent include the monoalcohol-based solvents and polyhydric alcohol-based solvents described above as the solvents used for hydrolysis and condensation.

Examples of the alkylene glycol alkyl ethers include alkylene glycol monoalkyl ethers and alkylene glycol dialkyl ethers.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Examples of the alkylene glycol dialkyl ether include diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, and propylene glycol dibutyl ether.

Examples of the alkylene glycol monoalkyl ether carboxylic acid esters include alkylene glycol monoalkyl ether acetate.

Examples of the alkylene glycol monoalkyl ether acetate include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, ethylene glycol monomethyl ether acetate, ethylene glycol monoethyl ether acetate, ethylene glycol monopropyl ether acetate, and ethylene glycol monobutyl ether acetate.

Specific examples of other organic solvents include toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, methyl propyl ketone, methyl butyl ketone, 2-heptanone, 3-heptanone, 4-heptanone, N,N-dimethylformamide, N-methylacetamide, N,N-dimethylacetamide, N-methyl-2-pyrrolidone, 4-methyl-2-pentanol, and γ-butyrolactone.

Examples of the alkaline aqueous solution include developers used in a lithography process.

Examples of the alkaline aqueous solution include an inorganic alkaline aqueous solution and an organic alkaline aqueous solution. Examples of the inorganic alkaline aqueous solution include a potassium hydroxide aqueous solution, a sodium hydroxide aqueous solution, a sodium carbonate aqueous solution, a potassium carbonate aqueous solution, a sodium hydrogen carbonate aqueous solution, a potassium hydrogen carbonate aqueous solution, a sodium phosphate aqueous solution, and a potassium phosphate aqueous solution. Examples of the organic alkaline aqueous solution include a tetramethylammonium hydroxide aqueous solution, a tetraethylammonium hydroxide aqueous solution, a tetrabutylammonium hydroxide aqueous solution, a monoethanolamine aqueous solution, a diethanolamine aqueous solution, and a triethanolamine aqueous solution.

The concentration of the alkali in the alkaline aqueous solution is not particularly limited.

In an embodiment of the present invention, in the laminate, an organic underlayer film may be provided between the substrate and the surface-modified film.

The organic underlayer film used here is not particularly limited, and may be arbitrarily selected from organic underlayer films commonly used in the lithography process.

In one aspect, the organic underlayer film is formed on the substrate, and the surface-modified film is formed on the organic underlayer film, followed by formation of a resist film as described below on the surface-modified film. This can narrow the pattern width of a resist film. Thus, even when the resist film is formed thinly for preventing pattern collapse, the substrate can be processed through selection of an appropriate etching gas described below. For example, the resist underlayer film can be processed using a fluorine-based gas having a sufficiently high etching rate with respect to the resist film as an etching gas, the organic underlayer film can be processed using an oxygen-based gas having a sufficiently high etching rate with respect to the resist underlayer film as an etching gas, and the substrate can be processed using a fluorine-based gas having a sufficiently high etching rate with respect to the organic underlayer film as an etching gas.

The substrate and application method usable in this process include those described above.

### <Selective Film Formation Step>

The method for producing a laminate of the present invention may further include a selective film formation step.

The selective film formation step is a step of preferentially forming an upper layer in one of the exposed region and the unexposed region.

The upper layer is, for example, a metal oxide film.

The selective film formation step can be performed by forming an upper layer by any of vacuum deposition, chemical vapor deposition (CVD), atomic layer deposition (ALD), and molecular layer deposition (MLD). The ALD method is preferred when excellent step coverage is required.

When the ALD method is used as the selective film formation step, it is preferable to form the upper layer using at least two kinds of gases. Specifically, regarding a step (1) of introducing the first gas (precursor) into a film formation apparatus, a step (2) of purging the inside of the apparatus, a step (3) of introducing the second gas, and a step (4) of purging the inside of the apparatus, these four steps are taken as one cycle, and the cycle is repeated, and thus the upper layer can be formed. A plasma treatment step may be performed after the step (2) or the step (4).

As the first gas (precursor), an organic metal, a metal halide, a metal oxyhalide, or the like can be used. For example, known compounds such as halogen, alkyl, alkoxide, alkylamide, and diketonate may be used as the precursor used in the ALD method. As the second gas, a gas that decomposes the first gas or a gas capable of removing a ligand of a precursor of the first gas can be used, and examples thereof include water (H₂O). As the carrier gas, helium gas, argon gas, nitrogen gas, or the like may be used. The reaction temperature at the time of forming the upper layer is not particularly limited, and is, for example, 100°C or higher and 800°C or lower.

In the method for producing a laminate of the present invention, a surface-modified film having two types of different regions having different surface characteristics, i.e. an exposed region and an unexposed region, is formed by the exposure step. Accordingly, in the selective film formation step, it is possible to selectively form the upper layer using the difference in surface characteristics between the two types of regions.

For example, after the exposure step, a resist film is formed by the ALD method on the surface-modified film in which the exposed region has high hydrophilicity (small contact angle of water) and the unexposed region has lower hydrophilicity than the exposed region (large contact angle of water). Thus, a large amount of metal film or the like tends to be selectively deposited on the exposed region. This makes it easy to form a metal film or the like having a pattern similar to the pattern of the exposed region and the unexposed region formed on the surface-modified film as an upper layer.

The upper layer is not particularly limited, and examples thereof include a metal film, an oxide film, a nitride film, a carbonized film, and a sulfide film. As the upper layer, for example, a film containing a pure element (e.g. Si, Cu, Ta, W), a film containing an oxide (e.g. SiO₂, GeO₂, HfO₂, ZrO₂, Ta₂O₅, TiO₂, Al₂O₃, ZnO, SnO₂, Sb₂O₅, B₂O₃, In₂O₃, WO₃), a film containing a nitride (e.g. Si₃N₄, TiN, AlN, BN, GaN, NbN), a film containing a carbide (e.g. SiC), a film containing a sulfide (e.g. CdS, ZnS, MnS, WS₂, PbS), a film containing a selenide (e.g. CdSe, ZnSe), a film containing a phosphide (GaP, InP), a film containing an arsenide (e.g. GaAs, InAs), or a film of a mixture thereof may be formed.

### Examples

Hereinafter, the present invention will be described more specifically with reference to Synthesis Examples and Examples, but the present invention is not limited to only the following Examples.

In the Examples, apparatuses and conditions used for analysis of the physical properties of samples are as follows.

### (1) Measurement of Molecular Weight

The molecular weight of the polysiloxane used in the present invention is determined by GPC analysis in terms of polystyrene.

The GPC analysis can be performed, for example, under the following conditions: GPC apparatus (trade name: HLC-8220GPC, manufactured by Tosoh Corporation), GPC columns (trade name: Shodex (registered trademark) KF803L, KF802, and KF801, manufactured by Showa Denko K.K.), column temperature of 40°C, tetrahydrofuran as an eluent (elution solvent), flow amount (flow rate) of 1.0 mL/min, and polystyrene (manufactured by Showa Denko K.K.) as a standard sample.

### (2) ¹H-NMR

The evaluation was performed using a nuclear magnetic resonance apparatus ¹H-NMR (400 MHz), manufactured by JEOL Ltd., and d6-Acetone as a solvent.

### (3) Amount of Residual Nitric Acid

The amount of nitric acid remaining in the system was measured by ion chromatography evaluation.

### [1] Synthesis of Polymer (Hydrolysis Condensate)

### (Synthesis Example 1)

A 300 mL flask was charged with 17.76 g of (3-triethoxysilyl)propylsuccinic anhydride, 16.37 g of triphenylsulfonium hydroxide, and 51.17 g of propylene glycol monoethyl ether. While the resultant mixed solution was stirred with a magnetic stirrer, 14.72 g of 0.1M nitric acid aqueous solution was added dropwise to the mixed solution.

After the dropwise addition, the flask was transferred to an oil bath set at 100°C and the mixed solution was reacted for 20 hours. Thereafter, ethanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1200 as determined by GPC in terms of polystyrene. The amount of Si atoms capped by the propylene glycol monoethyl ether was determined through ¹H-NMR to be 3 mol%. In addition, the amount of residual nitric acid in the polymer solution was 0.07%.

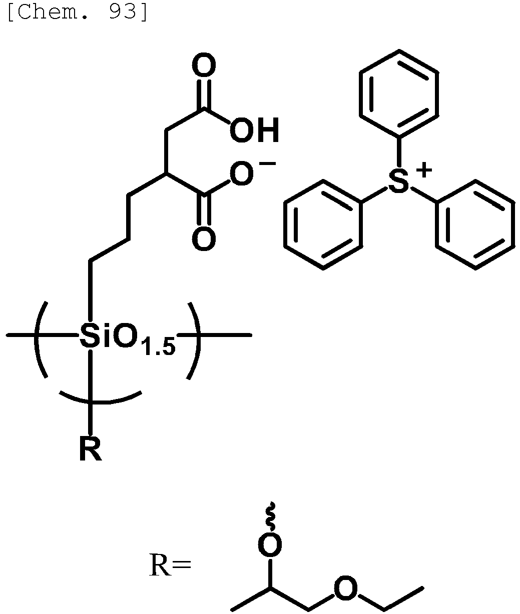

### (Synthesis Example 2)

A 300 mL flask was charged with 12.89 g of 3-(trihydroxysilyl)-1-propanesulfonic acid, 20.68 g of triphenylsulfonium hydrogencarbonate, and 50.35 g of propylene glycol monoethyl ether. While the resultant mixed solution was stirred with a magnetic stirrer, 16.08 g of 0.1M nitric acid aqueous solution was added dropwise to the mixed solution.

After the dropwise addition, the flask was transferred to an oil bath set at 100°C and the mixed solution was reacted for 20 hours. Thereafter, a reaction by-product: water was distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1800 as determined by GPC in terms of polystyrene. The amount of Si atoms capped by the propylene glycol monoethyl ether was determined through ¹H-NMR to be 5 mol%. The amount of residual nitric acid in the polymer solution was 0.08%.

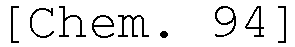

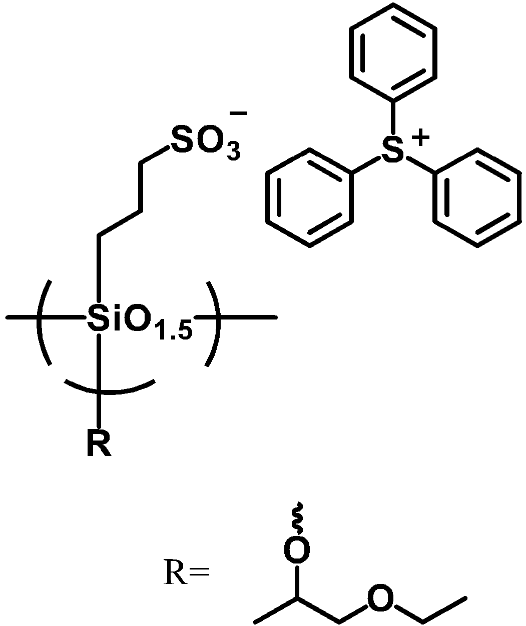

### (Synthesis Example 3)

A 300 mL flask was charged with 37.38 g of (2-(((2-hydroxy-5-(2-trimethoxysilyl)ethylcyclohexyl)oxy)carbonyl)phenyl phenyl iodonium trifluoromethanesulfonate and 56.07 g of propylene glycol monoethyl ether. While the resultant mixed solution was stirred with a magnetic stirrer, 6.54 g of 0.1M nitric acid aqueous solution was added dropwise to the mixed solution.

After the dropwise addition, the flask was transferred to an oil bath set at 100°C and the mixed solution was reacted for 20 hours. Thereafter, methanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1500 as determined by GPC in terms of polystyrene. The amount of Si atoms capped by the propylene glycol monoethyl ether was determined through ¹H-NMR to be 4 mol%. The amount of residual nitric acid in the polymer solution was 0.06%.

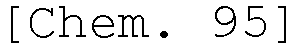

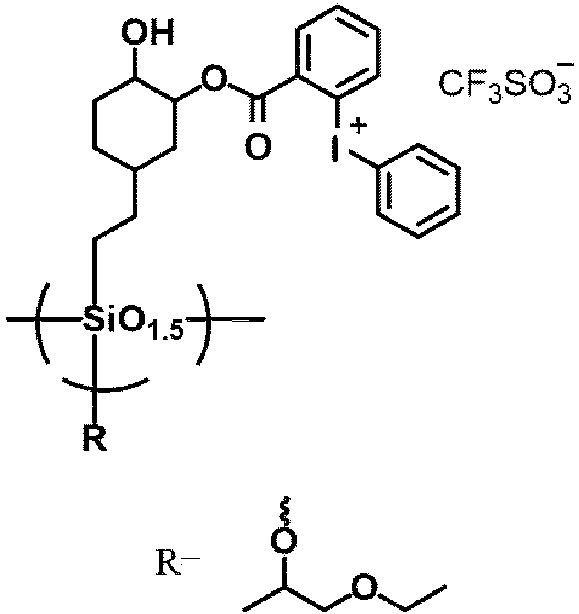

### (Synthesis Example 4)

A 300 mL flask was charged with 37.74 g of (3-((2-hydroxy-5-(2-(trimethoxysilyl)ethyl)cyclohexyl)oxy)phenyl)(4-hydroxyphenyl) (phenyl)sulfonium nonafluorobutanesulfonate, and 56.60 g of propylene glycol monoethyl ether. While the resultant mixed solution was stirred with a magnetic stirrer, 5.66 g of 0.1M nitric acid aqueous solution was added dropwise to the mixed solution.

After the dropwise addition, the flask was transferred to an oil bath set at 100°C and the mixed solution was reacted for 20 hours. Thereafter, methanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 2200 as determined by GPC in terms of polystyrene. The amount of Si atoms capped by the propylene glycol monoalkyl ether was determined through ¹H-NMR to be 3 mol%. The amount of residual nitric acid in the polymer solution was 0.08%.

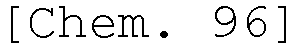

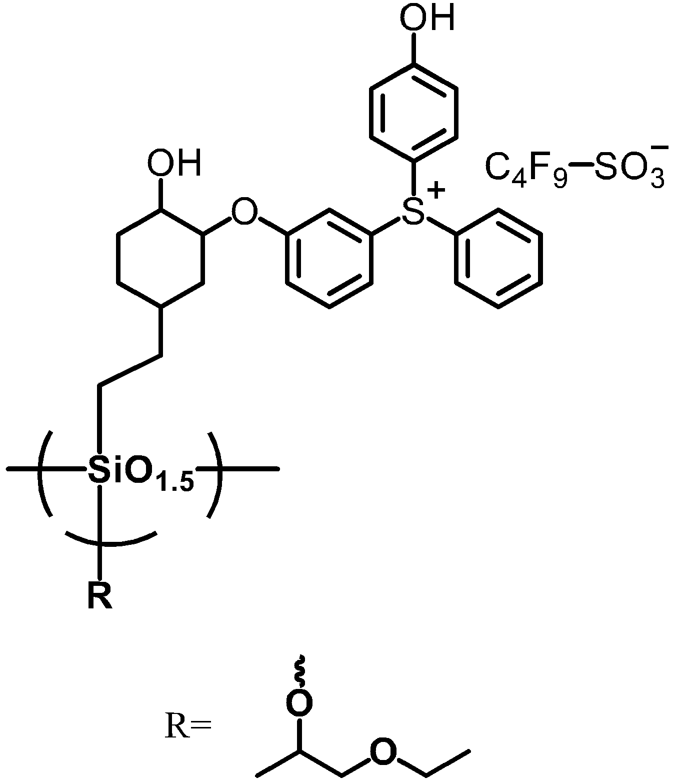

### (Synthesis Example 5)

A 300 mL flask was charged with 16.69 g of (3-triethoxysilyl)propylsuccinic anhydride, 17.77 g of diphenyliodonium-2-carboxylate, and 51.70 g of propylene glycol monoethyl ether. While the resultant mixed solution was stirred with a magnetic stirrer, 12.78 g of 0.1M nitric acid aqueous solution was added dropwise to the mixed solution.

After the dropwise addition, the flask was transferred to an oil bath set at 100°C and the mixed solution was reacted for 20 hours. Thereafter, ethanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1500 as determined by GPC in terms of polystyrene. The amount of Si atoms capped by the propylene glycol monoethyl ether was determined through ¹H-NMR to be 6 mol%. The amount of residual nitric acid in the polymer solution was 0.08%.

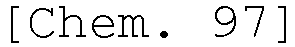

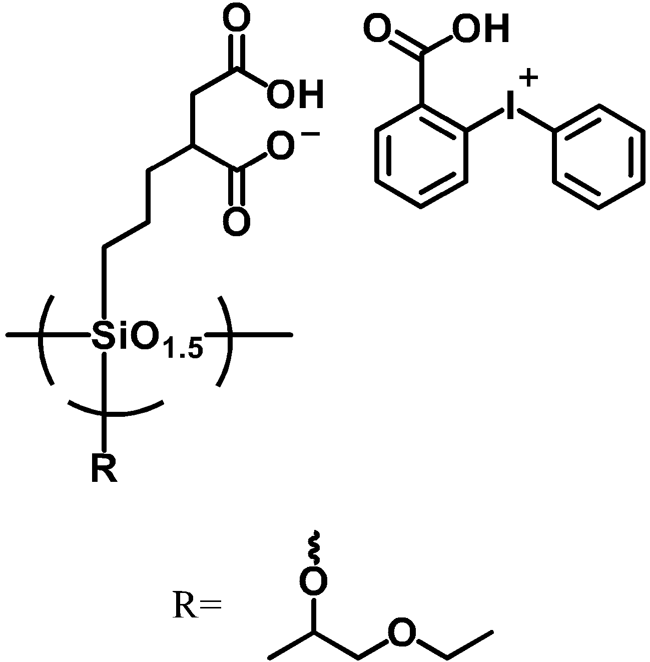

### (Synthesis Example 6)

A 300 mL flask was charged with 12.90 g of 3-(trihydroxysilyl)-1-propanesulfonic acid, 20.67 g of diphenyliodonium-2-carboxylate, and 50.35 g of propylene glycol monoethyl ether. While the resultant mixed solution was stirred with a magnetic stirrer, 16.09 g of 0.1M nitric acid aqueous solution was added dropwise to the mixed solution.

After the dropwise addition, the flask was transferred to an oil bath set at 100°C and the mixed solution was reacted for 20 hours. Thereafter, a reaction by-product: water was distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 2000 as determined by GPC in terms of polystyrene. The amount of Si atoms capped by the propylene glycol monoethyl ether was determined through ¹H-NMR to be 3 mol%. The amount of residual nitric acid in the polymer solution was 0.06%.

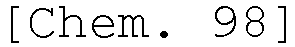

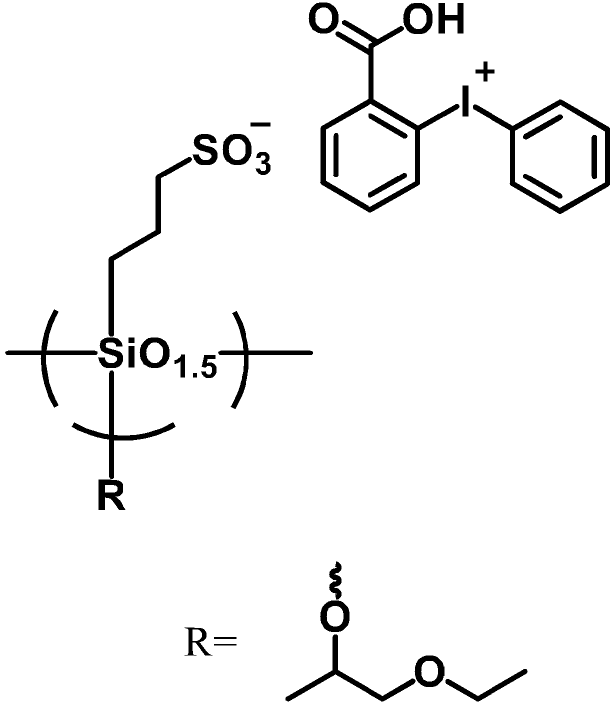

### (Synthesis Example 7)

A 300 mL flask was charged with 32.49 g of trifluoropropyltrimethoxysilane and 48.73 g of propylene glycol monoethyl ether. While the resultant mixed solution was stirred with a magnetic stirrer, 18.78 g of 0.1M nitric acid aqueous solution was added dropwise to the mixed solution.

After the dropwise addition, the flask was transferred to an oil bath set at 100°C and the mixed solution was reacted for 20 hours. Thereafter, methanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1300 as determined by GPC in terms of polystyrene. The amount of Si atoms capped by the propylene glycol monoethyl ether was determined through ¹H-NMR to be 3 mol%. In addition, the amount of residual nitric acid in the polymer solution was 0.05%.

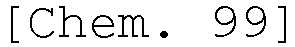

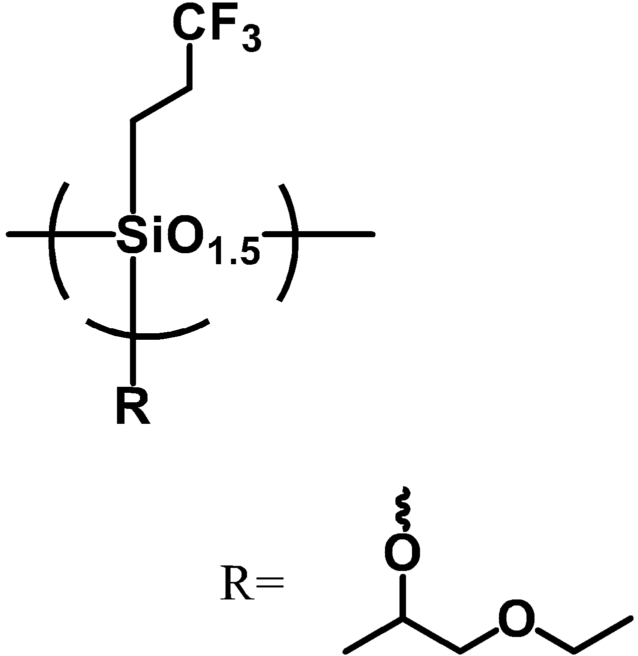

### (Synthesis Example 8)

A 300 mL flask was charged with 34.41 g of pentafluorophenyltriethoxysilane and 51.61 g of propylene glycol monoethyl ether. While the resultant mixed solution was stirred with a magnetic stirrer, 13.98 g of 0.1M nitric acid aqueous solution was added dropwise to the mixed solution.

After the dropwise addition, the flask was transferred to an oil bath set at 100°C and the mixed solution was reacted for 20 hours. Thereafter, ethanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1000 as determined by GPC in terms of polystyrene. The amount of Si atoms capped by the propylene glycol monoethyl ether was determined through ¹H-NMR to be 4 mol%. The amount of residual nitric acid in the polymer solution was 0.06%.

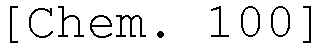

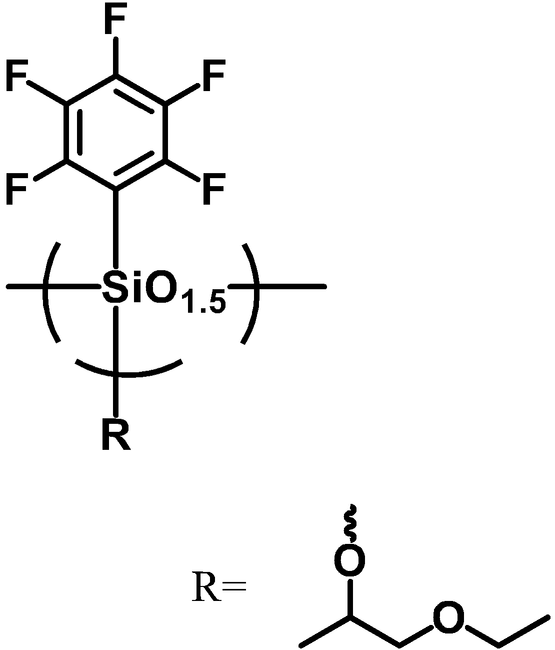

### (Synthesis Example 9)

A 300 mL flask was charged with 33.80 g of chlorophenyltriethoxysilane and 51.61 g of propylene glycol monoethyl ether. While the resultant mixed solution was stirred with a magnetic stirrer, 13.98 g of 0.1M nitric acid aqueous solution was added dropwise to the mixed solution.

After the dropwise addition, the flask was transferred to an oil bath set at 100°C and the mixed solution was reacted for 20 hours. Thereafter, ethanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1000 as determined by GPC in terms of polystyrene. The amount of Si atoms capped by the propylene glycol monoethyl ether was determined through ¹H-NMR to be 3 mol%. In addition, the amount of residual nitric acid in the polymer solution was 0.07%.

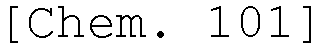

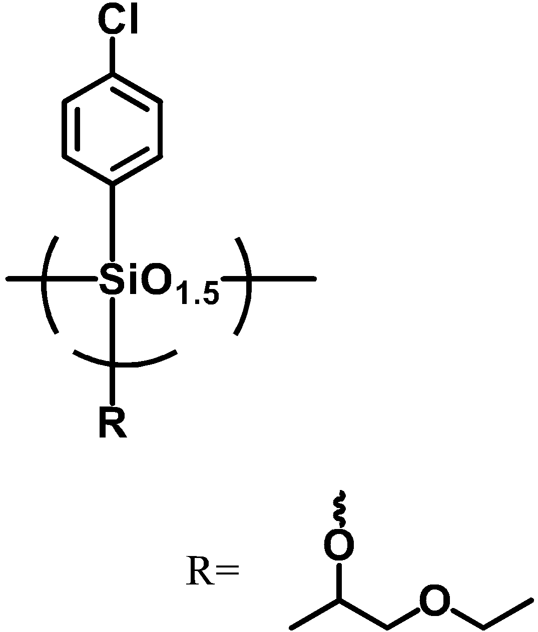

### (Synthesis Example 10)

A 300 mL flask was charged with 33.80 g of bromophenyltrimethoxysilane and 51.61 g of propylene glycol monoethyl ether. While the resultant mixed solution was stirred with a magnetic stirrer, 13.98 g of 0.1M nitric acid aqueous solution was added dropwise to the mixed solution.

After the dropwise addition, the flask was transferred to an oil bath set at 100°C and the mixed solution was reacted for 20 hours. Thereafter, ethanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1100 as determined by GPC in terms of polystyrene. The amount of Si atoms capped by the propylene glycol monoethyl ether was determined through ¹H-NMR to be 3 mol%. The amount of residual nitric acid in the polymer solution was 0.06%.

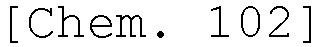

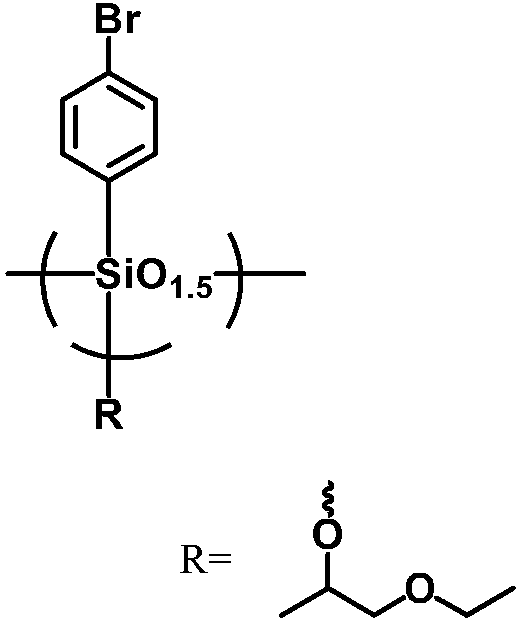

### (Synthesis Example 11)

A 300 mL flask was charged with 34.07 g of iodopropyltrimethoxysilane and 51.11 g of propylene glycol monoethyl ether. While the resultant mixed solution was stirred with a magnetic stirrer, 14.81 g of 0.1M nitric acid aqueous solution was added dropwise to the mixed solution.

After the dropwise addition, the flask was transferred to an oil bath set at 100°C and the mixed solution was reacted for 20 hours. Thereafter, methanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1200 as determined by GPC in terms of polystyrene. The amount of Si atoms capped by the propylene glycol monoethyl ether was determined through ¹H-NMR to be 4 mol%. The amount of residual nitric acid in the polymer solution was 0.06%.

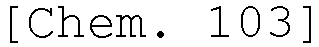

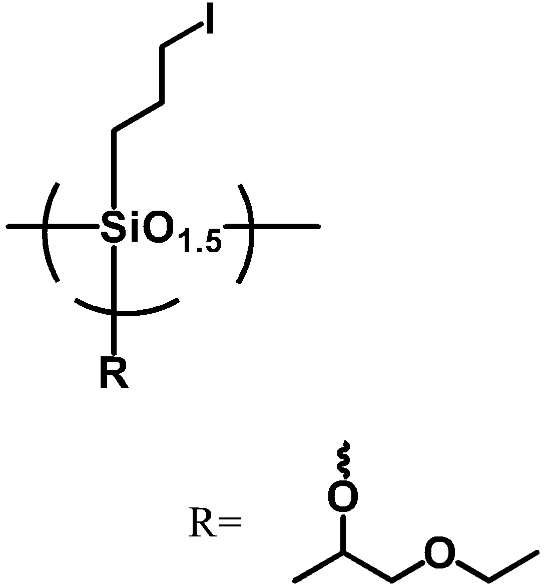

### (Synthesis Example 12)

In Synthesis Example 12, iodophenylsulfonylpropyltrimethoxysilane obtained in the following Synthesis Example was used.

### <Synthesis Example of Raw Material>

A 200 mL recovery flask was charged with 14.4 g (0.048 mol) of 4-iodobenzene-1-sulfonyl chloride, 9.0 g (0.072 mol) of sodium sulfite, 18.0 g (0.215 mol) of sodium hydrogen carbonate, and 45.0 g of water, and the resultant mixture was heated to 100°C, and reacted for 1 hour. Thereafter, 50.0 g of toluene was added, the mixture was heated to a reflux state, and water was collected by a Dean-Stark apparatus. To the mixture, 9.5 g (0.048 mol) of 3-chloropropyltrimethoxysilane, 1.4 g (0.010 mol) of sodium iodide, and 45.0 g of N-methyl-2-pyrrolidone were added, and the resultant mixture was heated and stirred at 150°C for 3 hours while a solvent was distilled off. The reaction solution was separated with toluene and water, sodium carbonate was then added to the organic phase, the mixture was stirred and filtered, and toluene was removed with an evaporator to obtain a crude product. The crude product was distilled under reduced pressure to obtain the following compound 1 as a target product in a yield of 36%.
¹H-NMR (500 MHz, CDCl₃): 0.70 ppm (t, 2H), 1.82 ppm (m, 2H), 3.12 ppm (t, 2H), 3.53 ppm (s, 9H), 7.61 ppm (d, 2H), 7.93 ppm (d, 2H)

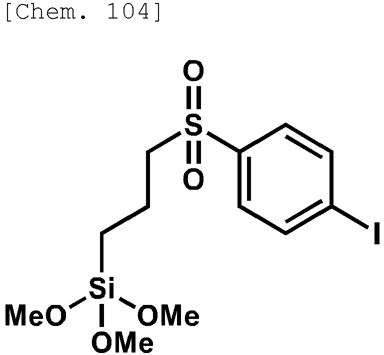

Me represents a methyl group.

A 300 mL flask was charged with 35.80 g of iodophenylsulfonylpropyltrimethoxysilane obtained in the above Synthesis Example and 53.70 g of propylene glycol monoethyl ether. While the resultant mixed solution was stirred with a magnetic stirrer, 10.49 g of 0.1M nitric acid aqueous solution was added dropwise to the mixed solution.

After the dropwise addition, the flask was transferred to an oil bath set at 100°C and the mixed solution was reacted for 20 hours. Thereafter, methanol, and water, i.e. reaction by-products, were distilled off under reduced pressure for concentration to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 1300 as determined by GPC in terms of polystyrene. The amount of Si atoms capped by the propylene glycol monoethyl ether was determined through ¹H-NMR to be 4 mol%. In addition, the amount of residual nitric acid in the polymer solution was 0.05%.

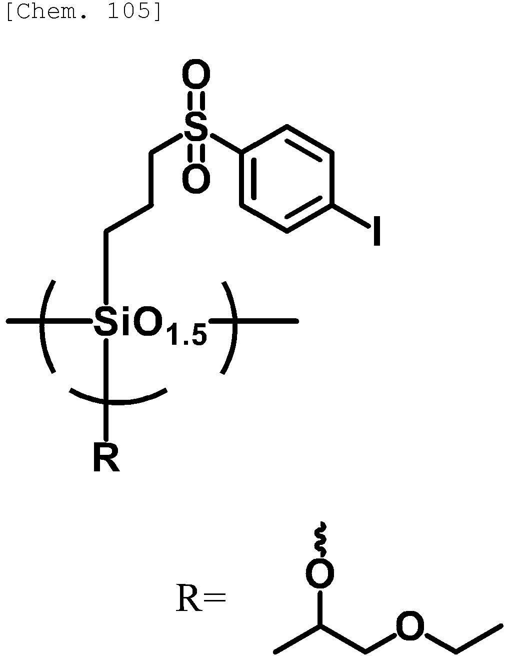

### (Comparative Synthesis Example 1)

A 300 mL flask was charged with 32.20 g of tetraethoxysilane and 48.3 g of propylene glycol monoethyl ether. While the resultant mixed solution was stirred with a magnetic stirrer, 19.5 g of nitric acid aqueous solution (0.1mol/L) was added dropwise to the mixed solution.

After the dropwise addition, the flask was transferred to an oil bath set at 60°C and the mixed solution was refluxed for 20 hours. Thereafter, ethanol, and water, i.e. reaction by-products, were distilled off under reduced pressure for concentration to obtain a hydrolysis condensate (polymer) solution.

Further, propylene glycol monomethyl ether was added to the solution to achieve a solvent proportion of propylene glycol monomethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following Formula, and to have a weight-average molecular weight Mw of 5,800 as determined by GPC in terms of polystyrene. The amount of Si atoms capped by the propylene glycol monomethyl ether was determined through ¹H-NMR to be 9 mol%. The amount of residual nitric acid in the polymer solution was 0.08%.

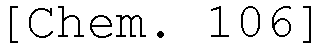

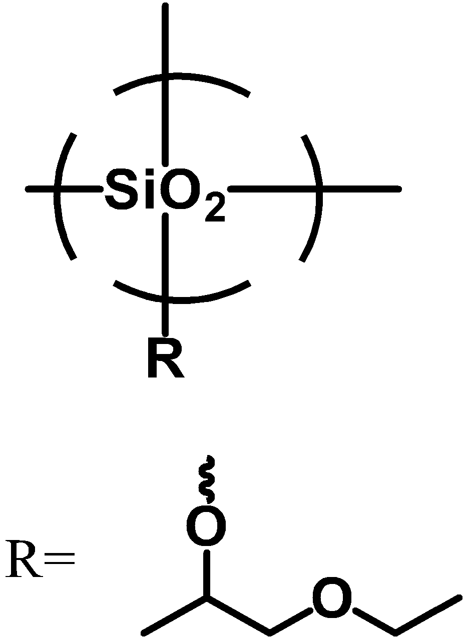

### [2] Preparation of Composition Applied to Resist Pattern

The polysiloxane (polymer) obtained in each of the above Synthesis Examples, an acid (additive 1), a photoacid generator (additive 2), and a solvent were mixed in proportions shown in Table 1, and the mixture was filtered through a 0.1 µm fluororesin filter to prepare each composition to be applied to a resist pattern. In Table 1, the amount of each component added is shown by part(s) by mass.

Although the composition was prepared from the solution containing the hydrolysis condensate (polymer) produced in each Synthesis Example, the amount of each polymer shown in Table 1 corresponds not to the amount of the polymer solution, but to the amount of the polymer itself.

Abbreviations in Table 1 are shown below.

### <Solvent>

DIW: ultrapure water
PGEE: propylene glycol monoethyl ether
PGME: propylene glycol monomethyl ether

### <Additive 1>

MA: maleic acid

### <Additive 2>

TPSNO3: triphenylsulfonium nitrate
TPSML: triphenylsulfonium maleate
TPSTfAc: triphenylsulfonium trifluoroacetate
BTEAC: benzyltriethylammonium chloride salt
TPSCl: triphenylsulfonium chloride salt

**[Table 1]**

| | Polymer | Additive 1 | Additive 2 | Solvent | | |
|---|---|---|---|---|---|---|
| Application liquid 1 | Synthesis Example 1 | MA | | PGEE | PGME | |
| (part(s) by mass) | 0.25 | 0.0025 | | 80 | 20 | |
| Application liquid 2 | Synthesis Example 2 | MA | | PGEE | PGME | DIW |
| (part(s) by mass) | 0.25 | 0.0025 | | 80 | 8 | 12 |
| Application liquid 3 | Synthesis Example 3 | MA | | PGEE | PGME | DIW |
| (part(s) by mass) | 0.25 | 0.0025 | | 80 | 8 | 12 |
| Application liquid 4 | Synthesis Example 4 | MA | | PGEE | PGMEA | |
| (part(s) by mass) | 0.25 | 0.0025 | | 80 | 20 | |
| Application liquid 5 | Synthesis Example 5 | MA | | PGEE | PGME | DIW |
| (part(s) by mass) | 0.25 | 0.0025 | | 80 | 8 | 12 |
| Application liquid 6 | Synthesis Example 6 | MA | | PGEE | PGME | DIW |
| (part(s) by mass) | 0.25 | 0.0025 | | 80 | 8 | 12 |
| Application liquid 7 | Synthesis Example 7 | MA | TPSN03 | PGEE | PGMEA | |
| (part(s) by mass) | 0.25 | 0.0025 | 0.001 | 80 | 20 | |
| Application liquid 8 | Synthesis Example 8 | MA | TPSML | PGEE | PGME | DIW |
| (part(s) by mass) | 0.25 | 0.0025 | 0.001 | 80 | 8 | 12 |
| Application liquid 9 | Synthesis Example 9 | MA | TPSTfAc | PGEE | PGME | DIW |
| (part(s) by mass) | 0.25 | 0.0025 | 0.001 | 80 | 8 | 12 |
| Application liquid 10 | Synthesis Example 10 | MA | BTEAC | PGEE | PGMEA | |
| (part(s) by mass) | 0.25 | 0.0025 | 0.001 | 80 | 20 | |
| Application liquid 11 | Synthesis Example 11 | MA | TPSCl | PGEE | PGME | DIW |
| (part(s) by mass) | 0.25 | 0.0025 | 0.001 | 80 | 8 | 12 |
| Application liquid 12 | Synthesis Example 12 | MA | | PGEE | PGME | DIW |
| (part(s) by mass) | 0.25 | 0.0025 | | 80 | 8 | 12 |
| Comparative application liquid 1 | Comparati ve Synthesis Example 1 | MA | | PGEE | PGME | DIW |
| (part(s) by mass) | 0.25 | 0.0025 | | 80 | 8 | 12 |

| | | | | | | |
|---|---|---|---|---|---|---|
| * Examples 1 to 12 and Comparative Example 1 further include nitric acid contained in the polymer solution prepared in Synthesis Example 1 to 6 and Comparative Synthesis Example. | | | | | | |

### Substrate Surface Modification Property Test

[3] Application liquids 1 to 12 and a comparative application liquid 1 were each applied to each Bare-Si and Bare-Si having a SiON (50 nm) film. Specifically, 1 ml of each of the application liquids 1 to 12 and the comparative application liquid 1 was applied to a wafer using CLEANTRACK (registered trademark) ACT8 (Tokyo Electron Ltd.), spin-coated at 1500 rpm for 60 seconds, and then baked at 215°C (120°C for the comparative application liquid 1). Thereafter, a mixed solvent of propylene glycol monomethyl ether/propylene glycol monomethyl ether acetate (7/3 (V/V)) was applied onto each of the surface-modified films, and then spin-dried to form photosensitive surface-modified films having a film thickness of 30Å (3 nm) . After that, measurement was performed on the contact angle of water with respect to the substrate on which the photosensitive surface-modified film of each of the application liquids 1 to 12 and the comparative application liquid 1 was formed. After liquid dropping in a volume of 3 µl, the dropping was stopped for 5 seconds, and then the water contact angle was measured in a constant temperature and humidity environment (23°C ± 2°C, 45%RH ± 5%) using a fully automatic contact angle meter DM-701 (manufactured by Kyowa Interface Science Co., Ltd.). This process was repeated five times, and an average value of the measurements was calculated. Both the water contact angles of the Bare-Si substrate and SiON (50 nm) were 20 degrees or less. Thus, a water contact angle of less than 30 degrees was determined as "poor" because the surface was not modified, and a water contact angle of 30 degrees or more was determined as "good" because the surface was modified. The measurement results are described in Table 2 below.

**[Table 2]**

| | Substrate | Application liquid | Baking temperature | Surface modification property (water contact angle of 30 degrees or more) |
|---|---|---|---|---|
| Example 1 | Bare-Si | Application liquid 1 | 215°C | Good |
| Example 2 | Bare-Si | Application liquid 2 | 215°C | Good |
| Example 3 | SiON | Application liquid 3 | 215°C | Good |
| Example 4 | Bare-Si | Application liquid 4 | 215°C | Good |
| Example 5 | Bare-Si | Application liquid 5 | 215°C | Good |
| Example 6 | Bare-Si | Application liquid 6 | 215°C | Good |
| Example 7 | SiON | Application liquid 7 | 215°C | Good |
| Example 8 | Bare-Si | Application liquid 8 | 215°C | Good |
| Example 9 | Bare-Si | Application liquid 9 | 215°C | Good |
| Example 10 | Bare-Si | Application liquid 10 | 215°C | Good |
| Example 11 | Bare-Si | Application liquid 11 | 215°C | Good |
| Example 12 | Bare-Si | Application liquid 12 | 215°C | Good |
| Comparative Example 1 | Bare-Si | Comparative application liquid 1 | 120°C | Poor |

As described above, due to the surface-modified film, each of the contact angles of water in Examples 1 to 12 was larger than the contact angle of water of the substrate including the Bare-Si or SiON film, and was 30 degrees or more. It was shown that the surface state was lower in hydrophilicity (higher in hydrophobicity) than the substrate before formation of the surface-modified film.

### [4] Formation of Film Hydrophilized by ArF Exposure

Each Bare-Si was spin-coated with each composition resulting from the application liquids 1 to 12 and the comparative application liquid 1 and heated at any temperature for 1 minute. Thereafter, a mixed solvent of propylene glycol monomethyl ether/propylene glycol monomethyl ether acetate (7/3 (V/V)) was applied onto each of the coating films, and spin-dried to form surface-modified films (1 to 3 nm) having a film thickness of 30Å or less. Further, the entire surface of each of the wafers was exposed using an ArF exposure apparatus (S307E), manufactured by Nikon Corporation.

Thereafter, each of the contact angles of water was measured. As compared with the water contact angle before ArF exposure, a film in which the surface could not be modified by 20 degrees or more (the contact angle did not decrease by 20 degrees or more) was determined as "poor", and a film in which the surface was modified by 20 degrees or more (the contact angle decreased by 20 degrees or more) was determined as "good". The measurement results are described in Table 3 below.

**[Table 3]**

| | Substrate | Application liquid | Baking temperature | Contact angle decreased by 20 degrees or more |
|---|---|---|---|---|
| Example 13 | Bare-Si | Application liquid 1 | 215°C | Good |
| Example 14 | Bare-Si | Application liquid 2 | 215°C | Good |
| Example 15 | Bare-Si | Application liquid 3 | 215°C | Good |
| Example 16 | Bare-Si | Application liquid 4 | 215°C | Good |
| Example 17 | Bare-Si | Application liquid 5 | 215°C | Good |
| Example 18 | Bare-Si | Application liquid 6 | 215°C | Good |
| Example 19 | Bare-Si | Application liquid 7 | 215°C | Good |
| Example 20 | Bare-Si | Application liquid 8 | 215°C | Good |
| Example 21 | Bare-Si | Application liquid 9 | 215°C | Good |
| Example 22 | Bare-Si | Application | 215°C | Good |
| | | liquid 10 | | |
| Example 23 | Bare-Si | Application liquid 11 | 215°C | Good |
| Example 24 | Bare-Si | Application liquid 12 | 215°C | Good |
| Comparative Example 2 | Bare-Si | Comparative application liquid 1 | 215°C | Poor |

### [5] Formation of Film Hydrophilized by EUV Exposure

Each Bare-Si was spin-coated with each composition resulted from the application liquids 2, 8, and 12 and the comparative application liquid 1 and heated at any temperature for 1 minute. Thereafter, a mixed solvent of propylene glycol monomethyl ether/propylene glycol monomethyl ether acetate (7/3 (V/V)) was applied onto each of the coating films, and spin-dried to form surface-modified films (1 to 3 nm) having a film thickness of 30Å or less. Further, the entire surface of each of the wafers was exposed using NXE3400B manufactured by ASML.

Thereafter, each of the contact angles of water was measured. As compared with the water contact angle before ArF exposure, a film in which the surface could not be modified by 20 degrees or more was determined as "poor", and a film in which the surface was modified by 20 degrees or more was determined as "good". The measurement results are described in Table 4 below.

**[Table 4]**

| | Substrate | Application liquid | Baking temperature | Contact angle decreased by 20 degrees or more |
|---|---|---|---|---|
| Example 25 | Bare-Si | Application liquid 2 | 215°C | Good |
| Example 26 | Bare-Si | Application liquid 8 | 215°C | Good |
| Example 27 | Bare-Si | Application liquid 12 | 215°C | Good |
| Comparative Example 3 | Bare-Si | Comparative application liquid 1 | 215°C | Poor |

The above description showed that when the surface-modified films having a contact angle of 30 degrees or more in Examples 1 to 12 were exposed to ArF or EUV in Examples 13 to 27, the contact angle in each of the films decreased by 20 degrees or more in the exposed region. That is, in the case of not being exposed to ArF or EUV and in the case of being exposed to ArF or EUV, surface characteristics having different hydrophilicity were exhibited.

Thus, according to each of the Examples, it is possible to obtain a surface-modified film which exhibits a hydrophilic-hydrophobic contrast due to exposure to ArF, EUV, or the like and has a region having different hydrophilicity on the surface depending on the presence or absence of exposure. Therefore, a patterned substrate can be formed by further selectively hydrophilizing the substrate surface exhibiting the hydrophilic-hydrophobic contrast by atomic layer deposition, molecular layer deposition, or the like, and depositing metal atoms or organic molecules only on the resultant surface.

## Claims

1. A laminate comprising:
a substrate; and
a surface-modified film, the surface-modified film formed of a photosensitive surface modifier containing a photosensitive polymer and irradiated with light or an electron beam,
wherein the surface-modified film has an exposed region irradiated with the light or the electron beam and an unexposed region, and
one of the exposed region and the unexposed region is a selective upper layer formation region in which an upper layer is selectively formed.

2. The laminate according to claim 1, wherein the photosensitive polymer is a polysiloxane.

3. The laminate according to claim 2, wherein the polysiloxane contains a polysiloxane modified product in which at least some of silanol groups are alcohol-modified or acetal-protected.

4. The laminate according to claim 2, wherein the polysiloxane contains at least one structure selected from a hydrocarbon group having 1 to 8 carbon atoms optionally substituted with a halogen atom, an aromatic ring having 6 to 30 carbon atoms optionally substituted with a halogen atom, an alkenyl group, an alkynyl group, a norbornene ring, a phenol group, a protected phenol group, an amino group, an amide group, a cyclic amide group, an imide group, a cyclic imide group, a sulfonyl group, a sulfonamide group, a nitro group, a cyano group, a thiocyanate group, an isocyanate group, a halogen group, a carboxylic acid group, a carboxylic acid ester group, a sulfonic acid group, a sulfonic acid ester group, a phosphoric acid group, a phosphoric acid ester group, an ammonium group, a phosphonium group, a sulfonium group, an epoxy group, a glycidoxy group, a cyclohexylepoxy group, a ring-opened epoxy group, a ring-opened glycidoxy group, a ring-opened cyclohexylepoxy group, a hydroxy group, a mercapto group, an acryloyloxy group, or a methacryloyloxy group.

5. The laminate according to claim 2, wherein the polysiloxane contains a group bonded to a silicon atom and having an ionic bond.

6. The laminate according to claim 5, wherein
the group having an ionic bond has an anionic group which is a group bonded to a silicon atom and a cation,
an anion in the anionic group is a sulfonate anion, a carboxylate anion, or a phosphate anion, and
the cation is a sulfonium cation, an iodonium cation, a phosphonium cation, a dihydroimidazole cation, or an ammonium cation.

7. The laminate according to claim 5, wherein
the group having an ionic bond has a cationic group which is a group bonded to a silicon atom and an anion,
a cation in the cationic group is a sulfonium cation, an iodonium cation, a phosphonium cation, a dihydroimidazole cation, or an ammonium cation, and
the anion is a sulfonate anion, a carboxylate anion, or a phosphate anion.

8. The laminate according to claim 2, wherein the polysiloxane contains a Q unit.

9. The laminate according to claim 1, wherein the substrate is made of a material containing an inorganic material or an organic material.

10. The laminate according to claim 1, wherein the substrate has a film made of a material containing an inorganic material or an organic material.

11. The laminate according to claim 9 or 10,
wherein the inorganic material is at least one selected from the group consisting of a metal, a metal oxide, a metal nitride, a metal carbide, a metal oxynitride, a metal oxycarbide, and a metal carbonitride.

12. The laminate according to claim 9 or 10,
wherein the organic material is at least one selected from the group consisting of amorphous carbon, graphite, fullerene, carbon nanotube, diamond, diamond-like carbon, polyimide, and an organic film doped or partially substituted with boron, oxygen, nitrogen, phosphorus, silicon, sulfur, or halogen.

13. A method for producing the laminate described in any one of claims 1 to 10, comprising: a film formation step of forming a surface modification precursor film on the substrate with the photosensitive surface modifier containing the photosensitive polymer and a solvent; and
an exposure step of irradiating the surface modification precursor film with the light or the electron beam to form the surface-modified film having the exposed region and the unexposed region.

14. The method for producing the laminate according to claim 13, wherein the laminate further includes a silicon-containing resist underlayer film or a carbon-containing resist underlayer film.

15. The method for producing the laminate according to claim 13, wherein the surface-modified film has a film thickness of 5 nm or less.

16. The method for producing the laminate according to claim 15, further comprising
a thinning step of bringing the surface-modified film into contact with a thinning liquid to cause the surface-modified film to have a film thickness of 5 nm or less.

17. The method for producing the laminate according to claim 16, wherein the thinning liquid is at least one selected from the group consisting of an organic solvent, water, and an alkaline aqueous solution.

18. The method for producing the laminate according to claim 16, wherein the thinning step is a step of spin-coating the surface-modified film with a thinning liquid to thin the surface-modified film and to form a surface-modified film having a film thickness of 5 nm or less.

19. The method for producing the laminate according to claim 13, further comprising a selective film formation step of preferentially forming an upper layer in one of the exposed region and the unexposed region.

20. The method for producing the laminate according to claim 19, wherein the selective film formation step is a step of forming an upper layer by any of vacuum deposition, chemical vapor deposition (CVD), atomic layer deposition (ALD), and molecular layer deposition (MLD).

21. A photosensitive surface modifier comprising: the photosensitive polymer; and a solvent, wherein
the photosensitive surface modifier is a formation material for the surface-modified film of the laminate described in any one of claims 1 to 10.

22. The photosensitive surface modifier according to claim 21, wherein the solvent contains at least one selected from the group consisting of alcohols, alkylene glycol alkyl ethers, alkylene glycol monoalkyl ether carboxylic acid esters, and water.

23. The photosensitive surface modifier according to claim 21, further comprising an acid.

24. The photosensitive surface modifier according to claim 21, further comprising an acid generator.
